# EUROPEAN PATENT APPLICATION

(11) **EP 3 447 511 A1**
(43) Date of publication of application: **27.02.2019**
(21) Application number: 17785586.3
(22) Date of filing: 24.01.2017
(51) Int. Cl.: G01R 31/36, H01M 10/48, H02J 7/00

(54) **STATE-OF-CHARGE CALCULATION DEVICE, COMPUTER PROGRAM, AND STATE-OF-CHARGE CALCULATION METHOD**

(30) Priority: 18.04.2016 JP 2016082913; 18.04.2016 JP 2016082914; 18.04.2016 JP 2016082915
(71) Applicant: Sumitomo Electric Industries, Ltd., Osaka-shi, Osaka 541-0041 (JP)
(72) Inventor: TAKECHI, Hiroaki, Osaka-shi Osaka 554-0024 (JP)
(74) Representative: Boult Wade Tennant LLP
(86) International application number: PCT/JP2017/002228
(87) International publication number: WO 2017/183241

(57) **Abstract**

An amount of charge calculation device, includes: a voltage obtaining portion obtaining a voltage of a secondary battery; a current obtaining portion obtaining a current of the secondary battery; a first calculation portion calculating a first amount of charge of the secondary battery by integrating the obtained current; a second calculation portion calculating a second amount of charge of the secondary battery, on the basis of the obtained voltage and current, and an equivalent circuit model of the secondary battery; and a determination portion determining whether or not a predetermined condition is satisfied, in which in a case where the determination portion determines that the predetermined condition is not satisfied, the first amount of charge is set to the amount of charge of the secondary battery, and in a case where the determination portion determines that the predetermined condition is satisfied, the second amount of charge is set to the amount of charge of the secondary battery.

## Description

### [Technical Field]

The present invention relates to an amount of charge calculation device, a computer program, and an amount of charge calculation method.

This application claims priority based on Japanese Patent Application No. 2016-082913, Japanese Application No. 2016-082914, and Japanese Patent Application No. 2016-082915 filed on April 18, 2016; the entire contents of all of which are incorporated herein.

### [Background Art]

Recently, a vehicle such as a hybrid electric vehicle (HEV) and an electric vehicle (EV) has been spread. In the HEV and the EV, a secondary battery is mounted. In such a vehicle, switching between charge and discharge of the secondary battery is repeated according to driving. Then, a charge state of the secondary battery greatly varies according to charge and discharge of the vehicle while being driven, and thus, it is necessary to accurately obtain an amount of charge (SOC) of the secondary battery.

For example, an amount of charge calculation method is disclosed as a method of calculating the amount of charge of the secondary battery, in which a current integration value is calculated by detecting a charge and discharge current of the secondary battery, and a first amount of charge is calculated on the basis of the calculated current integration value. Then, a second amount of charge is calculated on the basis of the voltage of the secondary battery at no load, and when a difference between the first amount of charge and the second amount of charge is greater than or equal to a predetermined value, the first amount of charge is corrected on the basis of the second amount of charge (refer to Patent Document 1).

### [Prior Art Document]

### [Patent Document]

[Patent Document 1] Japanese Patent Laid-Open Publication No. 2000-150003

### [Summary of Invention]

An amount of charge calculation device of this disclosure is an amount of charge calculation device calculating an amount of charge of a secondary battery, the device including: a voltage obtaining portion obtaining a voltage of the secondary battery; a current obtaining portion obtaining a current of the secondary battery; a first calculation portion calculating a first amount of charge of the secondary battery by integrating the current obtained by the current obtaining portion; a second calculation portion calculating a second amount of charge of the secondary battery, on the basis of the voltage obtained by the voltage obtaining portion, the current obtained by the current obtaining portion, and an equivalent circuit model of the secondary battery; and a determination portion determining whether or not a predetermined condition is satisfied, in which in a case where the determination portion determines that the predetermined condition is not satisfied, the first amount of charge is set to the amount of charge of the secondary battery, and in a case where the determination portion determines that the predetermined condition is satisfied, the second amount of charge is set to the amount of charge of the secondary battery.

An amount of charge calculation device of this disclosure, is an amount of charge calculation device calculating an amount of charge of a secondary battery, the device including: a voltage obtaining portion obtaining a voltage of the secondary battery; a current obtaining portion obtaining a current of the secondary battery; a first calculation portion calculating a first amount of charge of the secondary battery by integrating the current obtained by the current obtaining portion; a second calculation portion calculating a second amount of charge of the secondary battery, on the basis of the voltage obtained by the voltage obtaining portion, the current obtained by the current obtaining portion, and an equivalent circuit model of the secondary battery; and a switching determination portion determining the presence or absence of switching between charge and discharge of the secondary battery, on the basis of the current obtained by the current obtaining portion, in which in a case where the switching determination portion determines that there is no switching between charge and discharge, the first amount of charge is set to the amount of charge of the secondary battery, and in a case where the switching determination portion determines that there is switching between charge and discharge, the second amount of charge is set to the amount of charge of the secondary battery.

An amount of charge calculation device of this disclosure, is an amount of charge calculation device calculating an amount of charge of a secondary battery, the device including: a voltage obtaining portion obtaining a voltage of the secondary battery; a current obtaining portion obtaining a current of the secondary battery; a first calculation portion calculating a first amount of charge of the secondary battery by integrating the current obtained by the current obtaining portion; a second calculation portion calculating a second amount of charge of the secondary battery, on the basis of the voltage obtained by the voltage obtaining portion, the current obtained by the current obtaining portion, and an equivalent circuit model of the secondary battery; a difference in amount of charge calculation portion calculating a difference in the amount of charge of the first amount of charge calculated by the first calculation portion and the second amount of charge calculated by the second calculation portion; a condition determination portion determining whether or not a predetermined condition is satisfied, on the basis of the difference in the amount of charge, calculated by the difference in amount of charge calculation portion; and a correction portion correcting the first amount of charge, on the basis of the second amount of charge, in a case where the condition determination portion determines that the predetermined condition is satisfied.

A computer program of this disclosure, is a computer program for allowing a computer to calculate an amount of charge of a secondary battery, the program allowing the computer to function as: a voltage obtaining portion obtaining a voltage of the secondary battery; a current obtaining portion obtaining a current of the secondary battery; a first calculation portion calculating a first amount of charge of the secondary battery by integrating the obtained current; a second calculation portion calculating a second amount of charge of the secondary battery, on the basis of the obtained voltage and current, and an equivalent circuit model of the secondary battery; and a determination portion determining whether or not a predetermined condition is satisfied, in which in a case where it is determined that the predetermined condition is not satisfied, the first amount of charge is processed as the amount of charge of the secondary battery, and in a case where it is determined that the predetermined condition is satisfied, the second amount of charge is processed as the amount of charge of the secondary battery.

A computer program of this disclosure, is a computer program for allowing a computer to calculate an amount of charge of a secondary battery, the program allowing the computer to function as: a voltage obtaining portion obtaining a voltage of the secondary battery; a current obtaining portion obtaining a current of the secondary battery; a first calculation portion calculating a first amount of charge of the secondary battery by integrating the obtained current; a second calculation portion calculating a second amount of charge of the secondary battery, on the basis of the obtained voltage and current, and an equivalent circuit model of the secondary battery; and a switching determination portion determining the presence or absence of switching between charge and discharge of the secondary battery, on the basis of the obtained current, in which in a case where it is determined that there is no switching between charge and discharge, the first amount of charge is processed as the amount of charge of the secondary battery, and in a case where it is determined that there is switching between charge and discharge, the second amount of charge is processed as the amount of charge of the secondary battery.

A computer program of this disclosure, is a computer program for allowing a computer to calculate an amount of charge of a secondary battery, the program allowing the computer to function as: a voltage obtaining portion obtaining a voltage of the secondary battery; a current obtaining portion obtaining a current of the secondary battery; a first calculation portion calculating a first amount of charge of the secondary battery by integrating the obtained current; a second calculation portion calculating a second amount of charge of the secondary battery, on the basis of the obtained voltage and current, and an equivalent circuit model of the secondary battery; a difference in amount of charge calculation portion calculating a difference in the amount of charge of the calculated first amount of charge and second amount of charge; a condition determination portion determining whether or not a predetermined condition is satisfied, on the basis of the calculated difference in the amount of charge; and a correction portion correcting the first amount of charge, on the basis of the second amount of charge, in a case where it is determined that the predetermined condition is satisfied.

An amount of charge calculation method of this disclosure, is an amount of charge calculation method of calculating an amount of charge of a secondary battery, the method including: allowing a voltage obtaining portion to obtain a voltage of the secondary battery; allowing a current obtaining portion to obtain a current of the secondary battery; allowing a first calculation portion to calculate a first amount of charge of the secondary battery by integrating the obtained current; allowing a second calculation portion to calculate a second amount of charge of the secondary battery, on the basis of the obtained voltage and current, and an equivalent circuit model of the secondary battery; allowing a determination portion to determine whether or not a predetermined condition is satisfied; and setting the first amount of charge to the amount of charge of the secondary battery in a case where it is determined that the predetermined condition is not satisfied, and setting the second amount of charge to the amount of charge of the secondary battery in a case where it is determined that the predetermined condition is satisfied.

An amount of charge calculation method of this disclosure, is an amount of charge calculation method of calculating an amount of charge of a secondary battery, the method including: allowing a voltage obtaining portion to obtain a voltage of the secondary battery; allowing a current obtaining portion to obtain a current of the secondary battery; allowing a first calculation portion to calculate a first amount of charge of the secondary battery by integrating the obtained current; allowing a second calculation portion to calculate a second amount of charge of the secondary battery, on the basis of the obtained voltage and current, and an equivalent circuit model of the secondary battery; allowing a switching determination portion to determine the presence or absence of switching between charge and discharge of the secondary battery, on the basis of the obtained current; setting the first amount of charge to the amount of charge of the secondary battery in a case where it is determined that there is no switching between charge and discharge; and setting the second amount of charge to the amount of charge of the secondary battery in a case where it is determined that there is switching between charge and discharge.

An amount of charge calculation method of this disclosure, is an amount of charge calculation device of calculating an amount of charge of a secondary battery, the method including: allowing a voltage obtaining portion to obtain a voltage of the secondary battery; allowing a current obtaining portion to obtain a current of the secondary battery; allowing a first calculation portion to calculate a first amount of charge of the secondary battery by integrating the obtained current; allowing a second calculation portion to calculate a second amount of charge of the secondary battery, on the basis of the obtained voltage and current, and an equivalent circuit model of the secondary battery; allowing a difference in amount of charge calculation portion to calculate a difference in the amount of charge of the calculated first amount of charge and second amount of charge; allowing a condition determination portion to determine whether or not a predetermined condition is satisfied, on the basis of the calculated difference in the amount of charge; and allowing a correction portion to correct the first amount of charge, on the basis of the second amount of charge, in a case where it is determined that the predetermined condition is satisfied.

### [Brief Description of Drawings]

FIG. 1 is a block diagram illustrating an example of configurations of main parts of a vehicle on which a battery monitoring device as an amount of charge calculation device of a first embodiment, is mounted.
FIG. 2 is a block diagram illustrating an example of a configuration of the battery monitoring device of the first embodiment.
FIG. 3 is an explanatory diagram illustrating an example of an equivalent circuit model of a secondary battery unit of the first embodiment.
FIG. 4 is a schematic view illustrating an example of a voltage transition after charge of a secondary battery unit 50 of the first embodiment is started.
FIG. 5 is a schematic view illustrating an example of a voltage transition after discharge of the secondary battery unit 50 of the first embodiment is started.
FIG. 6 is an explanatory diagram illustrating an example of a correlative relationship between an open voltage and an amount of charge of the secondary battery unit of the first embodiment.
FIG. 7 is a schematic view illustrating main parts of calculation processing of the amount of charge of the secondary battery unit according to the battery monitoring device of the first embodiment.
FIG. 8 is an explanatory diagram illustrating an example of a current waveform of the secondary battery unit of the first embodiment.
FIG. 9 is an explanatory diagram illustrating an example of each amount of charge to be calculated by the battery monitoring device of the first embodiment.
FIG. 10 is an explanatory diagram illustrating an example of the amount of charge of the secondary battery unit according to the battery monitoring device of the first embodiment.
FIG. 11 is an explanatory diagram illustrating an example of an error of the amount of charge of the secondary battery unit according to the battery monitoring device of the first embodiment.
FIG. 12 is a flowchart illustrating a first example of a processing procedure of amount of charge calculation according to the battery monitoring device of the first embodiment.
FIG. 13 is a flowchart illustrating an example of a processing procedure of battery equivalent circuit model SOC calculation according to the battery monitoring device of the first embodiment.
FIG. 14 is a flowchart illustrating an example of the processing procedure of the battery equivalent circuit model SOC calculation according to the battery monitoring device of the first embodiment.
FIG. 15 is a flowchart illustrating a second example of the processing procedure of the amount of charge calculation according to the battery monitoring device of the first embodiment.
FIG. 16 is a flowchart illustrating a third example of the processing procedure of the amount of charge calculation according to the battery monitoring device of the first embodiment.
FIG. 17 is a flowchart illustrating a fourth example of the processing procedure of the amount of charge calculation according to the battery monitoring device of the first embodiment.
FIG. 18 is a block diagram illustrating an example of a configuration of a battery monitoring device of a second embodiment.
FIG. 19 is a schematic view illustrating main parts of calculation processing of an amount of charge of a secondary battery unit according to the battery monitoring device of the second embodiment.
FIG. 20 is an explanatory diagram illustrating an example a current waveform of the secondary battery unit of the second embodiment.
FIG. 21 is an explanatory diagram illustrating an example of each amount of charge to be calculated by the battery monitoring device of the second embodiment.
FIG. 22 is an explanatory diagram illustrating an example of the amount of charge of the secondary battery unit according to the battery monitoring device of the second embodiment.
FIG. 23 is an explanatory diagram illustrating an example of an error of the amount of charge of the secondary battery unit according to the battery monitoring device of the second embodiment.
FIG. 24 is a flowchart illustrating a first example of a processing procedure of amount of charge calculation according to the battery monitoring device of the second embodiment.
FIG. 25 is a flowchart illustrating an example of a processing procedure of battery equivalent circuit model SOC calculation according to the battery monitoring device of the second embodiment.
FIG. 26 is a flowchart illustrating an example of the processing procedure of the battery equivalent circuit model SOC calculation according to the battery monitoring device of the second embodiment.
FIG. 27 is a flowchart illustrating a second example of the processing procedure of the amount of charge calculation according to the battery monitoring device of the second embodiment.
FIG. 28 is a block diagram illustrating an example of a configuration of a battery monitoring device of a third embodiment.
FIG. 29 is an explanatory diagram illustrating an example of a calculation method of a unit capacity change amount according to the battery monitoring device of the third embodiment.
FIG. 30 is a schematic view illustrating main parts of calculation processing of an amount of charge of a secondary battery unit according to the battery monitoring device of the third embodiment.
FIG. 31 is an explanatory diagram illustrating an example of a current waveform of the secondary battery unit of the third embodiment.
FIG. 32 is an explanatory diagram illustrating an example of each amount of charge to be calculated by the battery monitoring device of the third embodiment.
FIG. 33 is an explanatory diagram illustrating an example of the amount of charge of the secondary battery unit according to the battery monitoring device of the third embodiment.
FIG. 34 is an explanatory diagram illustrating an example of an error of the amount of charge of the secondary battery unit according to the battery monitoring device of the third embodiment.
FIG. 35 is a flowchart illustrating a first example of a processing procedure of amount of charge calculation according to the battery monitoring device of the third embodiment.
FIG. 36 is a flowchart illustrating the first example of the processing procedure of the amount of charge calculation according to the battery monitoring device of the third embodiment.
FIG. 37 is a flowchart illustrating an example of a processing procedure of current integration SOC calculation according to the battery monitoring device of the third embodiment.
FIG. 38 is a flowchart illustrating an example of the processing procedure of the battery equivalent circuit model SOC calculation according to the battery monitoring device of the third embodiment.
FIG. 39 is a flowchart illustrating an example of a processing procedure of unit capacity change amount calculation according to the battery monitoring device of the third embodiment.
FIG. 40 is a flowchart illustrating an example of a processing procedure of error amount calculation according to the battery monitoring device of the third embodiment.
FIG. 41 is a flowchart illustrating a second example of the amount of charge calculation according to the battery monitoring device of the third embodiment.

### [Mode for Carrying out Invention]

### [Problems to be Solved by This Disclosure]

The method of Patent Document 1, it is necessary to detect the voltage of the secondary battery at no load. For example, it is necessary to stop the vehicle, and set an ignition (IG) to be in an off state, or to mandatorily stop charge and discharge with respect to the secondary battery, as a condition in which the voltage of the secondary battery at no load can be detected. For this reason, in a state where the ignition (IG) is continuously turned on for a long period of time, the voltage of the secondary battery at no load is not capable of being detected. In addition, in a case where the charge and discharge with respect to the secondary battery is mandatorily stopped, a case where a motor is not capable of being driven due to the discharge from the secondary battery, or a case where the secondary battery is not capable of being charged by using regenerative power from the motor, occurs, and thus, an energy loss and a regenerative brake force loss are caused.

Therefore, an object of this disclosure is to provide an amount of charge calculation device in which an amount of charge of a secondary battery can be accurately calculated even in a case where a charge and discharge current flows through the secondary battery, and a computer program and an amount of charge calculation method for realizing the amount of charge calculation device.

### [Effect of This Disclosure]

According to this disclosure, it is possible to accurately calculate an amount of charge of a secondary battery even in a case where a charge and discharge current flows through the secondary battery.

### [Description of First Embodiment of Present Invention]

An amount of charge calculation device according to a first embodiment, is an amount of charge calculation device calculating an amount of charge of a secondary battery, the device including: a voltage obtaining portion obtaining a voltage of the secondary battery; a current obtaining portion obtaining a current of the secondary battery; a first calculation portion calculating a first amount of charge of the secondary battery by integrating the current obtained by the current obtaining portion; a second calculation portion calculating a second amount of charge of the secondary battery, on the basis of the voltage obtained by the voltage obtaining portion, the current obtained by the current obtaining portion, and an equivalent circuit model of the secondary battery; and a determination portion determining whether or not a predetermined condition is satisfied, in which in a case where the determination portion determines that the predetermined condition is not satisfied, the first amount of charge is set to the amount of charge of the secondary battery, and in a case where the determination portion determines that the predetermined condition is satisfied, the second amount of charge is set to the amount of charge of the secondary battery.

A computer program according to the first embodiment, is a computer program for allowing a computer to calculate an amount of charge of a secondary battery, the program allowing the computer to function as: a voltage obtaining portion obtaining a voltage of the secondary battery; a current obtaining portion obtaining a current of the secondary battery; a first calculation portion calculating a first amount of charge of the secondary battery by integrating the obtained current; a second calculation portion calculating a second amount of charge of the secondary battery, on the basis of the obtained voltage and current, and an equivalent circuit model of the secondary battery; and a determination portion determining whether or not a predetermined condition is satisfied, in which in a case where it is determined that the predetermined condition is not satisfied, the first amount of charge is processed as the amount of charge of the secondary battery, and in a case where it is determined that the predetermined condition is satisfied, the second amount of charge is processed as the amount of charge of the secondary battery.

An amount of charge calculation method according to the first embodiment, is an amount of charge calculation method of calculating an amount of charge of a secondary battery, the method including: allowing a voltage obtaining portion to obtain a voltage of the secondary battery; allowing a current obtaining portion to obtain a current of the secondary battery; allowing a first calculation portion to calculate a first amount of charge of the secondary battery by integrating the obtained current; allowing a second calculation portion to calculate a second amount of charge of the secondary battery, on the basis of the obtained voltage and current, and an equivalent circuit model of the secondary battery; allowing a determination portion to determine whether or not a predetermined condition is satisfied; and setting the first amount of charge to the amount of charge of the secondary battery in a case where it is determined that the predetermined condition is not satisfied, and setting the second amount of charge to the amount of charge of the secondary battery in a case where it is determined that the predetermined condition is satisfied.

The voltage obtaining portion obtains the voltage of the secondary battery, and the current obtaining portion obtains the current of the secondary battery (including a charge current and a discharge current). The first calculation portion calculates the first amount of charge of the secondary battery by integrating the current obtained by the current obtaining portion. The first amount of charge is an amount of charge based on a current integration. The current integration is obtained by integrating the current over time, and for example, in a case where a sampling interval for obtaining the current is set to Δt, and a current value obtained at each sampling is set to Ibi (i = 1, 2, ...), the current integration can be calculated on the basis of ∑Ibi × Δt (i = 1, 2, ...). In a case where the most recently obtained amount of charge is set to SOCin, and the first amount of charge is set to SOC1, the first amount of charge cab be calculated by an expression of SOC1 = SOCin ± {∑Ibi × Δt (i = 1, 2, ...)/Full-Charge Capacity FCC}. Furthermore, in the expression described above, + is used at the time of charge, and - is used at the time of discharge, as the symbol of ±.

The second calculation portion calculates the second amount of charge of the secondary battery on the basis of the voltage obtained by the voltage obtaining portion, the current obtained by the current obtaining portion, and the equivalent circuit model of the secondary battery. The second amount of charge is an amount of charge based on the equivalent circuit model of the secondary battery. The current integration is not adopted in the second amount of charge, and thus, the second amount of charge is not affected by an error of the current value, which gradually increases in a process of integrating the current. The equivalent circuit model is an equivalent circuit indicating the impedance of the secondary battery, and for example, can be represented by impedance configured of a combination of a voltage source having an open voltage OCV, resistance, a parallel circuit of resistance and a capacitor, and the like. Furthermore, the voltage and the current are a value at the time of charging or discharging the secondary battery, and the secondary battery is not in an unloaded state.

The determination portion determines whether or not the predetermined condition is satisfied. The predetermined condition, for example, can be a condition indicating whether or not an error of the current integration exceeds an allowable range. That is, in a case where the error of the current integration exceeds the allowable range, it is possible to determine that the predetermined condition is satisfied, and in a case where the error of the current integration does not exceed the allowable range, it is possible to determine that the predetermined condition is not satisfied.

In a case where the determination portion determines that the predetermined condition is not satisfied (in a case where the error of the current integration does not exceed the allowable range), the first amount of charge is set to the amount of charge of the secondary battery, and in a case where the determination portion determines that the predetermined condition is satisfied (in a case where the error of the current integration exceeds the allowable range), the second amount of charge is set to the amount of charge of the secondary battery, in order to correct the first amount of charge (the first amount of charge is substituted with the second amount of charge). Accordingly, in a case where the error of the current integration is in the allowable range, the first amount of charge based on the current integration, can be set to the amount of charge, and in a case where the error of the current integration exceeds the allowable range, the second amount of charge based on the equivalent circuit model which is not affected by the current integration, can be set to the amount of charge, and thus, even in a case where a charge and discharge current flows through the secondary battery, it is possible to accurately calculate the amount of charge of the secondary battery.

In the amount of charge calculation device according to the first embodiment, in a case where a time for integrating the current of the secondary battery, is shorter than a predetermined integration time, the determination portion determines that the predetermined condition is not satisfied.

In a case where the time for integrating the current of the secondary battery, is shorter than the predetermined integration time, the determination portion determines that the predetermined condition is not satisfied. In a case where the current integration is performed by detecting the current of the secondary battery by a current sensor at a predetermined sampling cycle, the predetermined integration time can be a time to be considered that an error of the obtained current value, that is, the error of the current integration is accumulated, and exceeds the allowable range. In addition, the origination of the predetermined integration time, for example, can be a time point when the energization of the secondary battery is started, or the most recent (previous) correction time point when the first amount of charge is substituted with the second amount of charge, and thus, the first amount of charge is corrected.

According to the configuration described above, in a case where the error of the current integration does not exceed the allowable range, the first amount of charge based on the current integration having an accuracy higher than the accuracy of the second amount of charge based on the equivalent circuit model, can be used, and thus, it is possible to accurately calculate the amount of charge of the secondary battery.

The amount of charge calculation device according to the first embodiment further includes a switching determination portion determining the presence or absence of switching between charge and discharge of the secondary battery, on the basis of the current obtained by the current obtaining portion, and in a case where the time for integrating the current of the secondary battery, is longer than or equal to an integration time, the determination portion determines whether or not the predetermined condition is satisfied, according to the presence or absence of the switching, determined by the switching determination portion.

The switching determination portion determines that the presence or absence of the switching between charge and discharge of the secondary battery, on the basis of the current obtained by the current obtaining portion. For example, in a case where one of charge and discharge is defined as positive, and the current is changed from positive to negative, or the current is changed from negative to positive, it is possible to determine that there is switching between charge and discharge.

In a case where the time for integrating the current of the secondary battery, is longer than or equal to the integration time, the determination portion determines whether or not the predetermined condition is satisfied, according to the presence or absence of the switching between charge and discharge, determined by the switching determination portion. For example, in a case where the switching determination portion determines that there is switching between charge and discharge, it is possible to determine that the predetermined condition is satisfied.

In a case where switching from charge to discharge, or switching from discharge to charge, is performed, it is considered that internal impedance of the secondary battery is reset once, and the accuracy of the equivalent circuit model increases. Therefore, in a case where the error of the current integration exceeds the allowable range, and there is switching between charge and discharge of the secondary battery, the second amount of charge based on the equivalent circuit model having an accuracy higher than the accuracy of the first amount of charge based on the current integration, can be used, and thus, it is possible to accurately calculate the amount of charge of the secondary battery.

In the amount of charge calculation device according to the first embodiment, in a case where the switching determination portion determines that there is switching between charge and discharge, the second calculation portion calculates the second amount of charge of the secondary battery, on the basis of the voltage obtained by the voltage obtaining portion and the current obtained by the current obtaining portion, after a predetermined time has elapsed from a switching time point of charge and discharge.

In a case where the switching determination portion determines that there is switching between charge and discharge, the second calculation portion calculates the second amount of charge of the secondary battery, on the basis of the voltage obtained by the voltage obtaining portion and the current obtained by the current obtaining portion, after the predetermined time has elapsed from the switching time point of charge and discharge. The impedance of the secondary battery can be stabilized according to an energization time after the switching between charge and discharge, and an influence of an excess voltage can be reduced, and thus, it is possible to increase the accuracy of the second amount of charge based on the equivalent circuit model.

The amount of charge calculation device according to the first embodiment further includes a difference in amount of charge calculation portion calculating a difference in the amount of charge of the first amount of charge calculated by the first calculation portion and the second amount of charge calculated by the second calculation portion, at a time point when the second amount of charge is set to the amount of charge of the secondary battery, and a unit time error amount calculation portion calculating a unit time error amount per unit time of the amount of charge, on the basis of the difference in the amount of charge, calculated by the difference in amount of charge calculation portion, and the determination portion determines whether or not the predetermined condition is satisfied, on the basis of an elapsed time from the time point when the second amount of charge calculated by the second calculation portion, is set to the amount of charge of the secondary battery, and the unit time error amount.

The difference in amount of charge calculation portion calculates the difference in the amount of charge of the first amount of charge calculated by the first calculation portion and the second amount of charge calculated by the second calculation portion, at the time point when the second amount of charge calculated by the second calculation portion is set to the amount of charge of the secondary battery (that is, the correction time point when the first amount of charge is substituted with the second amount of charge, and thus, the first amount of charge is corrected). In a case where the first amount of charge is set to SOC1, and the second amount of charge is set to SOC2, the difference ΔSOC in the amount of charge can be represented by an expression of ΔSOC = SOC2 - SOC1.

The unit time error amount calculation portion calculates the unit time error amount per unit time of the amount of charge, on the basis of the difference in the amount of charge, calculated by the difference in amount of charge calculation portion. In a case where the unit time error amount is set to ΔEt, and a time required for charging or discharging capacity ΔEAh corresponding to the difference ΔSOC in the amount of charge, is set to Te, the unit time error amount ΔEt can be calculated by an expression of ΔEt = ΔEAh/Te. Here, in a case where the full-charge capacity of the secondary battery is set to FCC, ΔEAh = FCC × ΔSOC/100 is obtained. That is, the capacity ΔEAh is obtained by converting the difference ΔSOC in the amount of charge of which the unit is %, to Ah unit.

The determination portion determines whether or not the predetermined condition is satisfied, on the basis of an elapsed time from the time point when the second amount of charge calculated by the second calculation portion, is set to the amount of charge of the secondary battery (that is, the most recent correction time point of the amount of charge), and the unit time error amount. For example, in a case where Unit Time Error Amount ΔEt × Elapsed Time t is greater than or equal to a predetermined value, an error amount (ΔEt × t) is greater than or equal to a predetermined value, and thus, it is possible to determine that the predetermined condition is satisfied. Accordingly, it is possible to determine whether or not the first amount of charge is corrected by substituting the first amount of charge with the second amount of charge, on the basis of the most recently obtained difference ΔSOC in the amount of charge.

The amount of charge calculation device according to the first embodiment further includes a difference in amount of charge calculation portion calculating a difference in the amount of charge of the first amount of charge calculated by the first calculation portion and the second amount of charge calculated by the second calculation portion, at a time point when the second amount of charge is set to the amount of charge of the secondary battery, and a unit capacity error amount calculation portion calculating a unit capacity error amount per unit capacity of the amount of charge, on the basis of the difference in the amount of charge, calculated by the difference in amount of charge calculation portion, and the determination portion determines whether or not the predetermined condition is satisfied, on the basis of charge and discharge capacity of the secondary battery after the time point when the second amount of charge calculated by the second calculation portion, is set to the amount of charge of the secondary battery, and the unit capacity error amount.

The difference in amount of charge calculation portion calculates the difference in the amount of charge of the first amount of charge calculated by the first calculation portion and the second amount of charge calculated by the second calculation portion, at the time point when the second amount of charge calculated by the second calculation portion, is set to the amount of charge of the secondary battery (that is, the correction time point when the first amount of charge is substituted with the second amount of charge, and thus, the first amount of charge is corrected). In a case where the first amount of charge is set to SOC1, and the second amount of charge is set to SOC2, the difference ΔSOC in the amount of charge can be represented by an expression of ΔSOC = SOC2 - SOC1.

The unit capacity error amount calculation portion calculates the unit capacity error amount per unit capacity of the amount of charge, on the basis of the difference in the amount of charge, calculated by the difference in amount of charge calculation portion. In a case where the unit capacity error amount is set to ΔEc, and a charge and discharge capacity absolute value reaching the capacity ΔEAh corresponding to the difference ΔSOC in the amount of charge, is set to Ca, the unit capacity error amount ΔEc can be calculated by an expression of ΔEc = ΔEAh/Ce. Here, in a case where the full-charge capacity of the secondary battery is set to FCC, ΔEAh = FCC × ΔSOC/100 is obtained. That is, the capacity ΔEAh is obtained by converting the difference ΔSOC in the amount of charge of which the unit is %, to Ah unit.

The determination portion determines whether or not the predetermined condition is satisfied, on the basis of the charge and discharge capacity of the secondary battery after the time point when the second amount of charge calculated by the second calculation portion, is set to the amount of charge of the secondary battery (that is, the most recent correction time point of the amount of charge), and the unit capacity error amount. For example, in a case where Unit Capacity Error Amount ΔEc × Charge And Discharge Capacity c (an absolute value of the charge and discharge capacity after the recent correction time point of the amount of charge), is greater than or equal to a predetermined value, the error amount (ΔEc × c) is greater than or equal to a predetermined value, and thus, it is possible to determine that the predetermined condition is satisfied. Accordingly, it is possible to determine whether or not the first amount of charge is corrected by substituting the first amount of charge with the second amount of charge, on the basis of the most recently obtained difference ΔSOC in the amount of charge.

The amount of charge calculation device according to the first embodiment further includes open voltage calculation portion calculating an open voltage of the secondary battery, on the basis of the voltage obtained by the voltage obtaining portion, the current obtained by the current obtaining portion, and an equivalent circuit model of the secondary battery, and the second calculation portion calculates the second amount of charge of the secondary battery, on the basis of the open voltage calculated by the open voltage calculation portion, and a corresponding relationship between the open voltage and the amount of charge of the secondary battery.

The open voltage calculation portion calculates an open voltage OCV of the secondary battery, on the basis of a voltage Vb obtained by the voltage obtaining portion, a current Ib obtained by the current obtaining portion, and an equivalent circuit model of the secondary battery. For example, in an excess voltage generated due to the current Ib flowing through the equivalent circuit model (impedance represented by the equivalent circuit model), the voltage Vb to be obtained (detected), and the open voltage OCV, a relationship of (OCV = Vb - Excess Voltage) is established. Here, in a case where the current Ib is positive at the time of charge, and is negative at the time of discharge, the excess voltage is also positive at the time of charge, and is negative at the time of discharge.

The second calculation portion calculates the second amount of charge of the secondary battery, on the basis of the open voltage OCV calculated by the open voltage calculation portion, and the corresponding relationship between the open voltage and the amount of charge of the secondary battery. The corresponding relationship between the open voltage OCV and the amount of charge SOC of the secondary battery, may be stored in advance in a storage portion, or the corresponding relationship may be calculated by a calculation circuit. Accordingly, it is not necessary to detect the voltage of the secondary battery at no load, and even in a case where the charge and discharge current flows through the secondary battery, it is possible to calculate the second amount of charge for correcting the first amount of charge based on the current integration.

### [Description of Second Embodiment of Present Invention]

An amount of charge calculation device according to a second embodiment, is an amount of charge calculation device calculating an amount of charge of a secondary battery, the device including: a voltage obtaining portion obtaining a voltage of the secondary battery; a current obtaining portion obtaining a current of the secondary battery; a first calculation portion calculating a first amount of charge of the secondary battery by integrating the current obtained by the current obtaining portion; a second calculation portion calculating a second amount of charge of the secondary battery, on the basis of the voltage obtained by the voltage obtaining portion, the current obtained by the current obtaining portion, and an equivalent circuit model of the secondary battery; and a switching determination portion determining the presence or absence of switching between charge and discharge of the secondary battery, on the basis of the current obtained by the current obtaining portion, in which in a case where the switching determination portion determines that there is no switching between charge and discharge, the first amount of charge is set to the amount of charge of the secondary battery, and in a case where the switching determination portion determines that there is switching between charge and discharge, the second amount of charge is set to the amount of charge of the secondary battery.

A computer program according to the second embodiment, is a computer program for allowing a computer to calculate an amount of charge of a secondary battery, the program allowing the computer to function as: a voltage obtaining portion obtaining a voltage of the secondary battery; a current obtaining portion obtaining a current of the secondary battery; a first calculation portion calculating a first amount of charge of the secondary battery by integrating the obtained current; a second calculation portion calculating a second amount of charge of the secondary battery, on the basis of the obtained voltage and current, and an equivalent circuit model of the secondary battery; and a switching determination portion determining the presence or absence of switching between charge and discharge of the secondary battery, on the basis of the obtained current, in which in a case where it is determined that there is no switching between charge and discharge, the first amount of charge is processed as the amount of charge of the secondary battery, and in a case where it is determined that there is switching between charge and discharge, the second amount of charge is processed as the amount of charge of the secondary battery.

An amount of charge calculation method according to the second embodiment, is an amount of charge calculation method of calculating an amount of charge of a secondary battery, the method including: allowing a voltage obtaining portion to obtain a voltage of the secondary battery; allowing a current obtaining portion to obtain a current of the secondary battery; allowing a first calculation portion to calculate a first amount of charge of the secondary battery by integrating the obtained current; allowing a second calculation portion to calculate a second amount of charge of the secondary battery, on the basis of the obtained voltage and current, and an equivalent circuit model of the secondary battery; allowing a switching determination portion to determine the presence or absence of switching between charge and discharge of the secondary battery, on the basis of the obtained current; setting the first amount of charge to the amount of charge of the secondary battery in a case where it is determined that there is no switching between charge and discharge; and setting the second amount of charge to the amount of charge of the secondary battery in a case where it is determined that there is switching between charge and discharge.

The voltage obtaining portion obtains the voltage of the secondary battery, and the current obtaining portion obtains the current of the secondary battery (including a charge current and a discharge current). The first calculation portion calculates the first amount of charge of the secondary battery by integrating the current obtained by the current obtaining portion. The first amount of charge is an amount of charge based on a current integration. The current integration is obtained by integrating the current over time, and for example, in a case where a sampling interval for obtaining the current is set to Δt, and a current value obtained at each sampling is set to Ibi (i = 1, 2, ...), the current integration can be calculated on the basis of ∑Ibi × Δt (i = 1, 2, ...). In a case where the most recently obtained amount of charge is set to SOCin, and the first amount of charge is set to SOC1, the first amount of charge can be calculated by an expression of SOC1 = SOCin ± {∑Ibi × Δt (i = 1, 2, ...)/Full-Charge Capacity FCC}. Furthermore, in the expression described above, + is used at the time of charge, and - is used at the time of discharge, as the symbol of ±.

The second calculation portion calculates the second amount of charge of the secondary battery, on the basis of the voltage obtained by the voltage obtaining portion, the current obtained by the current obtaining portion, and an equivalent circuit model of the secondary battery. The second amount of charge is an amount of charge based on the equivalent circuit model of the secondary battery. The current integration is not adopted in the second amount of charge, and thus, the second amount of charge is not affected by an error of the current value, which gradually increases in a process of integrating the current. The equivalent circuit model is an equivalent circuit indicating the impedance of the secondary battery, and for example, can be represented by impedance configured of a combination of a voltage source having an open voltage OCV, resistance, a parallel circuit of resistance and a capacitor, and the like. Furthermore, the voltage and the current are a value at the time of charging or discharging the secondary battery, and the secondary battery is not in an unloaded state.

The switching determination portion determines the presence or absence of the switching between of the charge and discharge of the secondary battery, on the basis of the current obtained by the current obtaining portion. For example, in a case where one of charge and discharge is defined as positive, and the current is changed from positive to negative, or the current is changed from negative to positive, it is possible to determine that there is switching between charge and discharge.

In a case where the switching determination portion determines that there is no switching between charge and discharge, the first amount of charge is set to the amount of charge of the secondary battery, and in a case where the switching determination portion determines that there is switching between charge and discharge, the second amount of charge is set to the amount of charge of the secondary battery, in order to correct the first amount of charge (the first amount of charge is substituted with the second amount of charge).

In a case where switching from charge to discharge, or switching from discharge to charge, is performed, it is considered that internal impedance of the secondary battery is reset once, and the accuracy of the equivalent circuit model increases. Accordingly, in a case where there is no switching between charge and discharge of the secondary battery, the first amount of charge based on the current integration can be set to the amount of charge, and in a case where there is switching between charge and discharge of the secondary battery, the second amount of charge based on the equivalent circuit model which is not affected by the current integration, can be set to the amount of charge, and thus, even in a case where a charge and discharge current flows through the secondary battery, it is possible to accurately calculate the amount of charge of the secondary battery.

The amount of charge calculation device according to the second embodiment further includes a difference calculation portion calculating a difference in the first amount of charge calculated by the first calculation portion and the second amount of charge calculated by the second calculation portion, in a case where the switching determination portion determines that there is switching between charge and discharge, the first amount of charge is set to the amount of charge of the secondary battery when the difference calculated by the difference calculation portion, is not greater than or equal to a predetermined value, and in a case where the switching determination portion determines that there is switching between charge and discharge, the second amount of charge is set to the amount of charge of the secondary battery when the difference calculated by the difference calculation portion, is greater than or equal to the predetermined value.

The difference calculation portion calculates the difference in the first amount of charge calculated by the first calculation portion and the second amount of charge calculated by the second calculation portion. In a case where the first amount of charge is set to SOC1, and the second amount of charge is set to SOC2, the difference ΔSOC can be represented by an expression of ΔSOC = SOC2-SOC1.

In a case where the switching determination portion determines that there is switching between charge and discharge, the first amount of charge can be the amount of charge of the secondary battery when the difference calculated by the difference calculation portion is not greater than or equal to the predetermined value. In addition, in a case where the switching determination portion determines that there is switching between charge and discharge, the second amount of charge is set to the amount of charge of the secondary battery when the difference calculated by the difference calculation portion is greater than or equal to the predetermined value.

In a case where there is switching between charge and discharge of the secondary battery, it is considered that an error of the current integration does not exceed an allowable range when the difference in the amount of charge is not greater than or equal to the predetermined value, and thus, the first amount of charge based on the current integration is set to the amount of charge. On the other hand, in a case where there is switching between charge and discharge of the secondary battery, it is considered that the error of the current integration exceeds the allowable range the difference in the amount of charge is greater than or equal to the predetermined value, and thus, the second amount of charge based on the equivalent circuit model which is not affected by the current integration, is set to the amount of charge. Accordingly, even in a case where the charge and discharge current flows through the secondary battery, it is possible to accurately calculate the amount of charge of the secondary battery.

In the amount of charge calculation device according to the second embodiment, in a case where the switching determination portion determines that there is switching between charge and discharge, the second calculation portion calculates the second amount of charge of the secondary battery, on the basis of the voltage obtained by the voltage obtaining portion and the current obtained by the current obtaining portion after a predetermined time has elapsed from a switching time point of charge and discharge.

In a case where the switching determination portion determines that there is switching between charge and discharge, the second calculation portion calculates the second amount of charge of the secondary battery, on the basis of the voltage obtained by the voltage obtaining portion and the current obtained by the current obtaining portion, after the predetermined time has elapsed from the switching time point of charge and discharge. The impedance of the secondary battery can be stabilized according to an energization time after the switching between charge and discharge, and an influence of an excess voltage can be reduced, and thus, it is possible to increase the accuracy of the second amount of charge based on the equivalent circuit model.

The amount of charge calculation device according to the second embodiment further includes an open voltage calculation portion calculating an open voltage of the secondary battery, on the basis of the voltage obtained by the voltage obtaining portion, the current obtained by the current obtaining portion, and an equivalent circuit model of the secondary battery, and the second calculation portion calculates the second amount of charge of the secondary battery, on the basis of the open voltage calculated by the open voltage calculation portion, and a corresponding relationship between the open voltage and the amount of charge of the secondary battery.

The open voltage calculation portion calculates the open voltage OCV of the secondary battery, on the basis of a voltage Vb obtained by the voltage obtaining portion, a current Ib obtained by the current obtaining portion, and an equivalent circuit model of the secondary battery. For example, in an excess voltage generated due to the current Ib flowing through the equivalent circuit model (impedance represented by the equivalent circuit model), the voltage Vb to be obtained (detected), and the open voltage OCV, a relationship of (OCV = Vb - Excess Voltage) is established. Here, in a case where the current Ib is positive at the time of charge, and is negative at the time of discharge, the excess voltage is also positive at the time of charge, and is negative at the time of discharge.

The second calculation portion calculates the second amount of charge of the secondary battery, on the basis of the open voltage OCV calculated by the open voltage calculation portion, and the corresponding relationship between the open voltage and the amount of charge of the secondary battery. The corresponding relationship between the open voltage OCV and the amount of charge SOC of the secondary battery, may be stored in advance in a storage portion, or the corresponding relationship may be calculated by a calculation circuit. Accordingly, it is not necessary to detect the voltage of the secondary battery at no load, and even in a case where the charge and discharge current flows through the secondary battery, it is possible to calculate the second amount of charge for correcting the first amount of charge based on the current integration.

### [Description of Third Embodiment of Present Invention]

An amount of charge calculation device according to a third embodiment, is an amount of charge calculation device calculating an amount of charge of a secondary battery, the device including: a voltage obtaining portion obtaining a voltage of the secondary battery; a current obtaining portion obtaining a current of the secondary battery; a first calculation portion calculating a first amount of charge of the secondary battery by integrating the current obtained by the current obtaining portion; a second calculation portion calculating a second amount of charge of the secondary battery, on the basis of the voltage obtained by the voltage obtaining portion, the current obtained by the current obtaining portion, and an equivalent circuit model of the secondary battery; a difference in amount of charge calculation portion calculating a difference in the amount of charge of the first amount of charge calculated by the first calculation portion and the second amount of charge calculated by the second calculation portion; a condition determination portion determining whether or not a predetermined condition is satisfied, on the basis of the difference in the amount of charge, calculated by the difference in amount of charge calculation portion; and a correction portion correcting the first amount of charge, on the basis of the second amount of charge, in a case where the condition determination portion determines that the predetermined condition is satisfied.

A computer program according to the third embodiment, is a computer program for allowing a computer to calculate an amount of charge of a secondary battery, the program allowing the computer to function as: a voltage obtaining portion obtaining a voltage of the secondary battery; a current obtaining portion obtaining a current of the secondary battery; a first calculation portion calculating a first amount of charge of the secondary battery by integrating the obtained current; a second calculation portion calculating a second amount of charge of the secondary battery, on the basis of the obtained voltage and current, and an equivalent circuit model of the secondary battery; a difference in amount of charge calculation portion calculating a difference in the amount of charge of the calculated first amount of charge and second amount of charge; a condition determination portion determining whether or not a predetermined condition is satisfied, on the basis of the calculated difference in the amount of charge; and a correction portion correcting the first amount of charge, on the basis of the second amount of charge, in a case where it is determined that the predetermined condition is satisfied.

An amount of charge calculation method according to the third embodiment, is an amount of charge calculation device of calculating an amount of charge of a secondary battery, the method including: allowing a voltage obtaining portion to obtain a voltage of the secondary battery; allowing a current obtaining portion to obtain a current of the secondary battery; allowing a first calculation portion to calculate a first amount of charge of the secondary battery by integrating the obtained current; allowing a second calculation portion to calculate a second amount of charge of the secondary battery, on the basis of the obtained voltage and current, and an equivalent circuit model of the secondary battery; allowing a difference in amount of charge calculation portion to calculate a difference in the amount of charge of the calculated first amount of charge and second amount of charge; allowing a condition determination portion to determine whether or not a predetermined condition is satisfied, on the basis of the calculated difference in the amount of charge; and allowing a correction portion to correct the first amount of charge, on the basis of the second amount of charge, in a case where it is determined that the predetermined condition is satisfied.

The voltage obtaining portion obtains the voltage of the secondary battery, and the current obtaining portion obtains the current of the secondary battery (including a charge current and a discharge current). The first calculation portion calculates the first amount of charge of the secondary battery by integrating the current obtained by the current obtaining portion. The first amount of charge is an amount of charge based on a current integration. The current integration is obtained by integrating the current over time, and for example, in a case where a sampling interval for obtaining the current is set to Δt, and a current value obtained at each sampling is set to Ibi (i = 1, 2, ...), the current integration can be calculated on the basis of ∑Ibi × Δt (i = 1, 2, ...). In a case where the most recently obtained amount of charge is set to SOCin, and the first amount of charge is set to SOC1, the first amount of charge cab be calculated by an expression of SOC1 = SOCin ± {∑Ibi × Δt (i = 1, 2, ...)/Full-Charge Capacity FCC}. Furthermore, in the expression described above, + is used at the time of charge, and - is used at the time of discharge, as the symbol of ±.

The second calculation portion calculates the second amount of charge of the secondary battery on the basis of the voltage obtained by the voltage obtaining portion, the current obtained by the current obtaining portion, and the equivalent circuit model of the secondary battery. The second amount of charge is an amount of charge based on the equivalent circuit model of the secondary battery. The current integration is not adopted in the second amount of charge, and thus, the second amount of charge is not affected by an error of the current value, which gradually increases in a process of integrating the current. The equivalent circuit model is an equivalent circuit indicating the impedance of the secondary battery, and for example, can be represented by impedance configured of a combination of a voltage source having an open voltage OCV, resistance, a parallel circuit of resistance and a capacitor, and the like. Furthermore, the voltage and the current are a value at the time of charging or discharging the secondary battery, and the secondary battery is not in an unloaded state.

The difference in amount of charge calculation portion calculates the difference in the amount of charge of the first amount of charge calculated by the first calculation portion and the second amount of charge calculated by the second calculation portion. In a case where the first amount of charge is set to SOC1, and the second amount of charge is set to SOC2, the difference ΔSOC in the amount of charge, for example, can be calculated by an expression of ΔSOC = SOC2 - SOC1.

The condition determination portion determines whether or not the predetermined condition is satisfied, on the basis of the difference in the amount of charge, calculated by the difference in amount of charge calculation portion. The predetermined condition, for example, can be a condition indicating whether or not an error of the current integration exceeds an allowable range. That is, in a case where the difference in the amount of charge, calculated by the difference in amount of charge calculation portion, is large, it is considered that the error of the current integration exceeds the allowable range, and thus, it is possible to determine that the predetermined condition is satisfied. On the contrary, in a case where the difference in the amount of charge, calculated by the difference in amount of charge calculation portion, is small, it is possible to determine that the predetermined condition is not satisfied.

In a case where the condition determination portion determines that the predetermined condition is satisfied, the correction portion corrects the first amount of charge, on the basis of the second amount of charge. Correcting the first amount of charge on the basis of the second amount of charge, for example, indicates that the first amount of charge is substituted with the second amount of charge, and the second amount of charge can be set to the amount of charge of the secondary battery, instead of the first amount of charge.

According to the configuration described above, in a case where the error of the current integration is in the allowable range, the first amount of charge based on the current integration, can be set to the amount of charge, and in a case where the error of the current integration exceeds the allowable range, the second amount of charge based on the equivalent circuit model which is not affected by the current integration, can be set to the amount of charge, and thus, even in a case where a charge and discharge current flows through the secondary battery, it is possible to accurately calculate the amount of charge of the secondary battery.

The amount of charge calculation device according to the third embodiment further includes a switching determination portion determining the presence or absence of the switching between charge and discharge of the secondary battery, on the basis of the current obtained by the current obtaining portion, and the condition determination portion determines whether or not the predetermined condition is satisfied, according to the presence or absence of the switching, determined by the switching determination portion.

The switching determination portion determines the presence or absence of the switching between charge and discharge of the secondary battery, on the basis of the current obtained by the current obtaining portion. For example, in a case where one of charge and discharge is defined as positive, and the current is changed from positive to negative, or the current is changed from negative to positive, it is possible to determine that there is switching between charge and discharge.

The condition determination portion determines whether or not the predetermined condition is satisfied, according to the presence or absence of the switching, determined by the switching determination portion. For example, in a case where the switching determination portion determines that there is switching between charge and discharge, it is possible to determine that the predetermined condition is satisfied.

In a case where switching from charge to discharge, or switching from discharge to charge, is performed, it is considered that internal impedance of the secondary battery is reset once, and the accuracy of the equivalent circuit model increases. Therefore, in a case where there is switching between charge and discharge of the secondary battery, the second amount of charge based on the equivalent circuit model having an accuracy higher than the accuracy of the first amount of charge based on the current integration, can be used, and thus, it is possible to accurately calculate the amount of charge of the secondary battery.

The amount of charge calculation device according to the third embodiment further includes a change amount calculation portion calculating a change amount of the difference in the amount of charge, on the basis of the difference in the amount of charge, calculated by the difference in amount of charge calculation portion at each of a first correction time point when the correction portion performs correction and a second correction time point before the first correction time point, and an error amount calculation portion calculating an error amount, on the basis of the change amount calculated by the change amount calculation portion, and a charge continuation time or a discharge continuation time after the first correction time point and the condition determination portion determines whether or not the predetermined condition is satisfied, on the basis of whether or not the error amount calculated by the error amount calculation portion, is greater than or equal to a predetermined threshold value.

The change amount calculation portion calculates the change amount of the difference in the amount of charge, on the basis of the difference in the amount of charge, calculated by the difference in amount of charge calculation portion at each of the first correction time point when the correction portion performs correction and the second correction time point before the first correction time point. In a case where the difference in the amount of charge at the first correction time point t, is set to ΔSOC(t), the difference in the amount of charge at the second correction time point (t-1), is set to ΔSOC(t-1), the change amount can be calculated by an expression of ΔSOC(t) - ΔSOC(t-1). Here, the difference ΔSOC in the amount of charge can be calculated by ΔSOC = SOC2 - SOC1.

The error amount calculation portion calculates the error amount, on the basis of the change amount calculated by the change amount calculation portion, and the charge continuation time or the discharge continuation time after the first correction time point. For example, in a case where a time difference between the first correction time point t and the second correction time point (t-1), is set to Δt, the change amount per unit time can be represented by an expression of {ΔSOC(t) - ΔSOC(t-1)}/Δt. In a case where the charge continuation time or the discharge continuation time after the first correction time point (t) is represented by Tp, the error amount, for example, can be represented by an expression of Tp × {ΔSOC(t) - ΔSOC(t-1)}/Δt. That is, the error amount represents an index indicating how much the change amount increases as the charge continuation time or the discharge continuation time has elapsed.

The condition determination portion determines whether or not the predetermined condition is satisfied, on the basis of whether or not the error amount calculated by the error amount calculation portion, is greater than or equal to the predetermined threshold value. For example, in a case where the error amount is greater than or equal to the predetermined threshold value, it is possible to determine that the predetermined condition is satisfied.

According to the configuration described above, it is possible to correct the first amount of charge by substituting the first amount of charge with the second amount of charge, on the basis of the error amount, regardless of the presence or absence of the switching between charge and discharge of the secondary battery, and thus, it is possible to accurately calculate the amount of charge of the secondary battery.

The amount of charge calculation device according to the third embodiment further includes a capacity calculation portion calculating charged or discharged capacity between the first correction time point and the second correction time point, and a unit capacity change amount calculation portion calculating a unit capacity change amount per unit capacity, on the basis of the change amount calculated by the change amount calculation portion and the capacity calculated by the capacity calculation portion, and the error amount calculation portion calculates the error amount, on the basis of the unit capacity change amount calculated by the unit capacity change amount calculation portion, and charge capacity or discharge capacity of the secondary battery, after the first correction time point.

The capacity calculation portion calculates the charged or discharged capacity between the first correction time point and the second correction time point. The capacity, for example, represents an integration of a charge current between the first correction time point and the second correction time point, and a charge time, or an integration of a discharge current between the first correction time point and the second correction time point, and a discharge time, in Ah unit.

The unit capacity change amount calculation portion calculates the unit capacity change amount per unit capacity, on the basis of the change amount calculated by the change amount calculation portion and the capacity calculated by the capacity calculation portion. In a case where the change amount between the first correction time point (t) and the second correction time point (t-1), is set to ΔSOC(t) - ΔSOC(t-1), and the capacity between the first correction time point and the second correction time point, is set to C, the unit capacity change amount can be represented by an expression of {ΔSOC(t) - ΔSOC(t-1)}/C.

The error amount calculation portion calculates the error amount, on the basis of the unit capacity change amount calculated by the unit capacity change amount calculation portion, and the charge capacity or the discharge capacity of the secondary battery after the first correction time point. In a case where the charge capacity or the discharge capacity of the secondary battery after the first correction time point, is set to Cp, the error amount, for example, can be represented by an expression of Cp × {ΔSOC(t)-ΔSOC(t-1)}/C}. That is, the error amount represents an index indicating how much the change amount increases as the charge capacity or the discharge capacity of the secondary battery increases.

According to the configuration described above, it is possible to correct the first amount of charge by substituting the first amount of charge with the second amount of charge, on the basis of the error amount, regardless of the presence or absence of the switching between charge and discharge of the secondary battery, and thus, it is possible to accurately calculate the amount of charge of the secondary battery.

In the amount of charge calculation device according to the third embodiment, the condition determination portion determines whether or not the predetermined condition is satisfied, on the basis of whether or not the difference in the amount of charge, calculated by the difference in amount of charge calculation portion, is greater than or equal to a predetermined value.

The condition determination portion determines whether or not the predetermined condition is satisfied, on the basis of whether or not the difference in the amount of charge, calculated by the difference in amount of charge calculation portion, is greater than or equal to a predetermined value. In a case where the error of the current integration exceeds the allowable range, it is considered that the difference ΔSOC in the amount of charge increases. Therefore, in a case where the difference ΔSOC in the amount of charge is greater than or equal to the predetermined value, it is possible to determine that the predetermined condition is satisfied.

According to the configuration described above, it is possible to correct the first amount of charge by substituting the first amount of charge with the second amount of charge, on the basis of the difference ΔSOC in the amount of charge, regardless of the presence or absence of the switching between charge and discharge of the secondary battery, and thus, it is possible to accurately calculate the amount of charge of the secondary battery.

In the amount of charge calculation device according to the third embodiment, in a case where the charge continuation time or the discharge continuation time after the time point when the correction portion performs correction, is longer than or equal to a predetermined time, the condition determination portion determines whether or not the predetermined condition is satisfied.

In a case where the charge continuation time or the discharge continuation time after the time point when the correction portion performs correction, is longer than or equal to the predetermined time, the condition determination portion determines whether or not the predetermined condition is satisfied. In a case where the charge continuation time or the discharge continuation time becomes longer, it is considered that the error of the current integration increases. Therefore, in a case where the charge continuation time or the discharge continuation time is longer than or equal to the predetermined time, it is determined whether or not the predetermined condition is satisfied, in order to determine whether or not the error of the current integration exceeds the allowable range. Accordingly, it is possible to prevent the error of the current integration from exceeding the allowable range.

The amount of charge calculation device according to the third embodiment further includes an open voltage calculation portion calculating an open voltage of the secondary battery, on the basis of the voltage obtained by the voltage obtaining portion, the current obtained by the current obtaining portion, and an equivalent circuit model of the secondary battery, and the second calculation portion calculates the second amount of charge of the secondary battery, on the basis of the open voltage calculated by the open voltage calculation portion, and a corresponding relationship between the open voltage and the amount of charge of the secondary battery.

The open voltage calculation portion calculates an open voltage OCV of the secondary battery, on the basis of a voltage Vb obtained by the voltage obtaining portion, a current Ib obtained by the current obtaining portion, and an equivalent circuit model of the secondary battery. For example, in an excess voltage generated due to the current Ib flowing through the equivalent circuit model (impedance represented by the equivalent circuit model), the voltage Vb to be obtained (detected), and the open voltage OCV, a relationship of (OCV = Vb - Excess Voltage) is established. Here, in a case where the current Ib is positive at the time of charge, and is negative at the time of discharge, the excess voltage is also positive at the time of charge, and is negative at the time of discharge.

The second calculation portion calculates the second amount of charge of the secondary battery, on the basis of the open voltage OCV calculated by the open voltage calculation portion, and the corresponding relationship between the open voltage and the amount of charge of the secondary battery. The corresponding relationship between the open voltage OCV and the amount of charge SOC of the secondary battery, may be stored in advance in a storage portion, or the corresponding relationship may be calculated by a calculation circuit. Accordingly, it is not necessary to detect the voltage of the secondary battery at no load, and even in a case where the charge and discharge current flows through the secondary battery, it is possible to calculate the second amount of charge for correcting the first amount of charge based on the current integration.

### [Details of Embodiments of Present Invention]

### (First Embodiment)

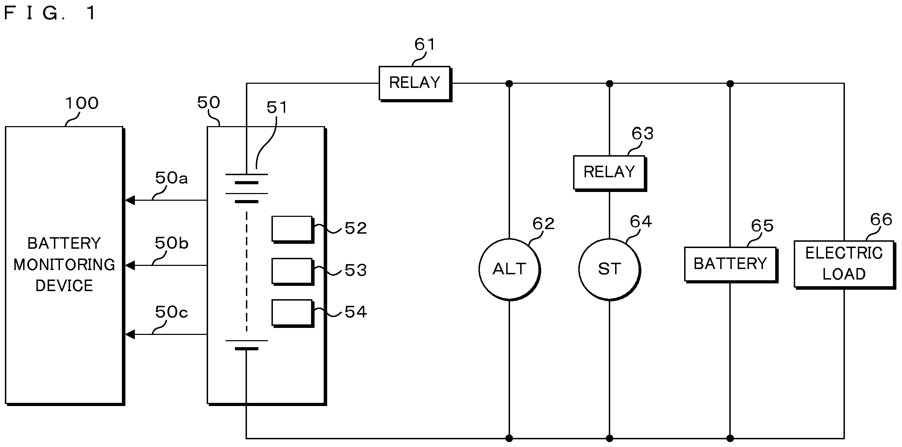

Hereinafter, embodiments of the amount of charge calculation device according to the present invention will be described on the basis of the drawings. FIG. 1 is a block diagram illustrating an example of configurations of main parts of a vehicle on which a battery monitoring device 100 as the amount of charge calculation device of the first embodiment, is mounted. As illustrated in FIG. 1, the vehicle includes a secondary battery unit 50, relays 61 and 63, a power generator (ALT) 62, a starter motor (ST) 64, a battery 65, an electric load 66, and the like, in addition to the battery monitoring device 100.

The secondary battery unit 50, for example, is a lithium ion battery, and a plurality of cells 51 are connected in series or in parallel. The secondary battery unit 50 includes a voltage sensor 52, a current sensor 53, and a temperature sensor 54. The voltage sensor 52 detects the voltage of each of the cells 51, and the voltage of the secondary battery unit 50 on both ends, and outputs the detected voltage to the battery monitoring device 100 through a voltage detection line 50a. The current sensor 53, for example, is configured of shunt resistance, a hall sensor, or the like, and detects a charge current and a discharge current of the secondary battery unit 50. The current sensor 53 outputs the detected current to the battery monitoring device 100 through a current detection line 50b. The temperature sensor 54, for example, is configured of a thermistor, and detects the temperature of the cell 51. The temperature sensor 54 outputs the detected temperature to the battery monitoring device 100 through a temperature detection line 50c.

The battery 65, for example, is a lead battery, and supplies power to the electric load 66 of the vehicle, and in a case where the relay 63 is turned on, the battery 65 supplies power to drive the starter motor 64. The power generator 62 generates power according to a rotation of an engine of the vehicle, and outputs a direct current by a rectification circuit provided inside, and thus, charges the battery 65. In addition, in a case where the relay 61 is turned on, the power generator 62 charges the battery 65 and the secondary battery unit 50. Furthermore, a relay control portion (not illustrated) turns on and off the relays 61 and 63.

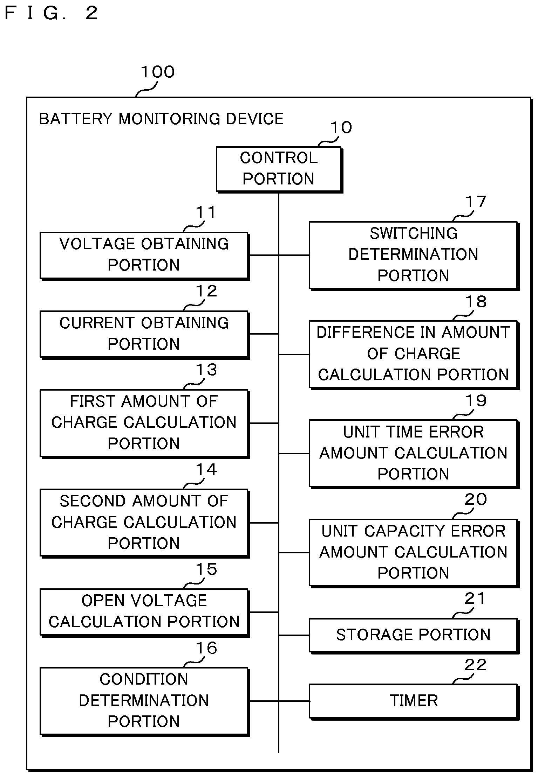

FIG. 2 is a block diagram illustrating an example the configuration of the battery monitoring device 100 of the first embodiment. The battery monitoring device 100 includes a control portion 10 controlling the entire device, a voltage obtaining portion 11, a current obtaining portion 12, a first amount of charge calculation portion 13, a second amount of charge calculation portion 14, an open voltage calculation portion 15, a condition determination portion 16, a switching determination portion 17, a difference in amount of charge calculation portion 18, unit time error amount calculation portion 19, a unit capacity error amount calculation portion 20, a storage portion 21, a timer 22 for clocking, and the like.

The voltage obtaining portion 11 obtains the voltage of the secondary battery unit 50 (for example, the voltage of the secondary battery unit 50 on both ends). In addition, the current obtaining portion 12 obtains the current of the secondary battery unit 50 (a charge current and a discharge current). Furthermore, an obtaining frequency of the voltage and the current, and a sampling cycle for obtaining the voltage and the current, can be controlled by the control portion 10. The sampling cycle, for example, can be set to 10 ms, but is not limited thereto.

The first amount of charge calculation portion 13 has a function as the first calculation portion, and calculates a first amount of charge of the secondary battery unit 50 by integrating the current obtained by the current obtaining portion 12. The first amount of charge is an amount of charge based on a current integration, and is also referred to as a current integration SOC. Furthermore, in this embodiment, the amount of charge is also referred to as a state of charge (SOC) or a charging rate, and indicates a ratio of charged capacity to full-charge capacity. The current integration is obtained by integrating the current over time, and for example, in a case where a sampling interval for obtaining the current is set to Δt, and a current value obtained at each sampling is set to Ibi (i = 1, 2, ...), the current integration can be calculated on the basis of ∑Ibi × Δt (i = 1, 2, ...). In a case where the most recently obtained amount of charge is set to SOCin, and the first amount of charge is set to SOC1, the first amount of charge can be calculated by an expression of SOC1 = SOCin ± {∑Ibi × Δt (i = 1, 2, ...)/Full-Charge Capacity FCC}. Furthermore, in the expression described above, + is used at the time of charge, and - is used at the time of discharge, as the symbol of ±.

The second amount of charge calculation portion 14 has a function as the second calculation portion, and calculates a second amount of charge of the secondary battery unit 50, on the basis of the voltage obtained by the voltage obtaining portion 11, the current obtained by the current obtaining portion 12, and an equivalent circuit model of the secondary battery unit 50. The second amount of charge is an amount of charge based on the equivalent circuit model of the secondary battery unit 50, and is also referred to as a battery equivalent circuit model SOC. The current integration is not adopted in the second amount of charge, and thus, the second amount of charge is not affected by an error of the current value, which is accumulated by gradually increasing in a process of integrating the current (for example, an error of the current sensor 53). Furthermore, the voltage and the current are a value at the time of charging or discharging the secondary battery unit 50, and the secondary battery unit 50 is not in an unloaded state.

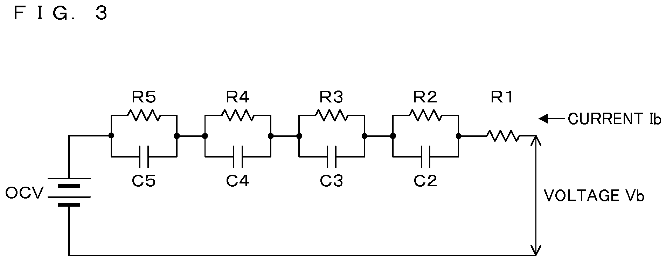

FIG. 3 is an explanatory diagram illustrating an example of the equivalent circuit model of the secondary battery unit 50 of the first embodiment. The equivalent circuit model (also referred to as a battery equivalent circuit model) is an equivalent circuit indicating the impedance of the secondary battery unit 50, and for example, as illustrated in FIG. 3, can be represented by impedance configured of a combination of a voltage source having an open voltage OCV, resistance R1, a parallel circuit of resistance and a capacitor (in FIG. 3, a configuration is illustrated in which four parallel circuits of each of resistances R2 to R5 and each of capacitors C2 to C5, are connected in series), and the like. The secondary battery unit 50 is determined by the voltage source having the open voltage OCV, series resistance of internal impedance, and the like. The open voltage OCV is determined by a static balance in a positive electrode, a negative electrode, and an electrolyte, and the internal impedance is determined by a dynamic mechanism.

More specifically, the resistance R1, for example, indicates electrolyte solution bulk resistance, and the resistances R2 to R5, for example, indicate interface charge transfer resistance and diffusion impedance, and the capacitors C2 to C5, for example, indicate electric double layer capacitance. The electrolyte solution bulk resistance includes conductive resistance of lithium (Li) ions in an electrolyte solution, electronic resistance of the positive electrode and the negative electrode, and the like. The interface charge transfer resistance includes charge transfer resistance, film resistance, and the like, on a surface of an active material. The diffusion impedance is impedance caused by a process of diffusing lithium (Li) ions into active material particles. Furthermore, the equivalent circuit model of the secondary battery unit 50 is an example, and is not limited to the example of FIG. 3.

The condition determination portion 16 has a function as the determination portion, and determines whether or not a predetermined condition is satisfied. The predetermined condition, for example, can be a condition indicating whether or not an error of the current integration exceeds a predetermined allowable range. That is, in a case where the error of the current integration exceeds the allowable range, it is possible to determine that the predetermined condition is satisfied, and in a case where the error of the current integration does not exceed the allowable range, it is possible to determine that the predetermined condition is not satisfied.

In a case where the condition determination portion 16 determines that the predetermined condition is not satisfied (in a case where the error of the current integration does not exceed the allowable range), the control portion 10 sets the first amount of charge to the amount of charge of the secondary battery unit 50. In addition, in a case where the condition determination portion 16 determines that the predetermined condition is satisfied (in a case where the error of the current integration exceeds the allowable range), the control portion 10 sets the second amount of charge to the amount of charge of the secondary battery unit 50, in order to correct the first amount of charge (the first amount of charge is substituted with the second amount of charge). Furthermore, correcting the first amount of charge by the second amount of charge, is also referred to as current integration SOC correction.

According to the configuration described above, in a case where the error of the current integration is in the allowable range, the first amount of charge based on the current integration, can be set to the amount of charge, and in a case where the error of the current integration exceeds the allowable range, the second amount of charge based on the equivalent circuit model which is not affected by the current integration, can be set to the amount of charge. Accordingly, even in a case where a charge and discharge current flows through the secondary battery unit 50, it is possible to accurately calculate the amount of charge of the secondary battery unit 50.

Next, the predetermined condition described above will be described. The predetermined condition, for example, can be set by an integration time of the current integration, the presence or absence of switching between charge and discharge of the secondary battery unit 50, or the like. First, the integration time of the current integration will be described.

In a case where a time for integrating the current of the secondary battery unit 50, is shorter than a predetermined integration time, the condition determination portion 16 determines that the predetermined condition is not satisfied. In a case where the current integration is performed by detecting the current of the secondary battery unit 50 with the current sensor 53 at a predetermined sampling cycle, the predetermined integration time can be a time to be considered that an error of the obtained current value (a detection error of the current sensor 53), that is, the error of the current integration is accumulated, and exceeds the allowable range. The integration time, for example, can be 10 minutes, 20 minutes, and the like, but is not limited thereto. In addition, the origination of the predetermined integration time, for example, can be a time point when the energization (the charge or the discharge) of the secondary battery unit 50 is started, or the most recent (previous) correction time point when the first amount of charge is corrected, and thus, is substituted with the second amount of charge.

According to the configuration described above, in a case where the error of the current integration does not exceed the allowable range, the first amount of charge based on the current integration having an accuracy higher than the accuracy of the second amount of charge based on the equivalent circuit model, can be used, and thus, it is possible to accurately calculate the amount of charge of the secondary battery unit 50.

Next, a case will be described in which the predetermined condition is set on the basis of the presence or absence of the switching between charge and discharge of the secondary battery unit 50.

The switching determination portion 17 determines the presence or absence of the switching between charge and discharge of the secondary battery unit 50, on the basis of the current obtained by the current obtaining portion 12. For example, in a case where one of charge and discharge is defined as positive, and the current is changed from positive to negative, or the current is changed from negative to positive, it is possible to determine that there is switching between charge and discharge.

In a case where the time for integrating the current of the secondary battery unit 50, is longer than or equal to the integration time, the condition determination portion 16 determines whether or not the predetermined condition is satisfied, according to the presence or absence of the switching between charge and discharge, determined by the switching determination portion 17. For example, in a case where the switching determination portion 17 determines that there is switching between charge and discharge, it is possible to determine that the predetermined condition is satisfied. In addition, in a case where the switching determination portion 17 determines that there is no switching between charge and discharge, it is possible to determine that the predetermined condition is not satisfied.

In a case where switching from charge to discharge, or switching from discharge to charge, is performed, it is considered that internal impedance of the secondary battery unit 50 is reset once, and the accuracy of the equivalent circuit model increases. Therefore, in a case where the error of the current integration exceeds the allowable range, and there is switching between charge and discharge of the secondary battery unit 50, the second amount of charge based on the equivalent circuit model having an accuracy higher than accuracy of the first amount of charge based on the current integration, can be used, and thus, it is possible to accurately calculate the amount of charge of the secondary battery unit 50.

In a case where the switching determination portion 17 determines that there is switching between charge and discharge, the second amount of charge calculation portion 14 calculates the second amount of charge of the secondary battery unit 50, on the basis of the voltage obtained by the voltage obtaining portion 11 and the current obtained by the current obtaining portion 12, after a predetermined time has elapsed from a switching time point of charge and discharge. In the predetermined time, different values or the same value may be used between a case where switching is performed from charge to discharge and a case where switching is performed from discharge to charge. The predetermined time, for example, can be set to approximately 0.1 seconds to 2 seconds, but is not limited thereto.

The impedance of the secondary battery unit 50 can be stabilized according to an energization time (a charge time or a discharge time) after the switching between charge and discharge, and an influence of an excess voltage can be reduced, and thus, it is possible to increase the accuracy of the second amount of charge based on the equivalent circuit model. Furthermore, the excess voltage indicates a difference between the voltage (a terminal voltage) and the open voltage OCV (also referred to as an open circuit voltage) of the secondary battery unit 50.

Next, a calculation method of the second amount of charge will be described in more detail.

The open voltage calculation portion 15 calculates the open voltage OCV of the secondary battery unit 50, on the basis of a voltage Vb obtained by the voltage obtaining portion 11, a current Ib obtained by the current obtaining portion 12, and the equivalent circuit model of the secondary battery unit 50.

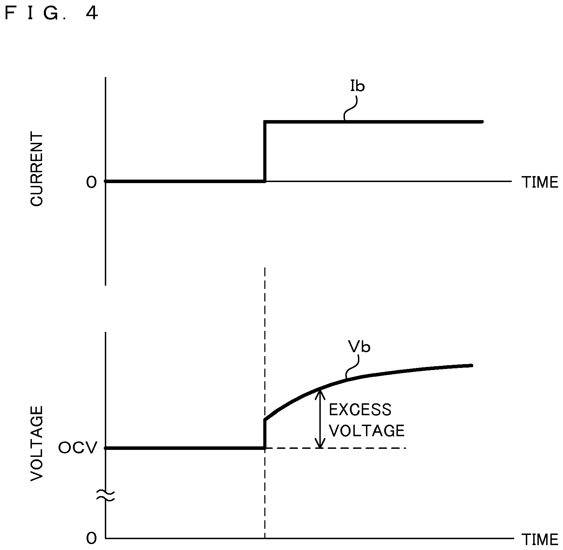

FIG. 4 is a schematic view illustrating an example of a voltage transition after the charge of the secondary battery unit 50 of the first embodiment is started. The upper diagram of FIG. 4 schematically illustrates the current Ib of the secondary battery unit 50, after charge is started from a state where neither charge nor discharge is performed. The lower diagram of FIG. 4 schematically illustrates a relationship in the open voltage OCV of the secondary battery unit 50, the voltage Vb which is the terminal voltage, and the excess voltage, after the charge is started. The excess voltage indicates a voltage of a difference between the voltage Vb and the open voltage OCV of the secondary battery unit 50. The open voltage OCV indicates a static state of the terminal voltage of the secondary battery unit 50, and is an equilibrium potential when an external power source is connected between the electrodes, the current is set to 0 A, and relaxation is performed for a long period of time within a time range where self-discharge is not performed. As illustrated in FIG. 4, in a case where a charge current Ib flows, the voltage Vb of the secondary battery unit 50 moderately increases due to a delay in various electrochemical reactions, as the voltage stepwisely increases. As illustrated in FIG. 4, in the voltage Vb to be obtained (detected), the excess voltage, and the open voltage OCV, a relationship of (OCV = Vb-Excess Voltage) is established. The current Ib is positive at the time of charge, and the excess voltage is also positive.

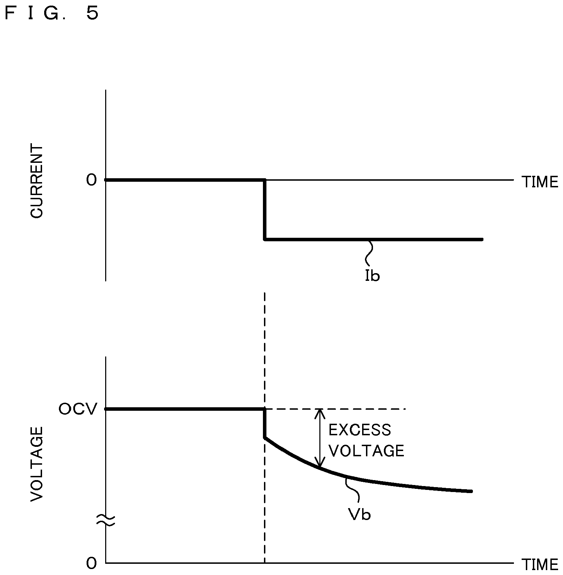

FIG. 5 is a schematic view illustrating an example of a voltage transition after the discharge of the secondary battery unit 50 of the first embodiment is started. The upper diagram of FIG. 5 schematically illustrates the current Ib of the secondary battery unit 50, after discharge is started from a state where neither charge nor discharge is performed. The lower diagram of FIG. 5 schematically illustrates a relationship in the open voltage OCV of the secondary battery unit 50, the voltage Vb which is the terminal voltage, and the excess voltage, after the charge is started. As illustrated in FIG. 5, in a case where a discharge current Ib flows, the voltage Vb of the secondary battery unit 50 moderately decreases due to a delay in various electrochemical reactions, as the voltage stepwisely decreases. In the voltage Vb to be obtained (detected), the excess voltage, and the open voltage OCV, a relationship of OCV = Vb - Excess Voltage is established. The current Ib is negative at the time of discharge, and the excess voltage is also negative, and thus, the relationship of (OCV = Vb-Excess Voltage) can be represented by (OCV = Vb + Excess Voltage), as illustrated in FIG. 5.

As described above, in the excess voltage generated by the current Ib flowing through the equivalent circuit model, the voltage Vb to be obtained (detected), and the open voltage OCV, the relationship of (OCV = Vb - Excess Voltage) is established. Here, in a case where the current Ib is positive at the time of charge, and is negative at the time of discharge, the excess voltage is also positive at the time of charge, and is negative at the time of discharge.

The second amount of charge calculation portion 14 calculates the second amount of charge of the secondary battery unit 50, on the basis of the open voltage OCV calculated by the open voltage calculation portion 15, and a corresponding relationship between the open voltage OCV and the amount of charge SOC of the secondary battery unit 50.

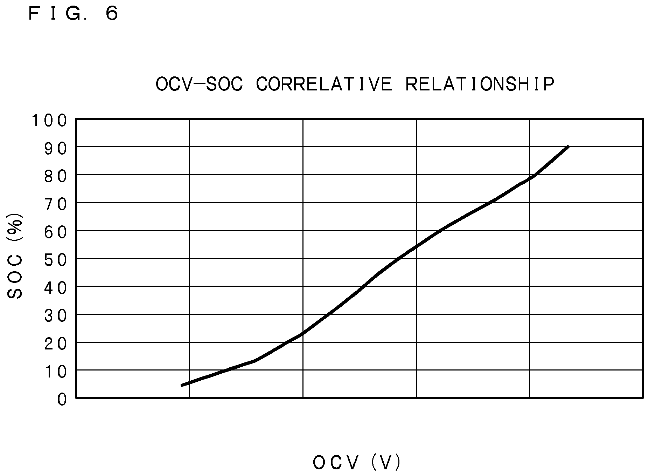

FIG. 6 is an explanatory diagram illustrating an example of the correlative relationship between the open voltage and the amount of charge of the secondary battery unit 50 of the first embodiment. In FIG. 6, a horizontal axis indicates the open voltage OCV, and a vertical axis indicates the amount of charge SOC. As illustrated in FIG. 6, the amount of charge increases as the open voltage of the secondary battery unit 50 increases. Furthermore, the correlative relationship between the open voltage and the amount of charge, exemplified in FIG. 6, may be stored in the storage portion 21, or may be calculated by the calculation circuit.

According to the configuration described above, it is not necessary to detect the voltage of the secondary battery unit 50 at no load, and even in a case where the charge and discharge current flows through the secondary battery unit 50, it is possible to calculate the second amount of charge for correcting the first amount of charge based on the current integration.

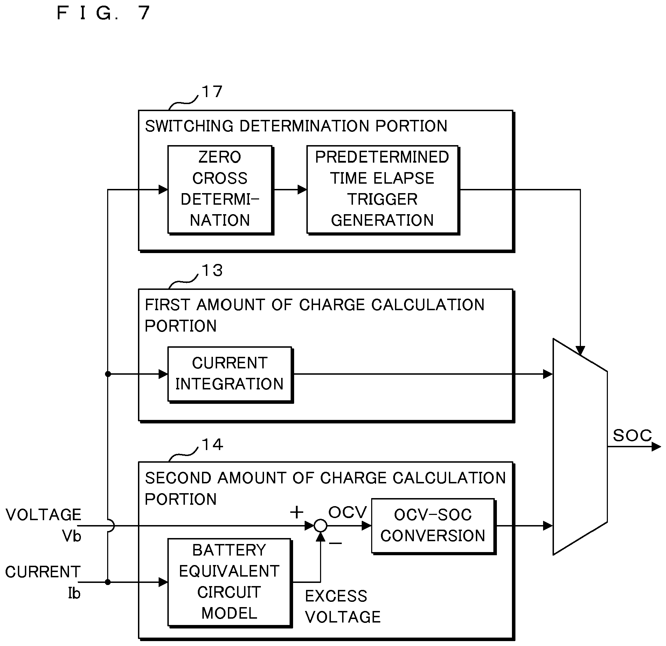

FIG. 7 is a schematic view illustrating main parts of calculation processing of the amount of charge of the secondary battery unit 50 according to the battery monitoring device 100 of the first embodiment. In a case where the voltage Vb and the current Ib of the secondary battery unit 50, are obtained at a predetermined sampling cycle (for example, 10 ms), the first amount of charge calculation portion 13 performs current integration processing, and calculates the first amount of charge at the sampling cycle. The control portion 10 outputs the calculated first charge capacity, as the amount of charge SOC of the secondary battery unit 50.

The second amount of charge calculation portion 14 calculates the excess voltage of the secondary battery unit 50, on the basis of the current Ib and the battery equivalent circuit model of the secondary battery unit 50, subtracts the calculated excess voltage from the voltage Vb of the secondary battery unit 50, and calculates the open voltage OCV. The second amount of charge calculation portion 14 converts the calculated open voltage OCV, on the basis of OCV-SOC characteristics as exemplified in FIG. 6, and thus, calculates the second amount of charge. A calculation frequency of the second amount of charge may be every sampling cycle described above (for example, 10 ms), or may be every time when a trigger described below is generated.

The switching determination portion 17 performs zero cross determination processing (determination processing of the presence or absence of current zero cross, that is, determination processing of the presence or absence of the switching between charge and discharge), on the basis of the current Ib of the secondary battery unit 50, and performs predetermined time elapse trigger generation processing of generating the trigger (also referred to as a predetermined time elapse trigger) at a time point when a predetermined time (for example, approximately 0.1 seconds to 2 seconds) has elapsed from a time point when there is current zero cross (the switching time point of charge and discharge).

The control portion 10 corrects the first amount of charge by substituting the first amount of charge with the second amount of charge, at a time point when the predetermined time elapse trigger is generated. That is, the control portion 10 outputs the second amount of charge calculated by the second amount of charge calculation portion 14 at the time point when the predetermined time elapse trigger is generated, as the amount of charge SOC of the secondary battery unit 50.

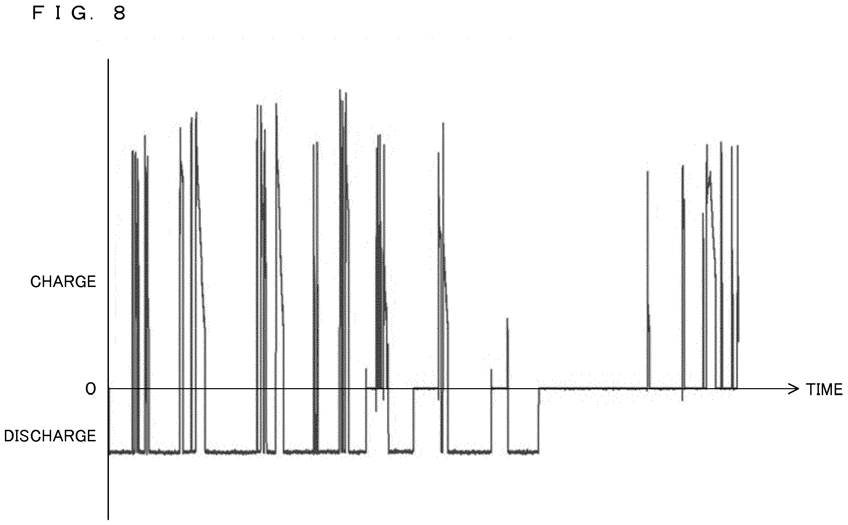

FIG. 8 is an explanatory diagram illustrating an example of a current waveform of the secondary battery unit 50 of the first embodiment. In FIG. 8, a horizontal axis indicates time, and a vertical axis indicates a current. In a case where the current is positive, a charge state is set, and in a case where the current is negative, a discharge state is set. In the example of FIG. 8, a current transition for several hours is illustrated, and it is known that the current zero cross occurs, at a timing when switching from charge to discharge, and switching from discharge to charge are performed. Furthermore, the current waveform is an example, and is not limited thereto.

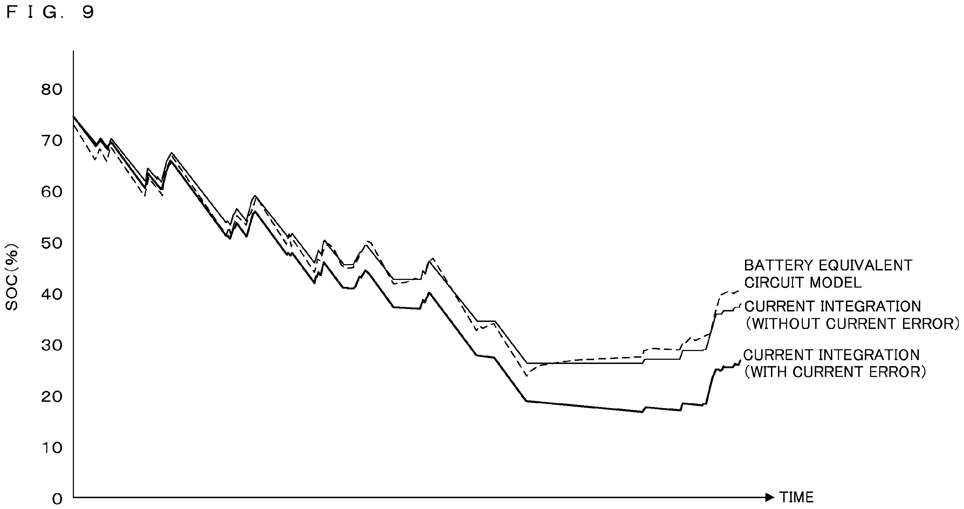

FIG. 9 is an explanatory diagram illustrating an example of each of the amounts of charge to be calculated by the battery monitoring device 100 of the first embodiment. In FIG. 9, a horizontal axis indicates time, and a vertical axis indicates the amount of charge SOC. In FIG. 9, a graph represented by "Current Integration (with Current Error)", illustrates a transition from a time 0 of the first amount of charge calculated on the basis of the current exemplified in FIG. 8. In addition, a graph represented by "Battery Equivalent Circuit Model", illustrates a transition from a time 0 of the second amount of charge calculated on the basis of the current exemplified in FIG. 8. In addition, a graph represented by "Current Integration (without Current Error)", illustrates a transition from a time 0 in a case where the current exemplified in FIG. 8 is integrated in a state without an error, and indicates a true value of the current integration.

As illustrated in FIG. 9, it is known that in the first amount of charge based on the current integration, a deviation from the true value of the current integration increases as time has elapsed, and the error gradually increases. In addition, it is known that a difference between the first amount of charge based on the current integration and the true value of the current integration, is small, while the time elapse from the time 0 is short, and the first amount of charge accurately indicates the amount of charge of the secondary battery unit 50. In addition, it is also known that the second amount of charge tends to be close to the true value of the current integration, at the timing when the switching between charge and discharge occurs.

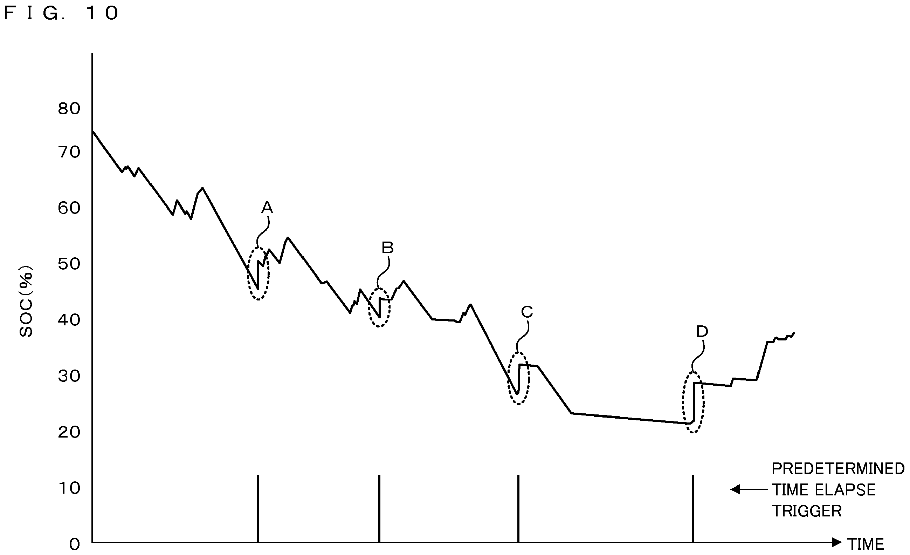

FIG. 10 is an explanatory diagram illustrating an example of the amount of charge of the secondary battery unit 50 according to the battery monitoring device 100 of the first embodiment. In FIG. 10, a horizontal axis indicates time, and a vertical axis indicates the amount of charge SOC. In FIG. 10, the predetermined time elapse trigger is generated four times. It is known that the amount of charge of the secondary battery unit 50 is corrected as illustrated by symbols A, B, C, and D in the drawing, at a timing when the predetermined time elapse trigger is generated.

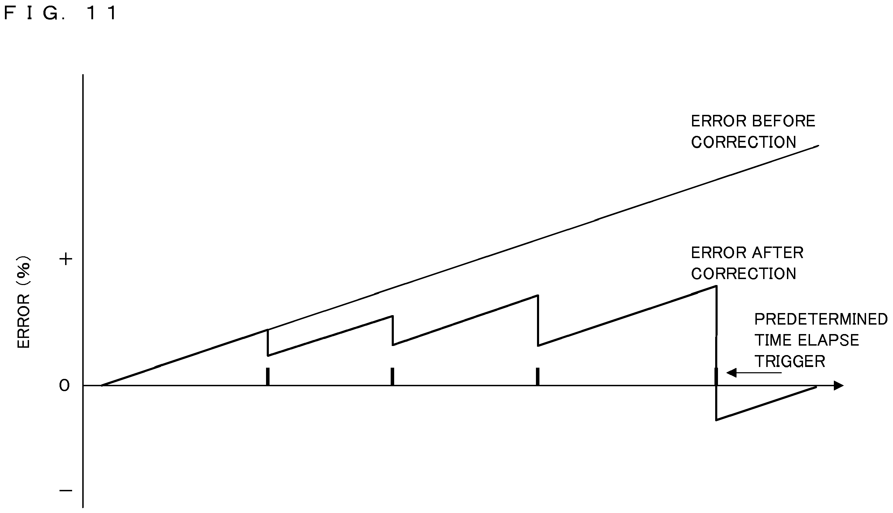

FIG. 11 is an explanatory diagram illustrating an example an error of the amount of charge of the secondary battery unit 50 according to the battery monitoring device 100 of the first embodiment. In FIG. 11, a horizontal axis indicates time, and a vertical axis indicates an error of the amount of charge SOC. In FIG. 11, the true value of the current integration is represented by the horizontal axis of the error of 0%. A graph represented by "Error before Correction", illustrates a ratio of the difference (the error) between the first amount of charge with respect to the true value of the current integration, and the true value of the current integration. In addition, a graph represented by "Error after Correction", illustrates a ratio of the amount of charge (the error) after the correction with respect to the true value of the current integration. As illustrated in FIG. 11, it is known that the amount of charge of the secondary battery unit 50 is corrected such that the error decreases, at the timing when the predetermined time elapse trigger is generated.

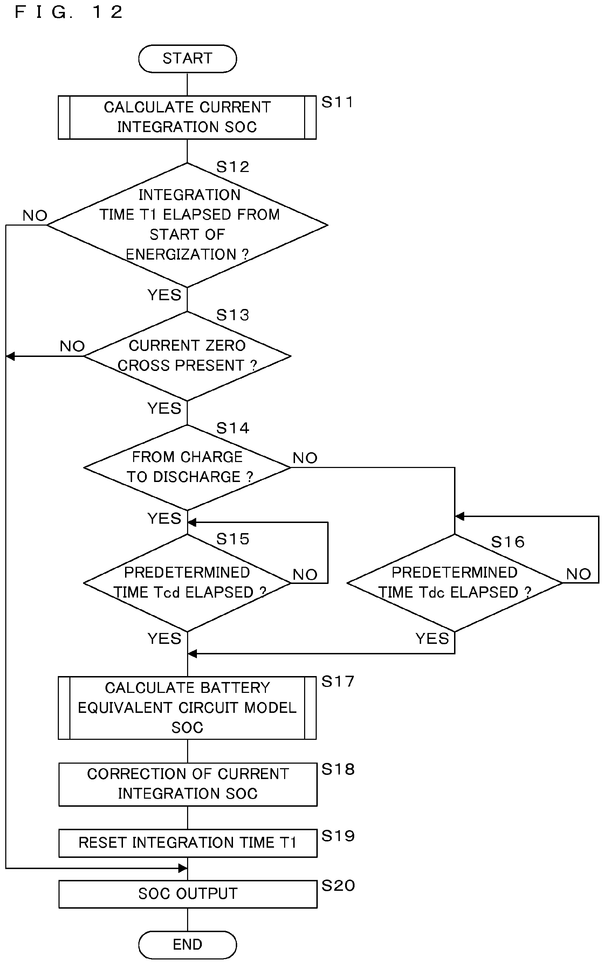

Next, the operation of the battery monitoring device 100 of this embodiment will be described. FIG. 12 is a flowchart illustrating a first example of a processing procedure of amount of charge calculation according to the battery monitoring device 100 of the first embodiment. Hereinafter, for the sake of simplicity, the main part of the processing will be described as the control portion 10. The control portion 10 calculates the current integration SOC (the first amount of charge) (S11). A calculation frequency of the current integration SOC can be synchronized with the sampling cycle of the current detection of the secondary battery unit 50, and for example, can be set to 10 ms. The details of calculation processing of the current integration SOC will be described below.

The control portion 10 determines whether or not an integration time T1 has elapsed from the start of energization (S12). The integration time T1, for example, can be set to 10 minutes, 20 minutes, and the like. The integration time T1 may be suitably set according to the type, the model, or the like of the secondary battery unit 50. In a case where the integration time T1 has elapsed from the start of the energization (YES in S12), the control portion 10 determines the presence or absence of the current zero cross (S13), and in a case where there is current zero cross (YES in S13), determines whether or not there is switching from charge to discharge (S14).

In a case where there is switching from charge to discharge (YES in S14), the control portion 10 determines whether or not a predetermined time Tcd has elapsed from a time point when the current zero cross occurs (S15). The predetermined time Tcd, for example, can be set to approximately 0.1 seconds to 2 seconds. In a case where the predetermined time Tcd has not elapsed (NO in S15), the control portion 10 continuously performs the processing of Step S15. In a case where the predetermined time Tcd has elapsed (YES in S15), the control portion 10 calculates the battery equivalent circuit model SOC (the second amount of charge) (S17). The details of calculation processing of the battery equivalent circuit model SOC will be described below.

In a case where there is no switching from charge to discharge (NO in S14), that is, in a case where there is switching from discharge to charge, the control portion 10 determines whether or not the predetermined time Tdc has elapsed from the time point when the current zero cross occurs (S16). The predetermined time Tdc, for example, can be set to approximately 0.1 seconds to 2 seconds. In a case where the predetermined time Tdc has not elapsed (NO in S16), the control portion 10 continuously performs the processing of Step S16. In a case where the predetermined time Tdc has elapsed (YES in S16), the control portion 10 performs the processing of Step S17.

The control portion 10 performs the correction of the current integration SOC (S18). The correction of the current integration SOC is processing of substituting the most recently calculated current integration SOC with the battery equivalent circuit model SOC, at a time point when the predetermined time Tcd or Tdc has elapsed.

The control portion 10 resets the integration time T1 (S19), outputs the substituted battery equivalent circuit model SOC, as the amount of charge SOC of the secondary battery unit 50 (S20), and ends the processing. In a case where the integration time T1 has not elapsed from the start of the energization start (NO in S12), or in a case where there is no current zero cross (NO in S13), the control portion 10 outputs the calculated current integration SOC, as the amount of charge SOC of the secondary battery unit 50 (S20), and ends the processing. Furthermore, in a case where the secondary battery unit 50 is continuously charged or discharged, the processing illustrated in FIG. 12 can be repeatedly performed.

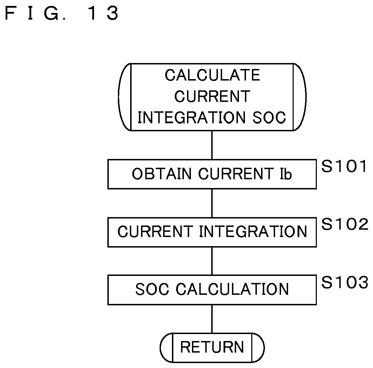

FIG. 13 is a flowchart illustrating an example of a processing procedure of current integration SOC calculation according to the battery monitoring device 100 of the first embodiment. The control portion 10 obtains the current Ib of the secondary battery unit 50 at a predetermined sampling cycle (for example, 10 ms) (S101), and integrates the obtained current value (S102). The control portion 10 divides the integrated current value by full-charge capacity, calculates the current integration SOC (S103), and ends the processing. Furthermore, in an initial value of SOC, for example, a voltage obtained when an ignition is turned off, or immediately after the ignition is turned on, that is, when the current of the secondary battery unit 50 does not flow, may be set to OCV, and SOC obtained from OCV may be set to the initial value.

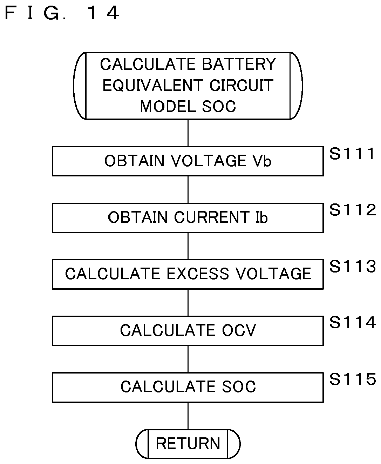

FIG. 14 is a flowchart illustrating an example of a processing procedure of battery equivalent circuit model SOC calculation according to the battery monitoring device 100 of the first embodiment. The control portion 10 obtains the voltage Vb of the secondary battery unit 50 (S111), and obtains the current Ib (S112). A timing for obtaining the voltage Vb and the current Ib may be every predetermined sampling cycle (for example, 10 ms), or may be a timing after values sampled a plurality of times are averaged.

The control portion 10 calculates the excess voltage, on the basis of the obtained current Ib and the battery equivalent circuit model (S113), and calculates the open voltage OCV, on the basis of the obtained voltage Vb and the calculated excess voltage (S114). The control portion 10 converts the calculated open voltage OCV, calculates the battery equivalent circuit model SOC (S115), and ends the processing.

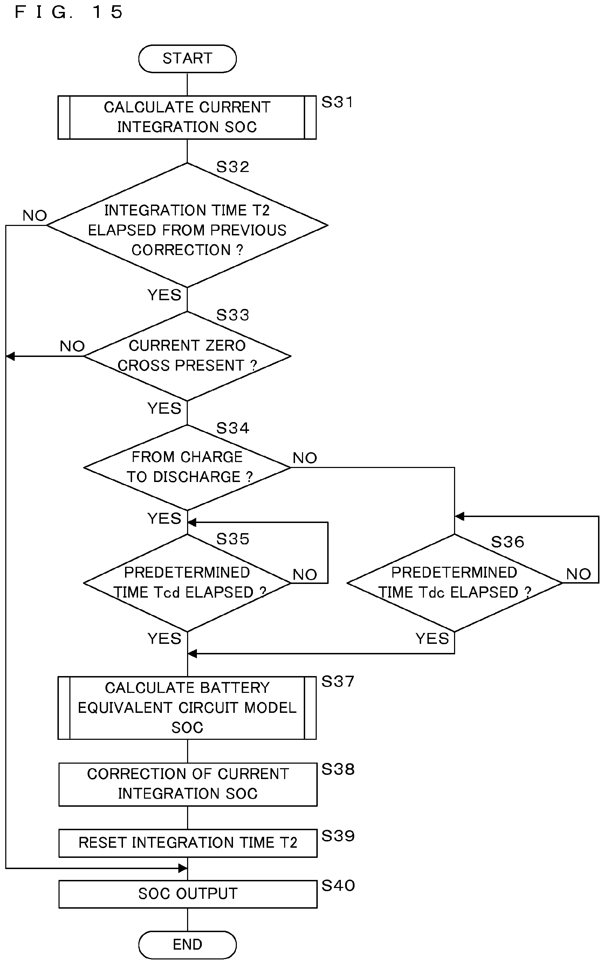

FIG. 15 is a flowchart illustrating a second example of the processing procedure of the amount of charge calculation according to the battery monitoring device 100 of the first embodiment. A difference from the first example illustrated in FIG. 12 is that the origination of the integration time is different. The control portion 10 calculates the current integration SOC (the first amount of charge) (S31). The calculation frequency of the current integration SOC can be synchronized with the sampling cycle of the current detection of the secondary battery unit 50, and for example, can be set to 10 ms. The calculation processing of the current integration SOC is identical to the processing illustrated in FIG. 13.

The control portion 10 determines whether or not an integration time T2 has elapsed from the previous (the most recent) correction time point (S32). The integration time T2, for example, can be set to 10 minutes, 20 minutes, and the like. The integration time T2 may be suitably set according to the type, the model, or the like of the secondary battery unit 50. In a case where the integration time T2 has elapsed from the previous correction time point (YES in S32), the control portion 10 determines the presence or absence of the current zero cross (S33), and in a case where there is no current zero cross (YES in S33), determines whether or not there is switching from charge to discharge (S34).

In a case where there is switching from charge to discharge (YES in S34), the control portion 10 determines whether or not the predetermined time Tcd has elapsed from the time point when the current zero cross occurs (S35). The predetermined time Tcd, for example, can be set to approximately 0.1 seconds to 2 seconds. In a case where the predetermined time Tcd has not elapsed (NO in S35), the control portion 10 continuously performs the processing of Step S35. In a case where the predetermined time Tcd has elapsed (YES in S35), the control portion 10 calculates the battery equivalent circuit model SOC (the second amount of charge) (S37). The calculation processing of the battery equivalent circuit model SOC is identical to the processing illustrated in FIG. 14.

In a case where there is no switching from charge to discharge (NO in S34), that is, in a case where there is switching from discharge to charge, the control portion 10 determines whether or not the predetermined time Tdc has elapsed from the time point when the current zero cross occurs (S36). The predetermined time Tdc, for example, can be set to approximately 0.1 seconds to 2 seconds. In a case where the predetermined time Tdc has not elapsed (NO in S36), the control portion 10 continuously performs the processing of Step S36. In a case where the predetermined time Tdc has elapsed (YES in S36), the control portion 10 performs the processing of Step S37.

The control portion 10 performs the correction of the current integration SOC (S38). The correction of the current integration SOC is processing of substituting the most recently calculated current integration SOC with the battery equivalent circuit model SOC, at the time point when the predetermined time Tcd or Tdc has elapsed.

The control portion 10 resets the integration time T2 (S39), outputs the substituted battery equivalent circuit model SOC, as the amount of charge SOC of the secondary battery unit 50 (S40), and ends the processing. In a case where the integration time T2 has not elapsed from the previous correction time point (NO in S32), or in a case where there is no current zero cross (NO in S33), the control portion 10 outputs the calculated current integration SOC, as the amount of charge SOC of the secondary battery unit 50 (S40), and ends the processing. Furthermore, in a case where the secondary battery unit 50 is continuously charged or discharged, the processing illustrated in FIG. 15 can be repeatedly performed.

Next, a method of calculating the amount of charge SOC of the secondary battery unit 50, on the basis of a correction amount of the previous (the most recent) amount of charge (a difference in the amount of charge), will be described in the case of using a unit time error amount as a third example and the case of using a unit capacity error amount as a fourth example. First, the case of using the unit time error amount as the third example, will be described.

The difference in amount of charge calculation portion 18 calculates a difference in the amount of charge of the first amount of charge calculated by the first amount of charge calculation portion 13, and the substituted second amount of charge, at a time point when the second amount of charge calculated by the second amount of charge calculation portion 14, is set to the amount of charge of the secondary battery unit 50 (that is, a correction time point when the first amount of charge is substituted with the second amount of charge, and thus, the first amount of charge is corrected). In a case where the first amount of charge is set to SOC1, and the second amount of charge is set to SOC2, the difference ΔSOC in the amount of charge can be represented by an expression of ΔSOC = SOC2-SOC1.

The unit time error amount calculation portion 19 calculates the unit time error amount per unit time of the amount of charge, on the basis of the difference in the amount of charge, calculated by the difference in amount of charge calculation portion 18. In a case where the unit time error amount is set to ΔEt, and a time required for charging or discharging the capacity ΔEAh corresponding to the difference ΔSOC in the amount of charge, is set to Te, the unit time error amount ΔEt can be calculated by an expression of ΔEt = ΔEAh/Te. Here, in a case where the full-charge capacity of the secondary battery unit 50 is set to FCC, ΔEAh = FCC × ΔSOC/100 is obtained. That is, the capacity ΔEAh is obtained by converting the difference ΔSOC in the amount of charge of which the unit is %, to Ah unit.

The condition determination portion 16 determines whether or not the predetermined condition is satisfied, on the basis of the elapsed time from a time point when the second amount of charge calculated by the second amount of charge calculation portion 14, is set to the amount of charge of the secondary battery unit 50 (that is, the most recent correction time point of the amount of charge), and the unit time error amount.

For example, in a case where Unit Time Error Amount ΔEt × Elapsed Time t, is greater than or equal to a predetermined value, an error amount (ΔEt × t) is greater than or equal to a predetermined value, and thus, it is possible to determine that the predetermined condition is satisfied. Accordingly, it is possible to determine whether or not the first amount of charge is substituted with the second amount of charge, and thus the first amount of charge is corrected, on the basis of the most recently obtained the difference ΔSOC in the amount of charge.

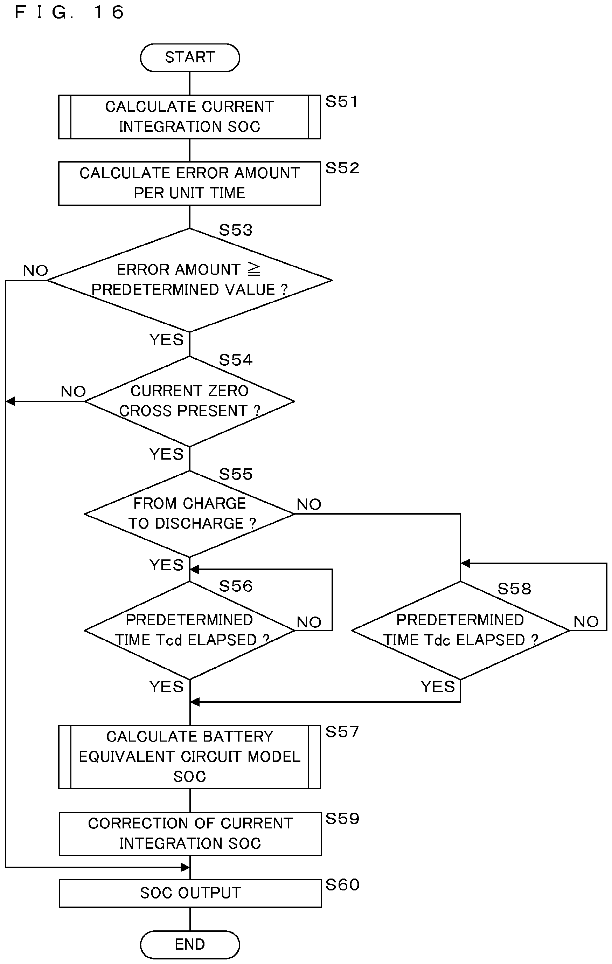

FIG. 16 is a flowchart illustrating a third example of the processing procedure of the amount of charge calculation according to the battery monitoring device 100 of the first embodiment. The control portion 10 calculates the current integration SOC (the first amount of charge) (S51). The calculation frequency of the current integration SOC can be synchronized with the sampling cycle of the current detection of the secondary battery unit 50, and for example, can be set to 10 ms. The calculation processing of the current integration SOC is identical to the processing illustrated in FIG. 13.

The control portion 10 calculates the error amount (the unit time error amount ΔEt) per unit time (S52), and determines whether or not the error amount (ΔEt × Elapsed Time t) is greater than or equal to the predetermined value (S53). Furthermore, the predetermined value can be set to approximately 5% to 10% of SOC of a determination time point, but is not limited thereto.

In a case where the error amount (ΔEt × Elapsed Time t) is greater than or equal to the predetermined value (YES in S53), the control portion 10 determines the presence or absence of the current zero cross (S54), and in a case where there is current zero cross (YES in S54), determines whether or not there is switching from charge to discharge (S55).

In a case where is switching from charge to discharge (YES in S55), the control portion 10 determines whether or not the predetermined time Tcd has elapsed from the time point when the current zero cross occurs (S56). The predetermined time Tcd, for example, can be set to approximately 0.1 seconds to 2 seconds. In a case where the predetermined time Tcd has not elapsed (NO in S56), the control portion 10 continuously perform the processing of Step S56. In a case where the predetermined time Tcd has elapsed (YES in S56), the control portion 10 calculates the battery equivalent circuit model SOC (the second amount of charge) (S57). The calculation processing of the battery equivalent circuit model SOC is identical to the processing illustrated in FIG. 14.

In a case where there is no switching from charge to discharge (NO in S55), that is, in a case where there is switching from discharge to charge, the control portion 10 determines whether or not the predetermined time Tdc has elapsed from the time point when the current zero cross occurs (S58). The predetermined time Tdc, for example, can be set to approximately 0.1 seconds to 2 seconds. In a case where the predetermined time Tdc has not elapsed (NO in S58), the control portion 10 continuously performs the processing of Step S58. In a case where the predetermined time Tdc has elapsed (YES in S58), the control portion 10 performs the processing of Step S57.

The control portion 10 performs the correction of the current integration SOC (S59). The correction of the current integration SOC is processing of substituting the most recently calculated current integration SOC with the battery equivalent circuit model SOC, at the time point when the predetermined time Tcd or Tdc has elapsed.

The control portion 10 outputs the substituted battery equivalent circuit model SOC, as the amount of charge SOC of the secondary battery unit 50 (S60), and ends the processing. In a case where the error amount (ΔEt × Elapsed Time t) is not greater than or equal to the predetermined value (NO in S53), or in a case where there is no current zero cross (NO in S54), the control portion 10 outputs the calculated current integration SOC, as the amount of charge SOC of the secondary battery unit 50 (S60), and ends the processing. Furthermore, in a case where the secondary battery unit 50 is continuously charged or discharged, the processing illustrated in FIG. 16 can be repeatedly performed.

In the processing illustrated in FIG. 16, the processing of Steps S53, S54, S55, S56, and S58 can be omitted. That is, in a case where the error amount (ΔEt × Elapsed Time t) is greater than or equal to the predetermined value (YES in S53), the control portion 10 may calculate the battery equivalent circuit model SOC (the second amount of charge) (S57).

Next, the case of using the unit capacity error amount as the fourth example, will be described.

As with the third example, the difference in amount of charge calculation portion 18 calculates the difference in the amount of charge of the first amount of charge calculated by the first amount of charge calculation portion 13, and the substituted second amount of charge, at the time point when the second amount of charge calculated by the second amount of charge calculation portion 14, is set to the amount of charge of the secondary battery unit 50 (that is, the correction time point when the first amount of charge is substituted with the second amount of charge, and thus, the first amount of charge is corrected). In a case where the first amount of charge is set to SOC1, and the second amount of charge is set to SOC2, the difference ΔSOC in the amount of charge can be represented by an expression of ΔSOC = SOC2 - SOC1.

The unit capacity error amount calculation portion 20 calculates the unit capacity error amount per unit capacity of the amount of charge, on the basis of the difference in the amount of charge, calculated by the difference in amount of charge calculation portion 18. In a case where the unit capacity error amount is set to ΔEc, and a charge and discharge capacity absolute value reaching the capacity ΔEAh corresponding to the difference ΔSOC in the amount of charge, is set to Ca, the unit capacity error amount ΔEc can be calculated by an expression of ΔEc = ΔEAh/Ce. Here, in a case where the full-charge capacity of the secondary battery unit 50 is set to FCC, ΔEAh = FCC × ΔSOC/100 is obtained. That is, the capacity ΔEAh is obtained by converting the difference ΔSOC in the amount of charge of which the unit is %, to Ah unit.

The condition determination portion 16 determines whether or not the predetermined condition is satisfied, on the basis of the charge and discharge capacity of the secondary battery unit 50 after the time point when the second amount of charge calculated by the second amount of charge calculation portion 14, is set to the amount of charge of the secondary battery unit 50 (that is, the most recent correction time point of the amount of charge), and the unit capacity error amount.

For example, in a case where Unit Capacity Error Amount ΔEc × Charge and Discharge Capacity c (an absolute value of charge and discharge capacity after the most recent correction time point of the amount of charge), is greater than or equal to a predetermined value, the error amount (ΔEc × c) is greater than or equal to the predetermined value, and thus, it is possible to determine that the predetermined condition is satisfied. Accordingly, it is possible to determine whether or not the first amount of charge is substituted with the second amount of charge, and thus, the first amount of charge is corrected, on the basis of the most recently obtained difference ΔSOC in the amount of charge.

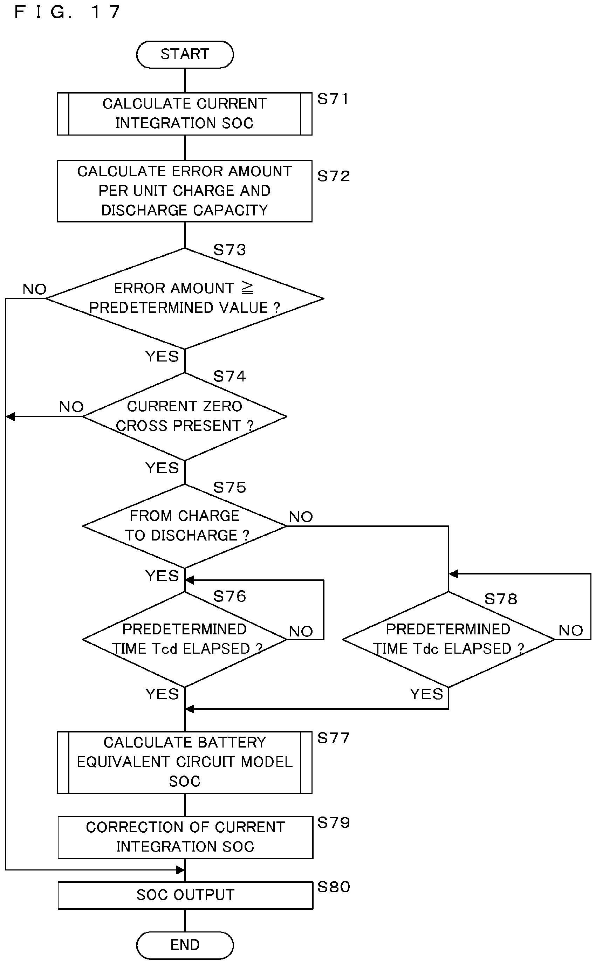

FIG. 17 is a flowchart illustrating a fourth example of the processing procedure of the amount of charge calculation according to the battery monitoring device 100 of the first embodiment. The control portion 10 calculates the current integration SOC (the first amount of charge) (S71). The calculation frequency of the current integration SOC can be synchronized with the sampling cycle of the current detection of the secondary battery unit 50, and for example, can be set to 10 ms. The calculation processing of the current integration SOC is identical to the processing illustrated in FIG. 13.

The control portion 10 calculates an error amount (the unit capacity error amount ΔEc) per unit charge and discharge capacity (S72), and determines whether or not the error amount (ΔEc × Charge and Discharge Capacity c) is greater than or equal to a predetermined value (S73). Furthermore, the predetermined value can be set to approximately 5% to 10% of SOC of the determination time point, but is not limited thereto.

In a case where the error amount (ΔEc × Charge and Discharge Capacity c) is greater than or equal to the predetermined value (YES in S73), the control portion 10 determines the presence or absence of the current zero cross (S74), and in a case where there is current zero cross (YES in S74), determines whether or not there is switching from charge to discharge (S75).

In a case where there is switching from charge to discharge (YES in S75), the control portion 10 determines whether or not the predetermined time Tcd has elapsed from the time point when the current zero cross occurs (S76). The predetermined time Tcd, for example, can be set to approximately 0.1 seconds to 2 seconds. In a case where the predetermined time Tcd has not elapsed (NO in S76), the control portion 10 continuously performs the processing of Step S76. In a case where the predetermined time Tcd has elapsed (YES in S76), the control portion 10 calculates the battery equivalent circuit model SOC (the second amount of charge) (S77). The calculation processing of the battery equivalent circuit model SOC is identical to the processing illustrated in FIG. 14.

In a case where there is no switching from charge to discharge (NO in S75), that is, in a case where there is switching from discharge to charge, the control portion 10 determines whether or not the predetermined time Tdc has elapsed from the time point when the current zero cross occurs (S78). The predetermined time Tdc, for example, can be set to approximately 0.1 seconds to 2 seconds. In a case where the predetermined time Tdc has not elapsed (NO in S78), the control portion 10 continuously performs the processing of Step S78. In a case where the predetermined time Tdc has elapsed (YES in S78), the control portion 10 performs the processing of Step S77.

The control portion 10 performs the correction of the current integration SOC (S79). The correction of the current integration SOC is processing of substituting the most recently calculated current integration SOC with the battery equivalent circuit model SOC, at the time point when the predetermined time Tcd or Tdc has elapsed.

The control portion 10 outputs the substituted battery equivalent circuit model SOC, as the amount of charge SOC of the secondary battery unit 50 (S80), and ends the processing. In a case where the error amount (ΔEc × Charge and Discharge Capacity c) is not greater than or equal to the predetermined value (NO in S73), or in a case where there is no current zero cross (NO in S74), the control portion 10 outputs the calculated current integration SOC, as the amount of charge SOC of the secondary battery unit 50 (S80), and ends the processing. Furthermore, in a case where the secondary battery unit 50 is continuously charged or discharged, the processing illustrated in FIG. 17 can be repeated performed.

In the processing illustrated in FIG. 17, the processing of Steps S73, S74, S75, S76, and S78 can be omitted. That is, in a case where the error amount (ΔEc × Charge and Discharge Capacity c) is greater than or equal to the predetermined value (YES in S73), the control portion 10 may calculate the battery equivalent circuit model SOC (the second amount of charge) (S77).

The amount of charge calculation device of this embodiment (the battery monitoring device 100), can be realized by using a general-purpose computer including a CPU (a processor), a RAM (a memory), and the like. That is, a computer program for defining the procedures of each of the processings as illustrated in FIG. 12 to FIG. 17, is loaded in the RAM (the memory) of the computer, and the computer program is executed by the CPU (the processor), and thus, the amount of charge calculation device (the battery monitoring device 100) can be realized on the computer.

As described above, according to the battery monitoring device 100 of this embodiment (the amount of charge calculation device), it is not necessary that the secondary battery unit is in an unloaded state, and even in a case where a current flows through the secondary battery unit, it is possible to correct the amount of charge based on the current integration by substituting the amount of charge based on the current integration with the amount of charge based on the battery equivalent circuit model, and it is possible to accurately calculate the amount of charge of the secondary battery unit.

In addition, as a comparative example, there is a method in which the open voltage is calculated from the terminal voltage of the secondary battery and a characteristic line obtained by linear regression calculation from the current, and in a case where a difference between the amount of charge to be calculated on the basis of the open voltage, and the amount of charge based on the current integration, is greater than or equal to a predetermined value, the amount of charge based on the current integration is substituted with the amount of charge to be calculated on the basis of the open voltage. However, in such a method, in order to obtain the characteristic line having a high accuracy by the linear regression calculation, it is necessary to sample the voltage and the current many times, and it is necessary that there is a certain degree of variation in the sampled voltage and current, and for example, in a case where there are many chances that the vehicle is driven at a constant speed, it is not possible to accurately obtain the open voltage, and it is not possible to correct the amount of charge. However, according to the battery monitoring device 100 of this embodiment, it is not necessary to perform the linear regression calculation, and it is possible to correct the amount of charge of the secondary battery unit at the switching timing of charge and discharge of the secondary battery unit (accurately, a time point when a predetermined time has elapsed after the switching between charge and discharge).

In addition, as a comparative example, there is a method in which the open voltage is calculated from the terminal voltage, the current, and the internal resistance of the secondary battery, and in a case where a difference between the amount of charge to be calculated on the basis of the open voltage, and the amount of charge based on the current integration, is greater than or equal to a predetermined value, the amount of charge based on the current integration is substituted with the amount of charge to be calculated on the basis of the open voltage. However, in such a method, in the case of calculating the open voltage, an influence of polarization of the secondary battery is not considered, and thus, it is not possible to accurately obtain the open voltage, and it is not possible to correct the amount of charge. However, according to the battery monitoring device 100 of this embodiment, the influence of the polarization is included in the battery equivalent circuit model, and thus, an error due to the polarization does not occur by using the battery equivalent circuit model.

### (Second Embodiment)

Next, a second embodiment will be described. Furthermore, the secondary battery unit 50 is identical to that of the first embodiment.

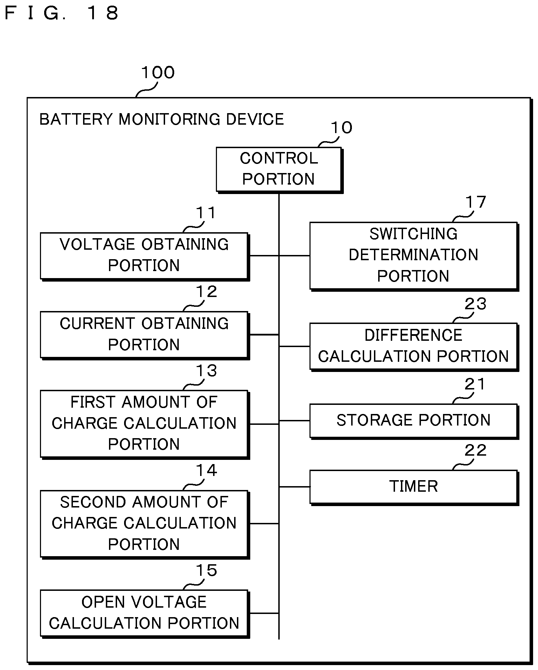

FIG. 18 is a block diagram illustrating an example of the configuration of the battery monitoring device 100 of the second embodiment. The battery monitoring device 100 includes the control portion 10 controlling the entire device, the voltage obtaining portion 11, the current obtaining portion 12, the first amount of charge calculation portion 13, the second amount of charge calculation portion 14, the open voltage calculation portion 15, the switching determination portion 17, a difference calculation portion 23, the storage portion 21, the timer 22 for clocking, and the like.

The voltage obtaining portion 11 obtains the voltage of the secondary battery unit 50 (for example, the voltage of the secondary battery unit 50 on both ends). In addition, the current obtaining portion 12 obtains the current of the secondary battery unit 50 (a charge current and a discharge current). Furthermore, an obtaining frequency of the voltage and the current, and a sampling cycle for obtaining the voltage and the current, can be controlled by the control portion 10. The sampling cycle, for example, can be set to 10 ms, but is not limited thereto.

The first amount of charge calculation portion 13 has a function as the first calculation portion, and calculates a first amount of charge of the secondary battery unit 50 by integrating the current obtained by the current obtaining portion 12. The first amount of charge is an amount of charge based on a current integration, and is also referred to as the current integration SOC. Furthermore, in this embodiment, the amount of charge is also referred to as a state of charge (SOC) or a charging rate, and indicates the ratio of charged capacity to full-charge capacity. The current integration is obtained by integrating the current over time, and for example, in a case where a sampling interval for obtaining the current is set to Δt, and a current value obtained at each sampling is set to Ibi (i = 1, 2, ...), the current integration can be calculated on the basis of ∑Ibi × Δt (i = 1, 2, ...). In a case where the most recently obtained amount of charge is set to SOCin, and the first amount of charge is set to SOC1, the first amount of charge can be calculated by an expression of SOC1 = SOCin ± {∑Ibi × Δt (i = 1, 2, ...)/Full-Charge Capacity FCC}. Furthermore, in the expression described above, + is used at the time of charge, and - is used at the time of discharge, as the symbol of ±.

The second amount of charge calculation portion 14 has a function as the second calculation portion, and calculates a second amount of charge of the secondary battery unit 50, on the basis of the voltage obtained by the voltage obtaining portion 11, the current obtained by the current obtaining portion 12, and an equivalent circuit model of the secondary battery unit 50. The second amount of charge is an amount of charge based on the equivalent circuit model of the secondary battery unit 50, and is also referred to as the battery equivalent circuit model SOC. The current integration is not adopted in the second amount of charge, and thus, the second amount of charge is not affected by an error of the current value, which is accumulated by gradually increasing in a process of integrating the current (for example, an error of the current sensor 53). Furthermore, the voltage and the current are a value at the time of charging or discharging the secondary battery unit 50, and the secondary battery unit 50 is not in an unloaded state.

The switching determination portion 17 determines the presence or absence of switching between charge and discharge of the secondary battery unit 50, on the basis of the current obtained by the current obtaining portion 12. For example, in a case where one of charge and discharge is defined as positive, and the current is changed from positive to negative, or the current is changed from negative to positive, it is possible to determine that there is switching between charge and discharge..

In a case where the switching determination portion 17 determines that there is no switching between charge and discharge, the control portion 10 sets the first amount of charge to the amount of charge of the secondary battery unit 50. In addition, in a case where the switching determination portion 17 determines that there is switching between charge and discharge, the control portion 10 sets the second amount of charge to the amount of charge of the secondary battery unit 50, in order to correct the first amount of charge (the first amount of charge is substituted with the second amount of charge).

In a case where switching from charge to discharge, or switching from discharge to charge, is performed, it is considered that internal impedance of the secondary battery unit 50 is reset once, and the accuracy of the equivalent circuit model increases. Accordingly, in a case where there is no switching between charge and discharge of the secondary battery unit 50, the first amount of charge based on the current integration, is set to the amount of charge, and in a case where there is switching between charge and discharge of the secondary battery unit 50, the second amount of charge based on the equivalent circuit model which is not affected by the current integration, can be set to the amount of charge, and thus, even in a case where a charge and discharge current flows through the secondary battery unit 50, it is possible to accurately calculate the amount of charge of the secondary battery unit 50.

In a case where the switching determination portion 17 determines that there is switching between charge and discharge, the second amount of charge calculation portion 14 calculates the second amount of charge of the secondary battery unit 50, on the basis of the voltage obtained by the voltage obtaining portion 11 and the current obtained by the current obtaining portion 12, after a predetermined time has elapsed from a switching time point of charge and discharge. In the predetermined time, different values or the same value may be used between a case where switching is performed from charge to discharge and a case where switching is performed from discharge to charge. The predetermined time, for example, can be set to approximately 0.1 seconds to 2 seconds, but is not limited thereto.

The impedance of the secondary battery unit 50 can be stabilized according to an energization time (a charge time or a discharge time) after the switching between charge and discharge, and an influence of an excess voltage can be reduced, and thus, it is possible to increase the accuracy of the second amount of charge based on the equivalent circuit model. Furthermore, the excess voltage indicates a difference between the voltage (a terminal voltage) and the open voltage OCV (also referred to as an open circuit voltage) of the secondary battery unit 50.

Next, a calculation method of the second amount of charge will be described in more detail.

The open voltage calculation portion 15 calculates the open voltage OCV of the secondary battery unit 50, on the basis of a voltage Vb obtained by the voltage obtaining portion 11, a current Ib obtained by the current obtaining portion 12, and the equivalent circuit model of the secondary battery unit 50.

As described in FIG. 4 and FIG. 5 of the first embodiment, in the excess voltage to be generated due to the current Ib flowing through the equivalent circuit model, the voltage Vb to be obtaining (detected), and the open voltage OCV, a relationship of (OCV = Vb - Excess Voltage) is established. Here, in a case where the current Ib is positive at the time of charge, is negative at the time of discharge, the excess voltage is also positive at the time of charge, and is negative at the time of discharge.

The second amount of charge calculation portion 14 calculates the second amount of charge of the secondary battery unit 50, on the basis of the open voltage OCV calculated by the open voltage calculation portion 15, and a corresponding relationship between the open voltage OCV and the amount of charge SOC of the secondary battery unit 50.

As with the first embodiment, it is not necessary to detect the voltage of the secondary battery unit 50 at no load, and even in a case where the charge and discharge current flows through the secondary battery unit 50, it is possible to calculate the second amount of charge for correcting the first amount of charge based on the current integration.

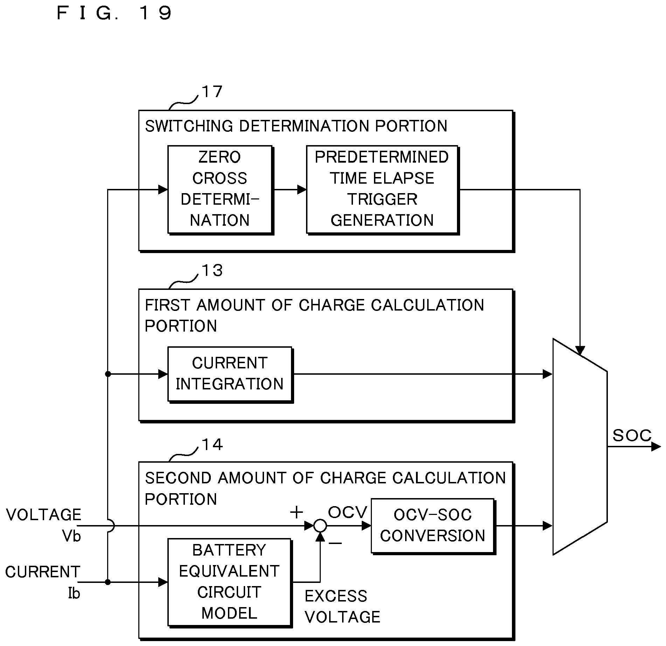

FIG. 19 is a schematic view illustrating main parts of the calculation processing of the amount of charge of the secondary battery unit 50 according to the battery monitoring device 100 of the second embodiment. In a case where the voltage Vb and the current Ib of the secondary battery unit 50, are obtained at a predetermined sampling cycle (for example, 10 ms), the first amount of charge calculation portion 13 performs current integration processing, and calculates the first amount of charge at the sampling cycle. The control portion 10 outputs the calculated first charge capacity, as the amount of charge SOC of the secondary battery unit 50.

The second amount of charge calculation portion 14 calculates the excess voltage of the secondary battery unit 50, on the basis of the current Ib and the battery equivalent circuit model of the secondary battery unit 50, subtracts the calculated excess voltage from the voltage Vb of the secondary battery unit 50, and calculates the open voltage OCV. The second amount of charge calculation portion 14 converts the calculated open voltage OCV, on the basis of the OCV-SOC characteristics as exemplified in FIG. 6, and thus, calculates the second amount of charge. A calculation frequency of the second amount of charge may be every sampling cycle described above (for example, 10 ms), or may be every time when a trigger described below is generated.

The switching determination portion 17 performs zero cross determination processing (determination processing of the presence or absence of current zero cross, that is, determination processing of the presence or absence of switching between charge and discharge), on the basis of the current Ib of the secondary battery unit 50, and performs predetermined time elapse trigger generation processing of generating the trigger (also referred to as a predetermined time elapse trigger) at a time point when a predetermined time (for example, approximately 0.1 seconds to 2 seconds) has elapsed from a time point when there is current zero cross (the switching time point of charge and discharge).

The control portion 10 corrects the first amount of charge by substituting the first amount of charge with the second amount of charge, at a time point when the predetermined time elapse trigger is generated. That is, the control portion 10 outputs the second amount of charge calculated by the second amount of charge calculation portion 14 at the time point when the predetermined time elapse trigger is generated, as the amount of charge SOC of the secondary battery unit 50.

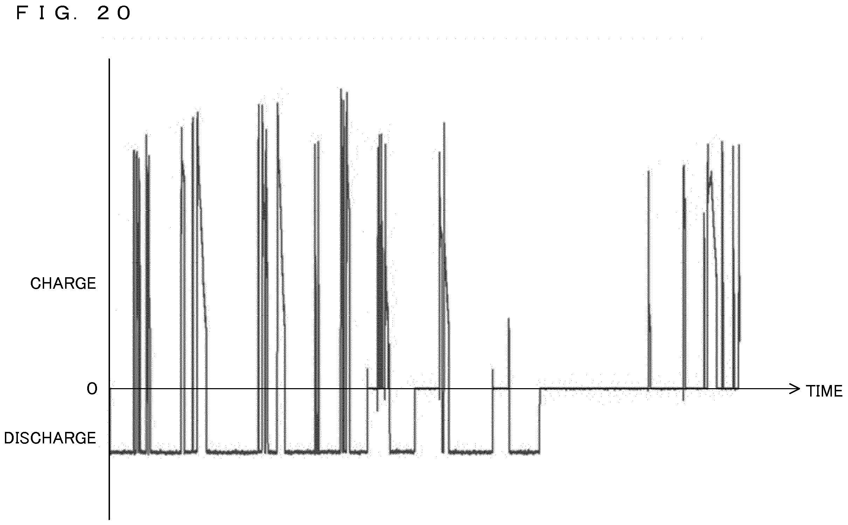

FIG. 20 is an explanatory diagram illustrating an example of a current waveform of the secondary battery unit 50 of the second embodiment. In FIG. 20, a horizontal axis indicates time, and a vertical axis indicates a current. In a case where the current is positive, a charge state is set, and in a case where the current is negative, a discharge state is set. In the example of FIG. 20, a current transition for several hours is illustrated, and it is known that the current zero cross occurs, at a timing when switching from charge to discharge, and switching from discharge to charge are performed. Furthermore, the current waveform is an example, and is not limited thereto.

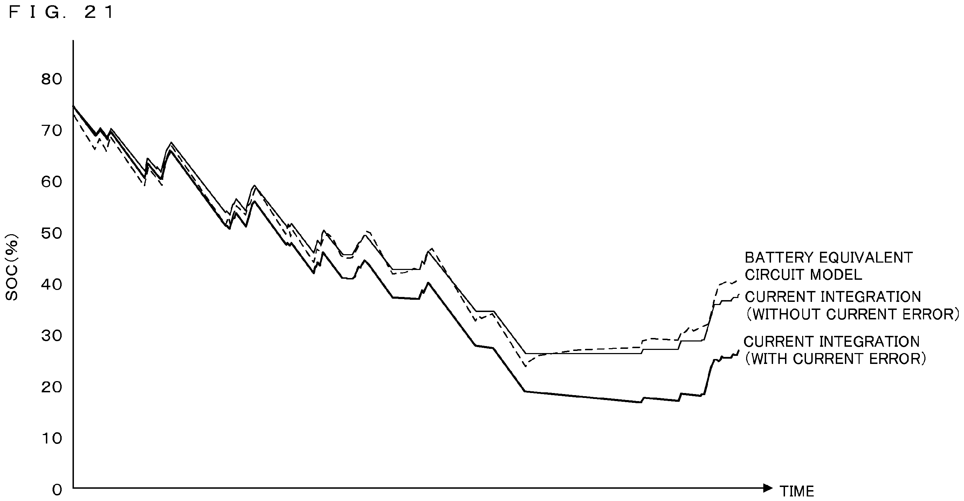

FIG. 21 is an explanatory diagram illustrating an example of each of the amounts of charge to be calculated by the battery monitoring device 100 of the second embodiment. In FIG. 21, a horizontal axis indicates time, and a vertical axis indicates the amount of charge SOC. In FIG. 21, a graph represented by "Current Integration (with Current Error)", illustrates a transition from a time 0 of the first amount of charge calculated on the basis of the current exemplified in FIG. 20. In addition, a graph represented by "Battery Equivalent Circuit Model", illustrates a transition from a time 0 of the second amount of charge calculated on the basis of the current exemplified in FIG. 20. In addition, a graph represented by "Current Integration (without Current Error)", illustrates a transition from a time 0 in a case where the current exemplified in FIG. 20 is integrated in a state without an error, and indicates a true value of the current integration.

As illustrated in FIG. 21, current integration, is small, while the time elapse from the time 0 is short, and the first amount of charge accurately indicates the amount of charge of the secondary battery unit 50. In addition, it is also known that the second amount of charge tends to be close to the true value of the current integration, at the timing when the switching between charge and discharge occurs.

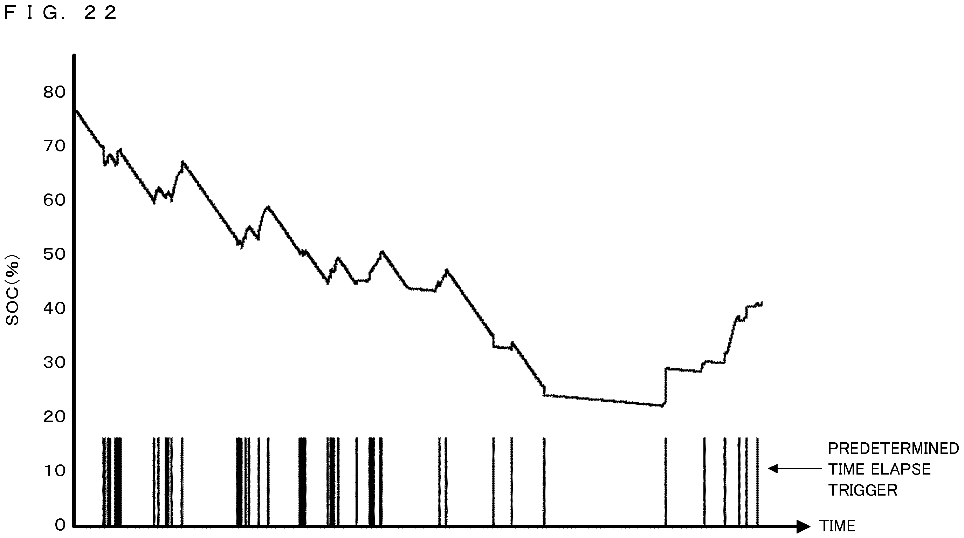

FIG. 22 is an explanatory diagram illustrating an example of the amount of charge of the secondary battery unit 50 according to the battery monitoring device 100 of the second embodiment. In FIG. 22, a horizontal axis indicates time, and a vertical axis indicates the amount of charge SOC. In FIG. 22, the predetermined time elapse trigger is generated whenever there is switching between charge and discharge. Then, it is known that the amount of charge of the secondary battery unit 50 is corrected at the timing when the predetermined time elapse trigger is generated. In addition, it is possible to correct the amount of charge of the secondary battery unit 50 whenever there is switching between charge and discharge, and in a vehicle of which charge and discharge are frequently repeated, it is possible to improve a calculation accuracy of the amount of charge of the secondary battery unit 50.

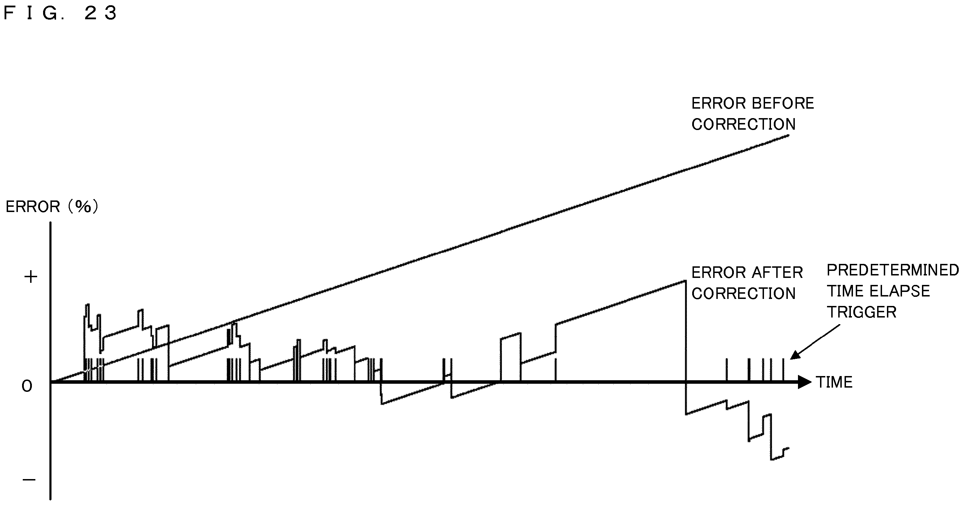

FIG. 23 is an explanatory diagram illustrating an example of an error of the amount of charge of the secondary battery unit 50 according to the battery monitoring device 100 of the second embodiment. In FIG. 23, a horizontal axis indicates time, and a vertical axis indicates an error of the amount of charge SOC. In FIG. 23, the true value of the current integration is represented by the horizontal axis of the error of 0%." A graph represented by "Error before Correction", illustrates a ratio of the difference (the error) between the first amount of charge with respect to the true value of the current integration, and the true value of the current integration. In addition, a graph represented by "Error after Correction", illustrates a ratio of the amount of charge (the error) after the correction with respect to the true value of the current integration. As illustrated in FIG. 23, it is known that the amount of charge of the secondary battery unit 50 is corrected such that the error decreases, compared to the error before correction, at the timing when the predetermined time elapse trigger is generated.

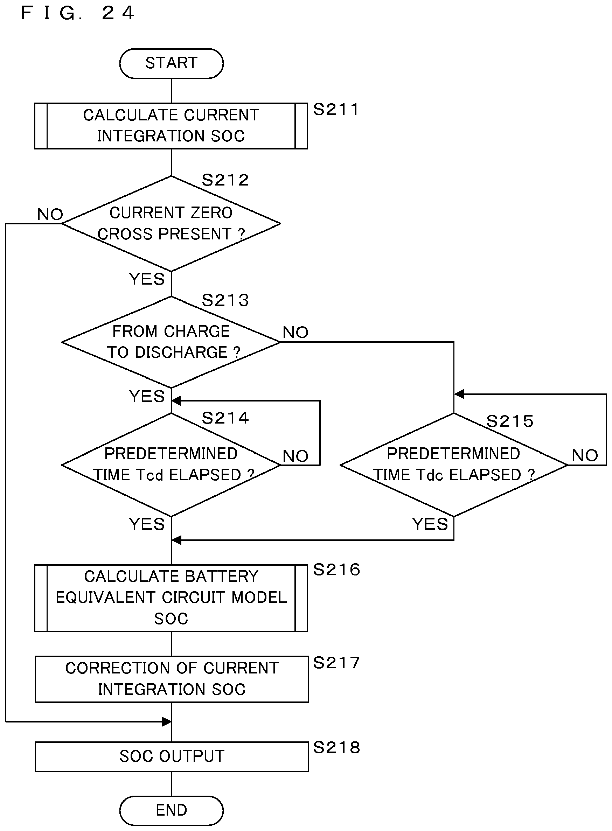

Next, the operation of the battery monitoring device 100 of the second embodiment will be described. FIG. 24 is a flowchart illustrating a first example of a processing procedure of amount of charge calculation according to the battery monitoring device 100 of the second embodiment. Hereinafter, for the sake of simplicity, the main part of the processing will be described as the control portion 10. The control portion 10 calculates the current integration SOC (the first amount of charge) (S211). A calculation frequency of the current integration SOC can be synchronized with the sampling cycle of the current detection of the secondary battery unit 50, and for example, can be set to 10 ms. The details of calculation processing of the current integration SOC will be described below.

The control portion 10 determines the presence or absence of the current zero cross (S212), and in a case where there is current zero cross (YES in S212), determines whether or not there is switching from charge to discharge (S213). In a case where there is switching from charge to discharge (YES in S213), the control portion 10 determines whether or not a predetermined time Tcd has elapsed from a time point when the current zero cross occurs (S214). The predetermined time Tcd, for example, can be set to approximately 0.1 seconds to 2 seconds.

In a case where the predetermined time Tcd has not elapsed (NO in S214), the control portion 10 continuously performs the processing of Step S214. In a case where there is no switching from charge to discharge (NO in S213), that is, in a case where there is switching from discharge to charge, the control portion 10 determines whether or not a predetermined time Tdc has elapsed from the time point when the current zero cross occurs (S215). The predetermined time Tdc, for example, can be set to approximately 0.1 seconds to 2 seconds. In a case where the predetermined time Tdc has not elapsed (NO in S215), the control portion 10 continuously performs the processing of Step S215.

In a case where the predetermined time Tcd has elapsed (YES in S214), or the predetermined time Tdc has elapsed (YES in S215), the control portion 10 calculates the battery equivalent circuit model SOC (the second amount of charge) (S216). The details of calculation processing of the battery equivalent circuit model SOC will be described below.

The control portion 10 performs the correction of the current integration SOC (S217). The correction of the current integration SOC is processing of substituting the most recently calculated current integration SOC with the battery equivalent circuit model SOC, at a time point when the predetermined time Tcd or Tdc has elapsed.

The control portion 10 outputs the substituted battery equivalent circuit model SOC, as the amount of charge SOC of the secondary battery unit 50 (S218), and ends the processing. In a case where there is no current zero cross (NO in S212), the control portion 10 outputs the calculated current integration SOC, as the amount of charge SOC of the secondary battery unit 50 (S218), and ends the processing. Furthermore, in a case where the secondary battery unit 50 is continuously charged or discharged, the processing illustrated in FIG. 24 can be repeatedly performed.

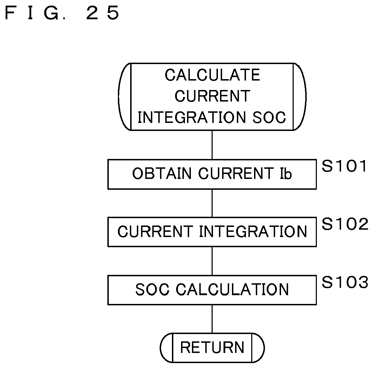

FIG. 25 is a flowchart illustrating an example of a processing procedure of current integration SOC calculation according to the battery monitoring device 100 of the second embodiment. The control portion 10 obtains the current Ib of the secondary battery unit 50 at a predetermined sampling cycle (for example, 10 ms) (S101), and integrates the obtained current value (S102). The control portion 10 divides the integrated current value by the full-charge capacity, calculates the current integration SOC (S103), and ends the processing. Furthermore, in an initial value of SOC, for example, a voltage obtained when an ignition is turned off, or immediately after the ignition is turned on, that is, when the current of the secondary battery unit 50 does not flow, may be set to OCV, and SOC obtained from OCV may be set to the initial value.

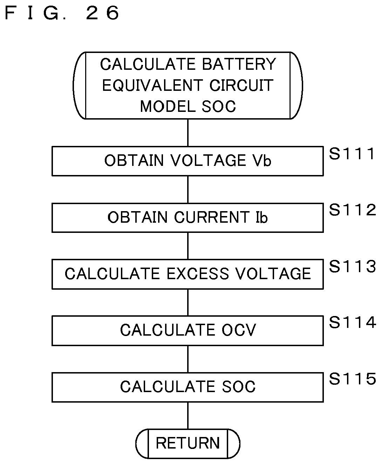

FIG. 26 is a flowchart illustrating an example of a processing procedure of battery equivalent circuit model SOC calculation according to the battery monitoring device 100 of the second embodiment. The control portion 10 obtains the voltage Vb of the secondary battery unit 50 (S111), and obtains the current Ib (S112). A timing for obtaining the voltage Vb and the current Ib may be every predetermined sampling cycle (for example, 10 ms), or may be a timing after values sampled a plurality of times are averaged.

The control portion 10 calculates the excess voltage, on the basis of the obtained current Ib and the battery equivalent circuit model (S113), and calculates the open voltage OCV, on the basis of the obtained voltage Vb and the calculated excess voltage (S114). The control portion 10 converts the calculated open voltage OCV, calculates the battery equivalent circuit model SOC (S115), and ends the processing.

In the example described above, in a case where there is switching between charge and discharge, the current integration SOC is corrected, but is not limited thereto. For example, as a second example, in a case where there is switching between charge and discharge, it is possible to determine whether or not to correct the current integration SOC, according to a difference between the current integration SOC and the battery equivalent circuit model SOC. Hereinafter, the details will be described.

The difference calculation portion 23 calculates a difference between the first amount of charge (the current integration SOC) calculated by the first amount of charge calculation portion 13 and the second amount of charge (the battery equivalent circuit model SOC) calculated by the second amount of charge calculation portion 14. In a case where the first amount of charge is set to SOC1, and the second amount of charge is set to SOC2, the difference ΔSOC can be represented by an expression of ΔSOC = SOC2 - SOC1.

In a case where the switching determination portion 17 determines that there is switching between charge and discharge, the control portion 10 sets the first amount of charge to the amount of charge of the secondary battery unit 50 when the difference calculated by the difference calculation portion 23 is greater than or equal to a predetermined value. In addition, in a case where the switching determination portion 17 determines that there is switching between charge and discharge, the control portion 10 sets the second amount of charge to the amount of charge of the secondary battery unit 50 when the difference calculated by the difference calculation portion 23 is greater than or equal to the predetermined value. The predetermined value can be set to approximately 5% to 10% of SOC of a determination time point, but is not limited thereto.

In a case where there is switching between charge and discharge of the secondary battery unit 50, it is considered that an error of the current integration does not exceed an allowable range when a difference in the amount of charge is greater than or equal to a predetermined value, and thus, the first amount of charge based on the current integration, is set to the amount of charge. On the other hand, in a case where there is switching between charge and discharge of the secondary battery unit 50, it is considered that the error of the current integration exceeds the allowable range when the difference in the amount of charge is greater than or equal to the predetermined value, and thus, the second amount of charge based on the equivalent circuit model which is not affected by the current integration, is set to the amount of charge. Accordingly, even in a case where the charge and discharge current flows through the secondary battery unit 50, it is possible to accurately calculate the amount of charge of the secondary battery unit 50.

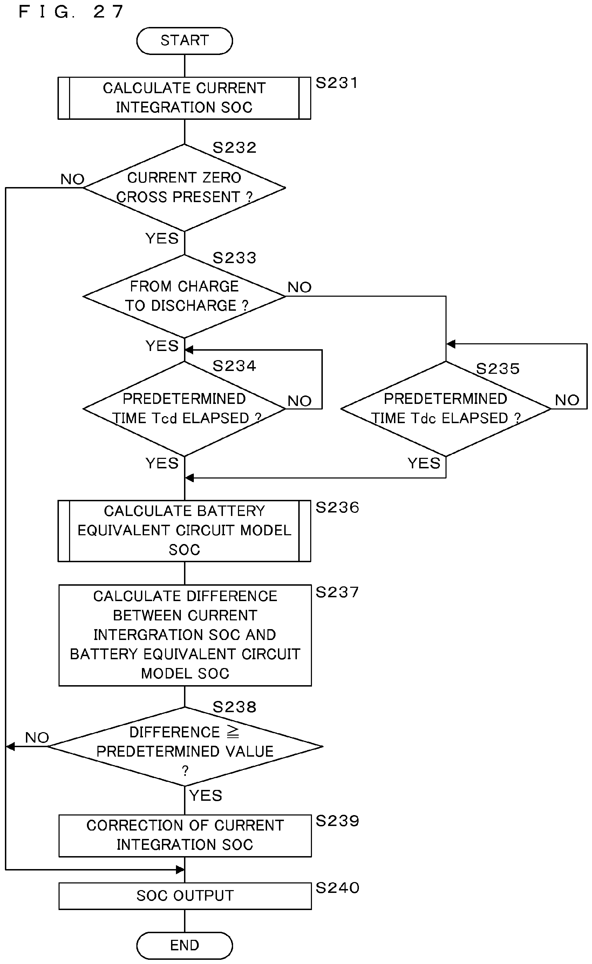

FIG. 27 is a flowchart illustrating a second example of the processing procedure of the amount of charge calculation according to the battery monitoring device 100 of the second embodiment. The control portion 10 calculates the current integration SOC (the first amount of charge) (S231). The calculation frequency of the current integration SOC can by synchronized with the sampling cycle of the current detection of the secondary battery unit 50, and for example, can be set to 10 ms. The calculation processing of the current integration SOC is identical to the processing of FIG. 25.

The control portion 10 determines the presence or absence of the current zero cross (S232), and in a case where there is current zero cross (YES in S232), determines whether or not there is switching from charge to discharge (S233). In a case where there is switching from charge to discharge (YES in S233), the control portion 10 determines whether or not the predetermined time Tcd has elapsed from the time point when the current zero cross occurs (S234). The predetermined time Tcd, for example, can be set to approximately 0.1 seconds to 2 seconds.

In a case where the predetermined time Tcd has not elapsed (NO in S234), the control portion 10 continuously performs the processing of Step S234. In a case where there is no switching from charge to discharge (NO in S233), that is, in a case where there is switching from discharge to charge, the control portion 10 determines whether or not the predetermined time Tdc has elapsed from the time point when the current zero cross occurs (S235). The predetermined time Tdc, for example, can be set to approximately 0.1 seconds to 2 seconds. In a case where the predetermined time Tdc has not elapsed (NO in S235), the control portion 10 continuously performs the processing of Step S235.

In a case where the predetermined time Tcd has elapsed (YES in S234), or in a case where the predetermined time Tdc has elapsed (YES in S235), the control portion 10 calculates the battery equivalent circuit model SOC (S36). The calculation processing of the battery equivalent circuit model SOC is identical to the processing of FIG. 26.

The control portion 10 calculates a difference between the current integration SOC and the battery equivalent circuit model SOC (S237). Furthermore, the current integration SOC to be used in Step S237, can be set to the current integration SOC which is calculated at a timing closest to a timing for calculating the battery equivalent circuit model SOC, and for example, can be the most recently calculated current integration SOC, at the time point when the predetermined time Tcd or Tdc has elapsed.

In a case where the control portion 10 determines whether or not the calculated difference is greater than or equal to a predetermined value (S238), and in a case where the difference is greater than or equal to the predetermined value (YES in S238), performs the correction of the current integration SOC (S239). The correction of the current integration SOC is processing of substituting the most recently calculated current integration SOC with the battery equivalent circuit model SOC, at the time point when the predetermined time Tcd or Tdc has elapsed.

The control portion 10 outputs the substituted battery equivalent circuit model SOC with the amount of charge SOC of the secondary battery unit 50 (S240), and ends the processing. In a case where there is no current zero cross (NO in S232), or in a case where the difference is not greater than or equal to the predetermined value (NO in S238), the control portion 10 outputs the calculated current integration SOC with the amount of charge SOC of the secondary battery unit 50 (S240), and ends the processing. Furthermore, in a case where the secondary battery unit 50 is continuously charged or discharged, the processing illustrated in FIG. 27 can be repeatedly performed.

The amount of charge calculation device of this embodiment (the battery monitoring device 100) can be realized by using a general-purpose computer including a CPU (a processor), a RAM (a memory), and the like. That is, a computer program for defining the procedures of each of the processings as illustrated in FIG. 24 to FIG. 27, is loaded in the RAM (the memory) of the computer, and the computer program is executed by the CPU (the processor), and thus, the amount of charge calculation device (the battery monitoring device 100) can be realized on the computer.

As described above, according to the battery monitoring device 100 of this embodiment (the amount of charge calculation device), it is not necessary that the secondary battery unit is in an unloaded state, and even in a case where a current flow through the secondary battery unit, the amount of charge based on the current integration, can be corrected by substituting the amount of charge based on the current integration with the amount of charge based on the battery equivalent circuit model, and thus, it is possible to accurately calculate the amount of charge of the secondary battery unit.

In addition, as a comparative example, there is a method in which the open voltage is calculated from the terminal voltage of the secondary battery and a characteristic line obtained by linear regression calculation from the current, and in a case where a difference between the amount of charge to be calculated on the basis of the open voltage, and the amount of charge based on the current integration, is greater than or equal to a predetermined value, the amount of charge based on the current integration is substituted with the amount of charge to be calculated on the basis of the open voltage. However, in such a method, in order to obtain the characteristic line having a high accuracy by the linear regression calculation, it is necessary to sample the voltage and the current many times, and it is necessary that there is a certain degree of variation in the sampled voltage and current, and for example, in a case where there are many chances that the vehicle is driven at a constant speed, it is not possible to accurately obtain the open voltage, and it is not possible to correct the amount of charge. However, according to the battery monitoring device 100 of this embodiment, it is not necessary to perform the linear regression calculation, and it is possible to correct the amount of charge of the secondary battery unit at the switching timing of charge and discharge of the secondary battery unit (accurately, a time point when a predetermined time has elapsed after the switching between charge and discharge).

In addition, as a comparative example, there is a method in which the open voltage is calculated from the terminal voltage, the current, and the internal resistance of the secondary battery, and in a case where a difference between the amount of charge to be calculated on the basis of the open voltage, and the amount of charge based on the current integration, is greater than or equal to a predetermined value, the amount of charge based on the current integration is substituted with the amount of charge to be calculated on the basis of the open voltage. However, in such a method, in the case of calculating the open voltage, an influence of polarization of the secondary battery is not considered, and thus, it is not possible to accurately obtain the open voltage, and it is not possible to correct the amount of charge. However, according to the battery monitoring device 100 of this embodiment, the influence of the polarization is included in the battery equivalent circuit model, and thus, an error due to the polarization does not occur by using the battery equivalent circuit model.

### (Third Embodiment)

Next, a third embodiment will be described. Furthermore, the secondary battery unit 50 is identical to the first embodiment.

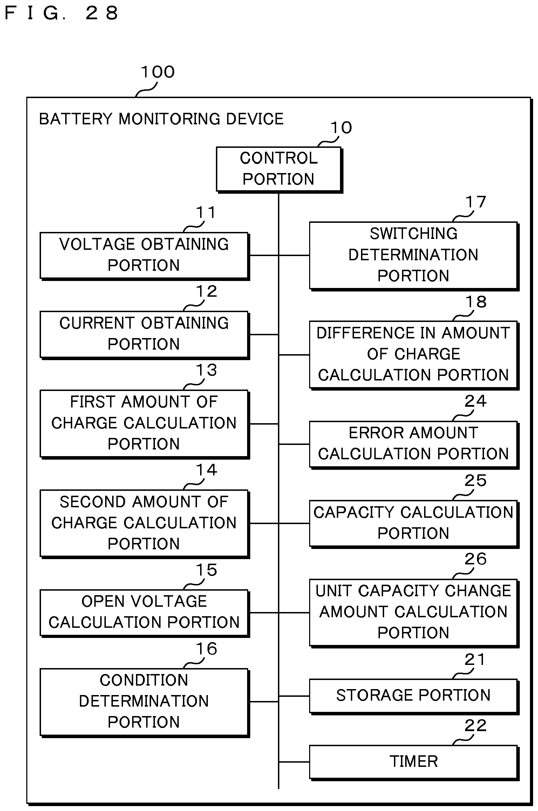

FIG. 28 is a block diagram illustrating an example of the configuration of the battery monitoring device 100 of the third embodiment. The battery monitoring device 100 includes the control portion 10 controlling the entire device, the voltage obtaining portion 11, the current obtaining portion 12, the first amount of charge calculation portion 13, the second amount of charge calculation portion 14, the open voltage calculation portion 15, the condition determination portion 16, the switching determination portion 17, the difference in amount of charge calculation portion 18, an error amount calculation portion 24, a capacity calculation portion 25, a unit capacity change amount calculation portion 26, the storage portion 21, the timer 22 for clocking, and the like.

The voltage obtaining portion 11 obtains the voltage of the secondary battery unit 50 (for example, the voltage of the secondary battery unit 50 on both ends). In addition, the current obtaining portion 12 obtains the current of the secondary battery unit 50 (a charge current and a discharge current). Furthermore, a sampling cycle for obtaining the voltage and the current, can be controlled by the control portion 10. The sampling cycle, for example, can be set to 10 ms, but is not limited thereto.

The first amount of charge calculation portion 13 has a function as the first calculation portion, and calculates a first amount of charge of the secondary battery unit 50 by integrating the current obtained by the current obtaining portion 12. The first amount of charge is an amount of charge based on a current integration, and is also referred to as the current integration SOC. Furthermore, in this embodiment, the amount of charge is also referred to as a state of charge (SOC) or a charging rate, and indicates the ratio of charged capacity to full-charge capacity.

The current integration is obtained by integrating the current over time, and for example, in a case where a sampling interval for obtaining the current is set to Δt, and a current value obtained at each sampling is set to Ibi (i = 1, 2, ...), the current integration can be calculated on the basis of ∑Ibi × Δt (i = 1, 2, ...). In a case where the most recently obtained amount of charge is set to SOCin, and the first amount of charge is set to SOC1, the first amount of charge can be calculated by an expression of SOC1 = SOCin ± {∑Ibi × Δt (i = 1, 2, ...)/Full-Charge Capacity FCC}. Furthermore, in the expression described above, + is used at the time of charge, and - is used at the time of discharge, as the symbol of ±.

The second amount of charge calculation portion 14 has a function as the second calculation portion, and calculates a second amount of charge of the secondary battery unit 50, on the basis of the voltage obtained by the voltage obtaining portion 11, the current obtained by the current obtaining portion 12, and an equivalent circuit model of the secondary battery unit 50. The second amount of charge is an amount of charge based on the equivalent circuit model of the secondary battery unit 50, and is also referred to as a battery equivalent circuit model SOC. The current integration is not adopted in the second amount of charge, and thus, the second amount of charge is not affected by an error of the current value, which is accumulated by gradually increasing in a process of integrating the current (for example, an error of the current sensor 53). Furthermore, the voltage and the current are a value at the time of charging or discharging the secondary battery unit 50, and the secondary battery unit 50 is not in an unloaded state.

The difference in amount of charge calculation portion 18 calculates a difference in the amount of charge of the first amount of charge (the current integration SOC) calculated by the first amount of charge calculation portion 13 and the second amount of charge (the battery equivalent circuit model SOC) calculated by the second amount of charge calculation portion 14. In a case where the first amount of charge is set to SOC1, and the second amount of charge is set to SOC2, the difference ΔSOC in the amount of charge, for example, can be calculated by an expression of ΔSOC = SOC2 - SOC1.

The condition determination portion 16 determines whether or not a predetermined condition is satisfied, on the basis of the difference in amount of charge calculated by the difference in amount of charge calculation portion 18. The predetermined condition, for example, can be a condition indicating whether or not an error of the current integration exceeds an allowable range. That is, in a case where the difference in the amount of charge, calculated by the difference in amount of charge calculation portion 18, is large, it is considered that the error of the current integration exceeds the allowable range, and thus, it is possible to determine that the predetermined condition is satisfied. On the contrary, in a case where the difference in the amount of charge, calculated by the difference in amount of charge calculation portion 18, is small, it is possible to determine that the predetermined condition is not satisfied.

The control portion 10 has a function as the correction portion, and in a case where the condition determination portion 16 determines that the predetermined condition is satisfied, corrects the first amount of charge based on the second amount of charge. Correcting the first amount of charge on the basis of the second amount of charge, for example, indicates that the first amount of charge is substituted with the second amount of charge, and the second amount of charge can be set to the amount of charge of the secondary battery unit 50, instead of the first amount of charge.

More specifically, in a case where the condition determination portion 16 determines that the predetermined condition is not satisfied (in a case where it is considered that the error of the current integration does not exceed the allowable range), the control portion 10 sets the first amount of charge to the amount of charge of the secondary battery unit 50. In addition, in a case where the condition determination portion 16 determines that the predetermined condition is satisfied (in a case where it is considered that the error of the current integration exceeds the allowable range), the control portion 10 sets the second amount of charge to the amount of charge of the secondary battery unit 50, instead of the first amount of charge (the first amount of charge is substituted with the second amount of charge). Furthermore, correcting the first amount of charge with the second amount of charge, is also referred to as current integration SOC correction.

According to the configuration described above, in a case where the error of the current integration is in the allowable range, the first amount of charge based on the current integration, can be set to the amount of charge, and in a case where the error of the current integration exceeds the allowable range, the second amount of charge based on the equivalent circuit model which is not affected by the current integration, can be set to the amount of charge, and thus, even in a case where a charge and discharge current flows through the secondary battery unit 50, it is possible to accurately calculate the amount of charge of the secondary battery unit 50.

The switching determination portion 17 determines the presence or absence of switching between charge and discharge of the secondary battery unit 50, on the basis of the current obtained by the current obtaining portion 12. For example, in a case where one of charge and discharge is defined as positive, and the current is changed from positive to negative, or the current is changed from negative to positive, it is possible to determine that there is switching between charge and discharge.

The condition determination portion 16 determines whether or not the predetermined condition is satisfied, according to the presence or absence of the switching, determined by the switching determination portion 17. For example, in a case where the switching determination portion 17 determines that there is switching between charge and discharge, it is possible to determine that the predetermined condition is satisfied.

In a case where switching from charge to discharge, or switching from discharge to charge, is performed, it is considered that internal impedance of the secondary battery unit 50 is reset once, and the accuracy of the equivalent circuit model increases. Therefore, in a case where there is switching between charge and discharge of the secondary battery unit 50, the second amount of charge based on the equivalent circuit model having an accuracy higher than the accuracy of the first amount of charge based on the current integration, can be used, and thus, it is possible to accurately calculate the amount of charge of the secondary battery unit 50.

Furthermore, in this embodiment, even in a case where the switching determination portion 17 determines that there is no switching between charge and discharge, it is considered that the error of the current integration exceeds the allowable range in a case where the difference in the amount of charge, calculated by the difference in amount of charge calculation portion 18, is large, and it is determined that the predetermined condition is satisfied, and thus, the first amount of charge is corrected with the second amount of charge, it is possible to increase the number of times of the current integration SOC correction, compared to a case where the current integration SOC correction is performed only at the time of performing switching between charge and discharge, and even in a case where the charge and discharge current flows through the secondary battery unit 50, it is possible to accurately calculate the amount of charge of the secondary battery unit 50.

In addition, in a case where the switching determination portion 17 determines that there is switching between charge and discharge, the second amount of charge calculation portion 14 is capable of calculating the second amount of charge of the secondary battery unit 50, on the basis of the voltage obtained by the voltage obtaining portion 11 and the current obtained by the current obtaining portion 12, after a predetermined time has elapsed from a switching time point of charge and discharge. In the predetermined time, different values or the same value may be used between a case where switching is performed from charge to discharge and a case where switching is performed from discharge to charge. The predetermined time, for example, can be set to approximately 0.1 seconds to 2 seconds, but is not limited thereto.

The impedance of the secondary battery unit 50 can be stabilized according to an energization time (a charge time or a discharge time) after the switching between charge and discharge, and an influence of an excess voltage can be reduced, and thus, it is possible to increase the accuracy of the second amount of charge based on the equivalent circuit model. Furthermore, the excess voltage indicates a difference between the voltage (a terminal voltage) and the open voltage OCV (also referred to as an open circuit voltage) of the secondary battery unit 50.

Next, a calculation method of the second amount of charge will be described in more detail.

The open voltage calculation portion 15 calculates the open voltage OCV of the secondary battery unit 50, on the basis of a voltage Vb obtained by the voltage obtaining portion 11, a current Ib obtained by the current obtaining portion 12, and the equivalent circuit model of the secondary battery unit 50.

As described in FIG. 4 and FIG. 5 of the first embodiment, in the excess voltage to be generated due to the current Ib flowing through the equivalent circuit model, the voltage Vb to be obtaining (detected), and the open voltage OCV, a relationship of (OCV = Vb - Excess Voltage) is established. Here, in a case where the current Ib is positive at the time of charge, is negative at the time of discharge, the excess voltage is also positive at the time of charge, and is negative at the time of discharge.

The second amount of charge calculation portion 14 calculates the second amount of charge of the secondary battery unit 50, on the basis of the open voltage OCV calculated by the open voltage calculation portion 15, and a corresponding relationship between the open voltage OCV and the amount of charge SOC of the secondary battery unit 50.

As with the first embodiment, it is not necessary to detect the voltage of the secondary battery unit 50 at no load, and even in a case where the charge and discharge current flows through the secondary battery unit 50, it is possible to calculate the second amount of charge for correcting the first amount of charge based on the current integration.

Next, processing of determining whether or not the predetermined condition is satisfied, on the basis of the difference in the amount of charge, calculated by the difference in amount of charge calculation portion 18, will be described. Specifically, a change amount of the difference in the amount of charge, indicating how much the difference in the amount of charge at the time of performing the current integration SOC correction, is changed from the difference in the amount of charge at the time of performing the previous current integration SOC correction, is used. First, the case of using a unit capacity change amount, will be described.

The control portion 10 performs the current integration SOC correction at each of a first correction time point, and a second correction time point before the first correction time point. The difference in amount of charge calculation portion 18 has a function as the change amount calculation portion, and calculates the change amount of the difference in the amount of charge, on the basis of the difference in the amount of charge, calculated at each of the first correction time point and the second correction time point, corrected by the control portion 10.

In a case where the difference in the amount of charge at a first correction time point t, is set to ΔSOC(t), and the difference in the amount of charge at a second correction time point (t-1), is set to ΔSOC(t-1), the change amount can be calculated by an expression of ΔSOC(t) - ΔSOC(t-1). Here, the difference ΔSOC in the amount of charge can be calculated by ΔSOC = SOC2 - SOC1.

The capacity calculation portion 25 calculates charged or discharged capacity between the first correction time point and the second correction time point. The capacity, for example, an integration of a charge current and a charge time between the first correction time point and the second correction time point, or an integration of a discharge current and a discharge time between the first correction time point and the second correction time point, is represented in Ah unit.

The unit capacity change amount calculation portion 26 calculates a unit capacity change amount per unit capacity, on the basis of the change amount calculated by the difference in amount of charge calculation portion 18 (the change amount calculation portion), and the capacity calculated by the capacity calculation portion 25. In a case where the change amount between the first correction time point (t) and the second correction time point (t-1), is set to ΔSOC(t) - ΔSOC(t-1), the capacity between the first correction time point and the second correction time point, is set to C, the unit capacity change amount can be represented by an expression of {ΔSOC(t) - ΔSOC(t-1)}/C.

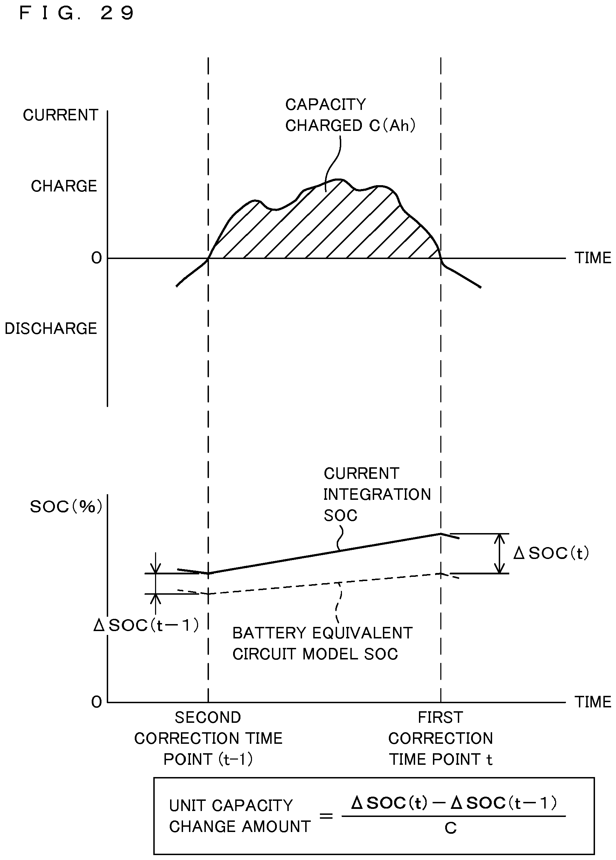

FIG. 29 is an explanatory diagram illustrating an example of a calculation method of the unit capacity change amount according to the battery monitoring device 100 of the third embodiment. The upper diagram illustrates a current flowing through the secondary battery unit 50, and the lower diagram illustrates a change transition of the difference ΔSOC in the amount of charge. In the lower diagram, a graph illustrated by a solid line, represents the current integration SOC (the first amount of charge), and a graph illustrated by a broken line, represents the battery equivalent circuit model SOC (the second amount of charge). In the example of FIG. 29, switching from discharge to charge is performed at the second correction time point (t-1), and the current integration SOC correction is performed at the second correction time point (t-1). A charge state is continued after the second correction time point (t-1), switching from charge to discharge is performed at the first correction time point t, and the current integration SOC correction is performed at the first correction time point t.

A region illustrated by an oblique line in the upper diagram, represents capacity C charged between the first correction time point and the second correction time point. Furthermore, the unit of the capacity C is Ah. In a case where the difference in the amount of charge at the first correction time point t, is set to ΔSOC(t), the difference in the amount of charge at the second correction time point (t-1), is set to ΔSOC(t-1), the change amount of the difference in the amount of charge between the first correction time point and the second correction time point, can be calculated by an expression of ΔSOC(t) - ΔSOC(t-1). Then, the unit capacity change amount can be represented by an expression of {ΔSOC(t) - ΔSOC(t-1)}/C.

The error amount calculation portion 24 calculates an error amount, on the basis of the unit capacity change amount calculated by the unit capacity change amount calculation portion 26, and the charge capacity or the discharge capacity of the secondary battery unit 50 after the first correction time point. In a case where the charge capacity or the discharge capacity of the secondary battery unit 50 after the first correction time point, is set to Cp, the error amount, for example, can be represented by an expression of Cp × {ΔSOC(t) - ΔSOC(t-1)}/C}. That is, the error amount represents an index indicating how much the change amount increases as the charge capacity or the discharge capacity of the secondary battery unit 50 increases.

The condition determination portion 16 determines whether or not the predetermined condition is satisfied, on the basis of whether or not the error amount calculated by the error amount calculation portion 24, is greater than or equal to a predetermined threshold value. For example, in a case where the error amount is greater than or equal to the predetermined threshold value, it is possible to determine that the predetermined condition is satisfied.

According to the configuration described above, it is possible to correct the first amount of charge by substituting the first amount of charge with the second amount of charge, on the basis of the error amount, regardless of the presence or absence of the switching between charge and discharge of the secondary battery unit 50, and thus, it is possible to accurately calculate the amount of charge of the secondary battery unit 50.

In the example described above, the case of using the unit capacity change amount, has been described, but is not limited thereto. Hereinafter, another example will be described.

That is, the error amount calculation portion 24 is capable of calculating the error amount, on the basis of the change amount calculated by the difference in amount of charge calculation portion 18, and a charge continuation time or a discharge continuation time after the first correction time point. For example, in a case where a time difference between the first correction time point t and the second correction time point (t-1) is set to Δt, the change amount per unit time, can be represented by an expression of {ΔSOC(t) - ΔSOC(t-1)}/Δt. In a case where the charge continuation time or the discharge continuation time after the first correction time point (t), is represented by Tp, the error amount, for example, can be represented by an expression of Tp × {ΔSOC(t) - ΔSOC(t-1)}/Δt. That is, the error amount represents an index indicating how much the change amount increases as the charge continuation time or the discharge continuation time has elapsed.

Even in such a case, the condition determination portion 16 determines whether or not the predetermined condition is satisfied, on the basis of whether or not the error amount calculated by the error amount calculation portion 24, is greater than or equal to the predetermined threshold value. For example, in a case where the error amount is greater than or equal to the predetermined threshold value, it is possible to determine that the predetermined condition is satisfied.

According to the configuration described above, it is possible to correct the first amount of charge correction by substituting the first amount of charge with the second amount of charge, on the basis of the error amount, regardless of the presence or absence of the switching between charge and discharge of the secondary battery unit 50, and thus, it is possible to accurately calculate the amount of charge of the secondary battery unit 50.

In addition, it is also possible to set when determination processing of the condition determination portion 16 is performed. For example, in a case where the charge continuation time or the discharge continuation time after the correction time point when the control portion 10 performs the current integration SOC correction, is longer than or equal to a predetermined time, the condition determination portion 16 is capable of determining whether or not the predetermined condition is satisfied. The predetermined time, for example, can be set to 1 minute, 2 minutes, 5 minute, and the like, but is not limited thereto.

In a case where the charge continuation time or the discharge continuation time becomes longer, after the switching between charge and discharge of the secondary battery unit 50, it is considered that the error of the current integration increases. Therefore, in a case where the charge continuation time or the discharge continuation time is longer than or equal to the predetermined time, it is determined that whether or not predetermined condition is satisfied, in order to determine whether or not the error of the current integration exceeds the allowable range. Accordingly, it is possible to prevent the error of the current integration from exceeding the allowable range.

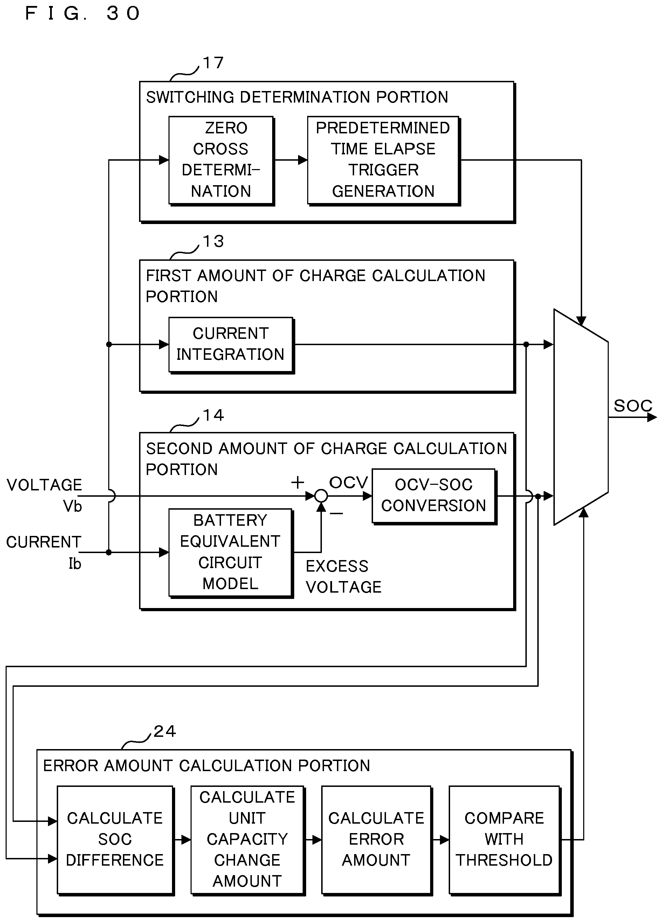

FIG. 30 is a schematic view illustrating main parts of calculation processing of the amount of charge of the secondary battery unit 50 according to the battery monitoring device 100 of the third embodiment. In a case where the voltage Vb and the current Ib of the secondary battery unit 50, are obtained at a predetermined sampling cycle (for example, 10 ms), the first amount of charge calculation portion 13 performs current integration processing, and calculates the first amount of charge at the sampling cycle. The control portion 10 outputs the calculated first charge capacity, as the amount of charge SOC of the secondary battery unit 50.

The second amount of charge calculation portion 14 calculates the excess voltage of the secondary battery unit 50, on the basis of the current Ib of the secondary battery unit 50, and the battery equivalent circuit model, subtracts the calculated excess voltage from the voltage Vb of the secondary battery unit 50, and calculates the open voltage OCV. The second amount of charge calculation portion 14 converts the calculated open voltage OCV, on the basis of the OCV-SOC characteristics as exemplified in FIG. 6, and thus, calculates the second amount of charge. A calculation frequency of the second amount of charge may be every sampling cycle described above (for example, 10 ms), or may be every time when a trigger described below is generated.

The switching determination portion 17 performs zero cross determination processing (determination processing of the presence or absence of current zero cross, that is, determination processing of the presence or absence of the switching between charge and discharge), on the basis of the current Ib of the secondary battery unit 50, and performs predetermined time elapse trigger generation processing of generating the trigger (also referred to as a predetermined time elapse trigger) at a time point when a predetermined time (for example, approximately 0.1 seconds to 2 seconds) has elapsed from a time point when there is current zero cross (the switching time point of charge and discharge).

The error amount calculation portion 24 calculates the difference in the amount of charge (an SOC difference) between the first amount of charge calculated by the first amount of charge calculation portion 13 and the second amount of charge calculated by the second amount of charge calculation portion 14, at a timing when the current integration SOC correction is performed, calculates the change amount of the difference in the amount of charge by using the difference in the amount of charge, calculated at a timing when the previous current integration SOC correction is performed. The error amount calculation portion 24 calculates the unit capacity change amount, on the basis of the change amount of the difference in the amount of charge, and capacity charged or discharged with respect to the secondary battery unit 50 between the timing when the previous current integration SOC correction is performed and a timing when the present current integration SOC correction is performed, calculates the error amount by using the capacity charged or discharged with respect to the secondary battery unit 50 after the timing when the present current integration SOC correction is performed, and compares the calculated error amount with the predetermined threshold value.

The control portion 10 corrects the first amount of charge by substituting the first amount of charge with the second amount of charge, at a time point when the predetermined time elapse trigger is generated, or a time point when the error amount is greater than or equal to the predetermined threshold value. That is, the control portion 10 performs the current integration SOC correction, at the time point when the predetermined time elapse trigger is generated, or the time point when the error amount is greater than or equal to the predetermined threshold value, and outputs the second amount of charge calculated by the second amount of charge calculation portion 14, as the amount of charge SOC of the secondary battery unit 50.

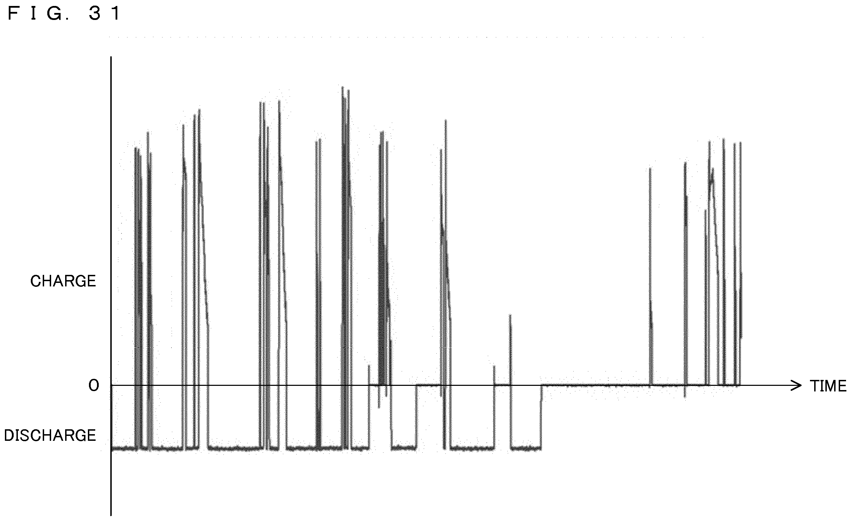

FIG. 31 is an explanatory diagram illustrating an example of a current waveform of the secondary battery unit 50 of the third embodiment. In FIG. 31, a horizontal axis indicates time, and a vertical axis indicates a current. In a case where the current is positive, a charge state is set, and in a case where the current is negative, a discharge state is set. In the example of FIG. 31, a current transition for several hours is illustrated, and it is known that current zero cross occurs, at a timing when switching from charge to discharge, and switching from discharge to charge are performed. Furthermore, the current waveform is an example, and is not limited thereto.

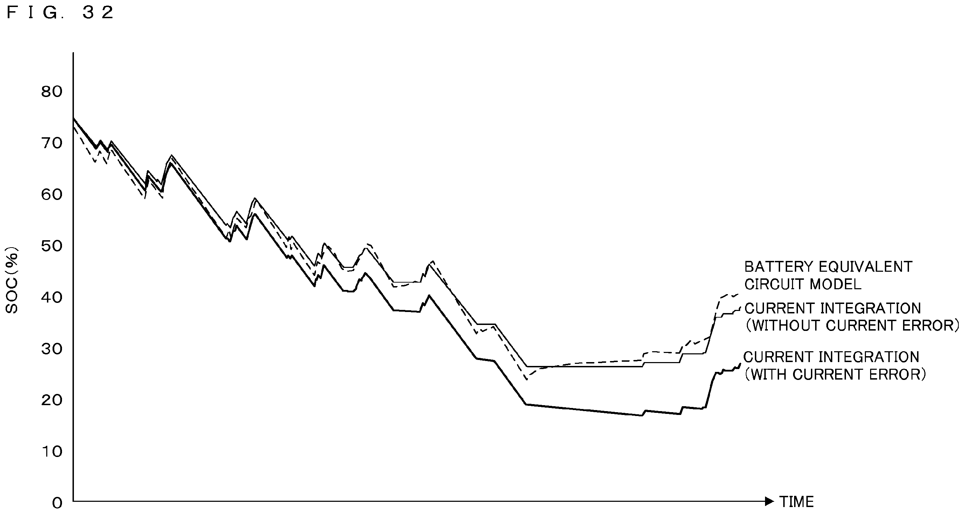

FIG. 32 is an explanatory diagram illustrating an example of each of the amounts of charge to be calculated by the battery monitoring device 100 of the third embodiment. In FIG. 32, a horizontal axis indicates time, and a vertical axis indicates the amount of charge SOC. In FIG. 32, a graph represented by "Current Integration (with Current Error)", illustrates a transition from a time 0 of the first amount of charge calculated on the basis of the current exemplified in FIG. 31. In addition, a graph represented by "Battery Equivalent Circuit Model", illustrates a transition from a time 0 of the second amount of charge calculated on the basis of the current exemplified in FIG. 31. In addition, a graph represented by "Current Integration (without Current Error)", illustrates a transition from a time 0 in a case where the current exemplified in FIG. 31 is integrated in a state without an error, and indicates a true value of the current integration.

As illustrated in FIG. 32, it is known that in the first amount of charge based on the current integration, a deviation from the true value of the current integration increases as time has elapsed, and the error gradually increases. In addition, it is known that a difference between the first amount of charge based on the current integration and the true value of the current integration, is small, while the time elapse from the time 0 is short, and the first amount of charge accurately indicates the amount of charge of the secondary battery unit 50. In addition, it is also known that the second amount of charge tends to be close to the true value of the current integration, at a timing when the switching between charge and discharge occurs.

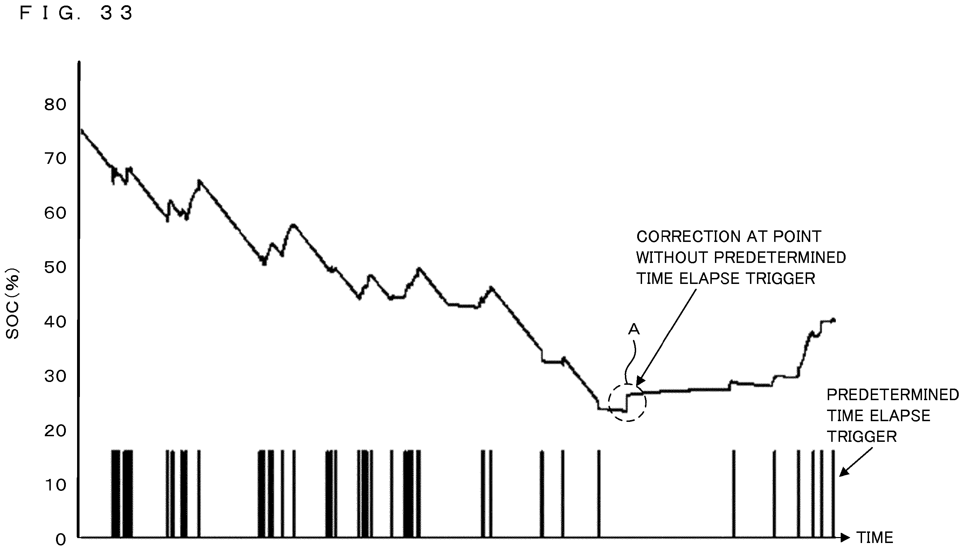

FIG. 33 is an explanatory diagram illustrating an example of the amount of charge of the secondary battery unit 50 according to the battery monitoring device 100 of the third embodiment. In FIG. 33, a horizontal axis indicates time, and a vertical axis indicates the amount of charge SOC. In FIG. 33, the predetermined time elapse trigger is generated four times. In addition, it is known that the amount of charge of the secondary battery unit 50 is corrected at a time point when the discharge state is continued, and the error amount is greater than or equal to the predetermined threshold value, as illustrated by a symbol A in the drawing. Thus, it is possible to increase the number of times of the current integration SOC correction, compared to a case where the current integration SOC correction is performed only at the time of performing switching between charge and discharge, and even in a case where the charge and discharge current flows through the secondary battery unit 50, it is possible to accurately calculate the amount of charge of the secondary battery unit 50. Furthermore, in FIG. 33, it is illustrated that the amount of charge of the secondary battery unit 50 is corrected at the time point when the discharge state is continued, and the error amount is greater than or equal to the predetermined threshold value, and the same applies to a case where the charge state is continued. In addition, in FIG. 33, for the sake of simplicity, the time point when the error amount is greater than or equal to the predetermined threshold value, is exemplified by only the symbol A, but actually, there is also a case where the time point when the error amount is greater than or equal to the predetermined threshold value, appears a plurality of times.

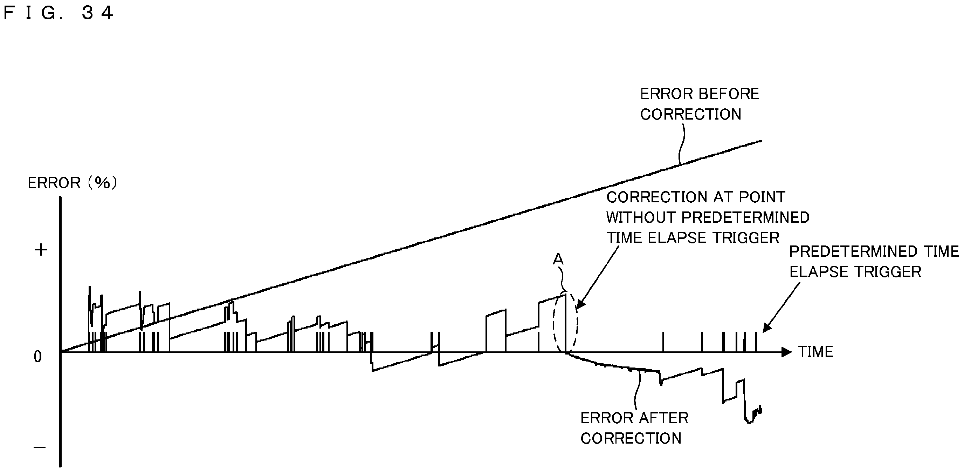

FIG. 34 is an explanatory diagram illustrating an example of an error of the amount of charge of the secondary battery unit 50 according to the battery monitoring device 100 of the third embodiment. In FIG. 34, a horizontal axis indicates time, and a vertical axis indicates an error of the amount of charge SOC. In FIG. 34, the true value of the current integration is represented by the horizontal axis of the error of 0%. A graph represented by "Error before Correction", illustrates a ratio of the difference (the error) between the first amount of charge with respect to the true value of the current integration, and the true value of the current integration. In addition, a graph represented by "Error after Correction", illustrates a ratio of the amount of charge (the error) after the correction with respect to the true value of the current integration. As illustrated in FIG. 34, it is known that the amount of charge of the secondary battery unit 50 is corrected such that the error decreases, not only at the timing when the predetermined time elapse trigger is generated, but also at the time point when the discharge state is continued, and the error amount is greater than or equal to the predetermined threshold value.

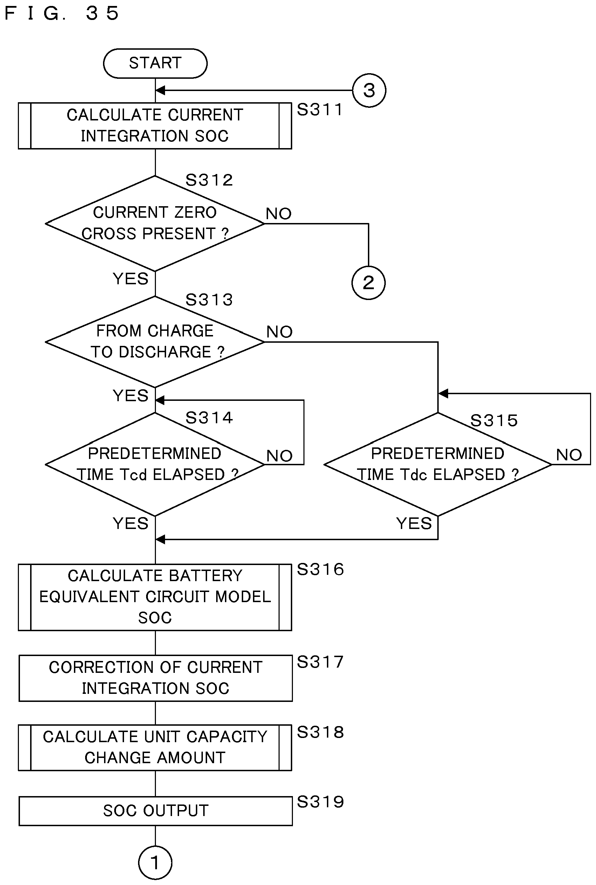

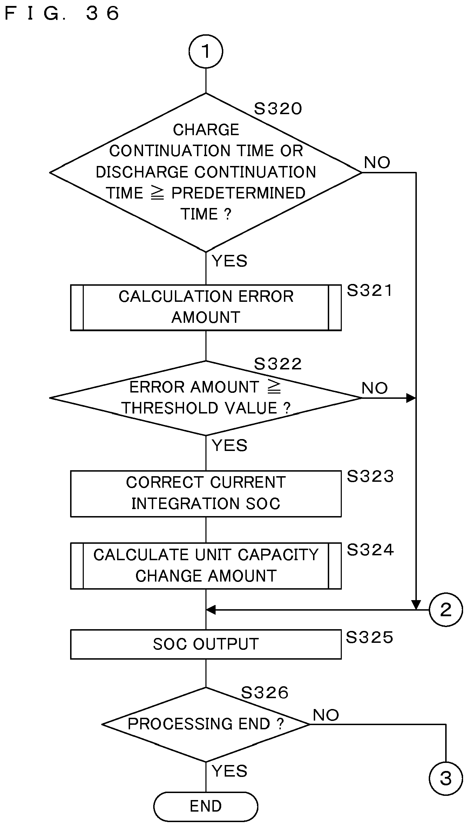

Next, the operation of the battery monitoring device 100 of this embodiment will be described. FIG. 35 and FIG. 36 are flowcharts illustrating a first example of a processing procedure of amount of charge calculation according to the battery monitoring device 100 of the third embodiment. Hereinafter, for the sake of simplicity, the main part of the processing will be described as the control portion 10. The control portion 10 calculates the current integration SOC (the first amount of charge) (S311). A calculation frequency of the current integration SOC can be synchronized with the sampling cycle of the current detection of the secondary battery unit 50, and for example, can be set to 10 ms. The details of calculation processing of the current integration SOC will be described below.

The control portion 10 determines the presence or absence of the current zero cross (S312), and in a case where there is current zero cross (YES in S312), determines whether or not there is switching from charge to discharge (S313). In a case where there is switching from charge to discharge (YES in S313), the control portion 10 determines whether or not a predetermined time Tcd has elapsed from a time point when the current zero cross occurs (S314). The predetermined time Tcd, for example, can be set to approximately 0.1 seconds to 2 seconds.

In a case where the predetermined time Tcd has not elapsed (NO in S314), the control portion 10 continuously performs the processing of Step S314. In a case where the predetermined time Tcd has elapsed (YES in S314), the control portion 10 performs processing of Step S316 described below.

In a case where there is no switching from charge to discharge (NO in S313), that is, in a case where there is switching from discharge to charge, the control portion 10 determines whether or not the predetermined time Tdc has elapsed from the time point when the current zero cross occurs (S315). The predetermined time Tdc, for example, can be set to approximately 0.1 seconds to 2 seconds. In a case where the predetermined time Tdc has not elapsed (NO in S315), the control portion 10 continuously performs the processing of Step S315. In a case where the predetermined time Tdc has elapsed (YES in S315), the control portion 10 performs processing of Step S316 described below.

The control portion 10 calculates the battery equivalent circuit model SOC (the second amount of charge) (S316). The details of calculation processing of the battery equivalent circuit model SOC will be described below. The control portion 10 performs the correction of the current integration SOC (S317). The correction of the current integration SOC is processing of substituting the most recently calculated current integration SOC with the battery equivalent circuit model SOC, at a time point when the predetermined time Tcd or Tdc has elapsed.

The control portion 10 performs unit capacity change amount calculation (S318). Furthermore, the details of unit capacity change amount calculation processing will be described below. The control portion 10 outputs the substituted battery equivalent circuit model SOC, as the amount of charge SOC of the secondary battery unit 50 (S319).

The control portion 10 determines whether or not the charge continuation time or the discharge continuation time is longer than or equal to the predetermined time (S320). The predetermined time, for example, can be set to 1 minute, 2 minutes, 5 minute, and the like, but is not limited thereto. In a case where the charge continuation time or the discharge continuation time is longer than or equal to the predetermined time (YES in S320), the control portion 10 performs error amount calculation (S321). Furthermore, the details of error amount calculation processing will be described below.

The control portion 10 determines whether or not the calculated error amount is greater than or equal to a threshold value (S322), and in a case where the error amount is greater than or equal to the threshold value (YES in S322), performs the correction of the current integration SOC (S323). The correction of the current integration SOC is processing of substituting the most recently calculated current integration SOC with the battery equivalent circuit model SOC, at a time point when the error amount is greater than or equal to the threshold value. Furthermore, the threshold value can be set to a numerical value corresponding to approximately 5% to 10% of SOC of a determination time point, but is not limited thereto.

The control portion 10 performs unit capacity change amount calculation (S324), and outputs the substituted battery equivalent circuit model SOC, as the amount of charge SOC of the secondary battery unit 50 (S325). In a case where there is no current zero cross (NO in S312), in a case where the charge continuation time or the discharge continuation time is longer than or equal to the predetermined time (NO in S320), or in a case where the error amount is not greater than or equal to the threshold value (NO in S322), the control portion 10 outputs the calculated current integration SOC, as the amount of charge SOC of the secondary battery unit 50 (S325).

The control portion 10 determines whether or not the processing is ended (S326), and in a case where the processing is not ended (NO in S326), continuously performs the processing after Step S311, and in a case where the processing is ended (YES in S326), ends the processing. Furthermore, in a case where the secondary battery unit 50 is continuously charged or discharged, the processing illustrated in FIG. 35 and FIG. 36 can be repeatedly performed.

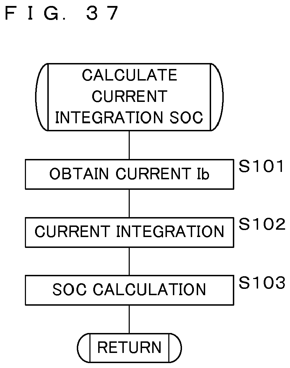

FIG. 37 is a flowchart illustrating an example of a processing procedure of current integration SOC calculation according to the battery monitoring device 100 of the third embodiment. The control portion 10 obtains the current Ib of the secondary battery unit 50 at a predetermined sampling cycle (for example, 10 ms) (S101), and integrates the obtained current value (S102). The control portion 10 divides the integrated current value by the full-charge capacity, calculates the current integration SOC (S103), and ends the processing. Furthermore, in an initial value of SOC, for example, a voltage obtained when an ignition is turned off, or immediately after the ignition is turned on, that is, when the current of the secondary battery unit 50 does not flow, may be set to OCV, and SOC obtained from OCV may be set to the initial value.

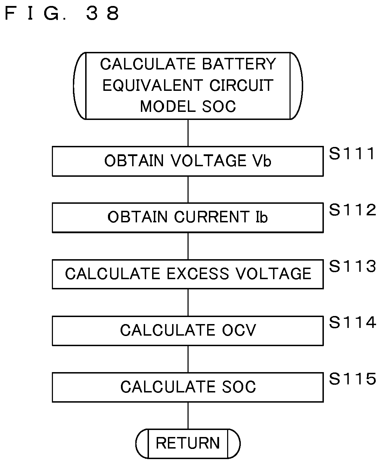

FIG. 38 is a flowchart illustrating an example of a processing procedure of battery equivalent circuit model SOC calculation according to the battery monitoring device 100 of the third embodiment. The control portion 10 obtains the voltage Vb of the secondary battery unit 50 (S111), and obtains the current Ib (S112). A timing for obtaining the voltage Vb and the current Ib may be every predetermined sampling cycle (for example, 10 ms), or may be a timing after values sampled a plurality of times are averaged.

The control portion 10 calculates the excess voltage, on the basis of the obtained current Ib and the battery equivalent circuit model (S113), and calculates the open voltage OCV, on the basis of the obtained voltage Vb and the calculated excess voltage (S114). The control portion 10 converts the calculated open voltage OCV, calculates the battery equivalent circuit model SOC (S115), and ends the processing.

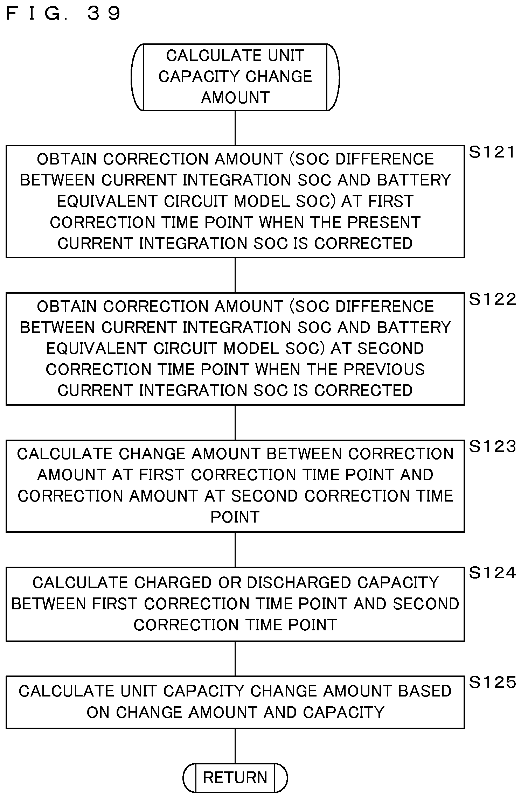

FIG. 39 is a flowchart illustrating an example of a processing procedure of the unit capacity change amount calculation according to the battery monitoring device 100 of the third embodiment. The control portion 10 obtains the correction amount (the SOC difference between the current integration SOC and the battery equivalent circuit model SOC), at the first correction time point when the present current integration SOC is corrected (S121), and obtains the correction amount (the SOC difference between the current integration SOC and the battery equivalent circuit model SOC), at the second correction time point when the previous current integration SOC is corrected (before the first correction time point) (S122).

The control portion 10 calculates the change amount of the difference in the amount of charge between the correction amount (the difference in the amount of charge) at the first correction time point and the correction amount (the difference in the amount of charge) at the second correction time point (S123). In a case where the difference in the amount of charge at the first correction time point t, is set to ΔSOC(t), and the difference in the amount of charge at the second correction time point (t-1), is set to ΔSOC(t-1), the change amount can be calculated by an expression of ΔSOC(t) - ΔSOC(t-1).

The control portion 10 calculates the charged or discharged capacity between the first correction time point and the second correction time point (S124), calculates the unit capacity change amount, on the basis of the change amount of the difference in the amount of charge and the calculated capacity (S125), and ends the processing. Furthermore, in a case where the charged or discharged capacity between the first correction time point and the second correction time point, is set to C, the unit capacity change amount can be calculated by an expression of {ΔSOC(t) - ΔSOC(t-1)}/C.

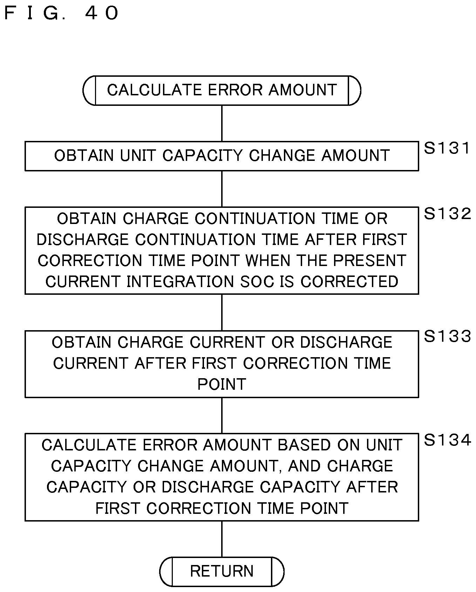

FIG. 40 is a flowchart illustrating an example of a processing procedure of the error amount calculation according to the battery monitoring device 100 of the third embodiment. The control portion 10 obtains the unit capacity change amount calculated in the processing exemplified in FIG. 39 (S131), and obtains the charge continuation time or the discharge continuation time after the first correction time point when the present current integration SOC is corrected (S132).

The control portion 10 obtains the charge current or the discharge current after the first correction time point (S133). In a case where the charge current and the charge continuation time after the first correction time point are integrated, it is possible to obtain the capacity to be charged to the secondary battery unit 50 after the first correction time point. In addition, in a case where the discharge current after the first correction time point and the discharge continuation time are integrated, it is possible to obtain the capacity to be discharged from the secondary battery unit 50 after the first correction time point.

The control portion 10 calculates the error amount, on the basis of the unit capacity change amount, and the capacity to be charged to the secondary battery unit 50 or the capacity to be discharged from the secondary battery unit 50 after the first correction time point (S134), and ends the processing.

In the first example described above, the amount of charge is corrected by substituting the current integration SOC with the battery equivalent circuit model SOC by using the error amount, but is not limited thereto. For example, as a second example, it is also possible to use the SOC difference between the current integration SOC and the battery equivalent circuit model SOC (the difference in the amount of charge). Hereinafter, the second example will be described.

The condition determination portion 16 determines whether or not the predetermined condition is satisfied, on the basis of whether or not the difference in the amount of charge, calculated by the difference in amount of charge calculation portion 18, is greater than or equal to a predetermined value. In a case where the error of the current integration exceeds the allowable range, it is considered that the difference ΔSOC in the amount of charge increases. Therefore, in a case where the difference ΔSOC in the amount of charge is greater than or equal to the predetermined value, it is possible to determine that the predetermined condition is satisfied.

In a case where condition determination portion 16 determines that the predetermined condition is satisfied, the control portion 10 corrects the first amount of charge, on the basis of the second amount of charge. In a case where the first amount of charge is corrected on the basis of the second amount of charge, for example, the first amount of charge is substituted with the second amount of charge, and the second amount of charge can be set to the amount of charge of the secondary battery unit 50, instead of the first amount of charge.

According to the configuration described above, it is possible to correct the first amount of charge by substituting the first amount of charge with the second amount of charge, on the basis of the difference ΔSOC in the amount of charge, regardless of the presence or absence of the switching between charge and discharge of the secondary battery unit 50, and thus, it is possible to accurately calculate the amount of charge of the secondary battery unit 50.

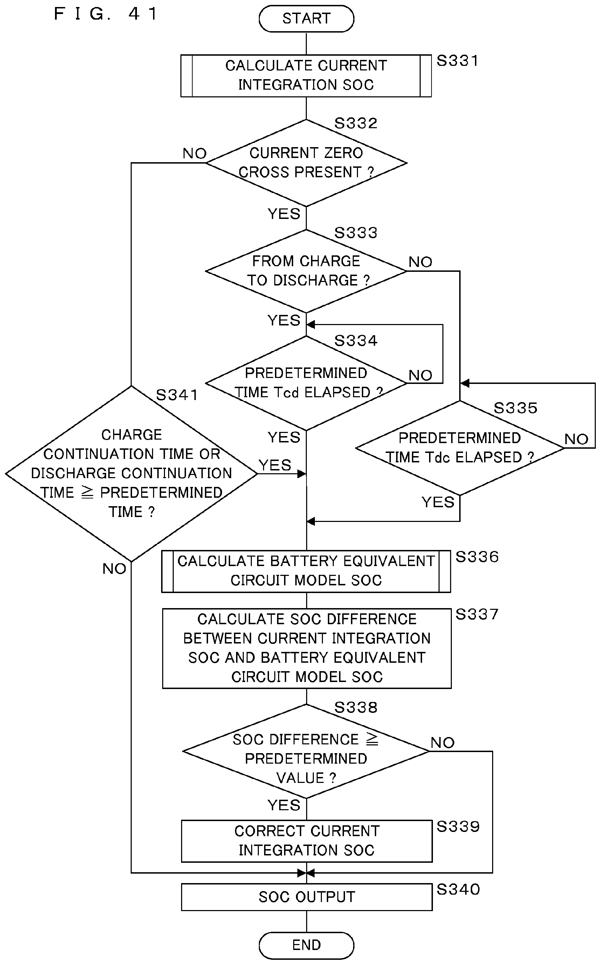

FIG. 41 is a flowchart illustrating a second example of the processing procedure of the amount of charge calculation according to the battery monitoring device 100 of the third embodiment. The control portion 10 calculates the current integration SOC (the first amount of charge) (S331). A calculation frequency of the current integration SOC can be synchronized with the sampling cycle of the current detection of the secondary battery unit 50, and for example, can be set to 10 ms. The calculation processing of the current integration SOC is identical to the processing illustrated in FIG. 37.

The control portion 10 determines the presence or absence of the current zero cross (S332), and in a case where there is current zero cross (YES in S332), determines whether or not there is switching from charge to discharge (S333). In a case where there is switching from charge to discharge (YES in S333), the control portion 10 determines whether or not the predetermined time Tcd has elapsed from the time point when the current zero cross occurs (S334). The predetermined time Tcd, for example, can be set to approximately 0.1 seconds to 2 seconds.

In a case where the predetermined time Tcd has not elapsed (NO in S334), the control portion 10 continuously performs the processing of Step S334. In a case where the predetermined time Tcd has elapsed (YES in S334), the control portion 10 performs processing of Step S336 described below.

In a case where there is no switching from charge to discharge (NO in S333), that is, in a case where there is switching from discharge to charge, the control portion 10 determines whether or not the predetermined time Tdc has elapsed from the time point when the current zero cross occurs (S335). The predetermined time Tdc, for example, can be set to approximately 0.1 seconds to 2 seconds. In a case where the predetermined time Tdc has not elapsed (NO in S335), the control portion 10 continuously performs the processing of Step S335. In a case where the predetermined time Tdc has elapsed (YES in S335), the control portion 10 performs processing of Step S336 described below.

The control portion 10 calculates the battery equivalent circuit model SOC (the second amount of charge) (S336). The calculation processing of the battery equivalent circuit model SOC is identical to the processing illustrated in FIG. 38. The control portion 10 calculates the SOC difference between the current integration SOC and the battery equivalent circuit model SOC (S337), and determines whether or not the SOC difference is greater than or equal to a predetermined value (S338). Furthermore, the predetermined value can be set to approximately 5% to 10% of SOC of a determination time point, but is not limited thereto.

In a case where the SOC difference is greater than or equal to the predetermined value (YES in S338), the control portion 10 performs the correction of the current integration SOC (S339). The correction of the current integration SOC is processing of substituting the most recently calculated current integration SOC with the battery equivalent circuit model SOC, at a time point when the predetermined time Tcd or Tdc has elapsed.

The control portion 10 outputs the substituted battery equivalent circuit model SOC, as the amount of charge SOC of the secondary battery unit 50 (S340), and ends the processing. In a case where there is no current zero cross (NO in S332), the control portion 10 determines whether or not the charge continuation time or the discharge continuation time is longer than or equal to the predetermined time (S341). The predetermined time, for example, can be set to 1 minute, 2 minutes, 5 minute, and the like, but is not limited to such transition values.

In a case where the charge continuation time or the discharge continuation time is longer than or equal to the predetermined time (YES in S341), the control portion 10 performs the processing of Step S336. In a case where the SOC difference is not greater than or equal to the predetermined value (NO in S338), or in a case where the charge continuation time or the discharge continuation time is not longer than or equal to the predetermined time (NO in S341), the control portion 10 outputs the calculated current integration SOC, as the amount of charge SOC of the secondary battery unit 50 (S340), and ends the processing. Furthermore, in a case where the secondary battery unit 50 is continuously charged or discharged, the processing illustrated in FIG. 41 can be repeatedly performed.

The amount of charge calculation device of this embodiment (the battery monitoring device 100), can be realized by using a general-purpose computer including a CPU (a processor), a RAM (a memory), and the like. That is, a computer program for defining the procedures of each of the processings as illustrated in FIG. 35 to FIG. 41, is loaded in the RAM (the memory) of the computer, and the computer program is executed by the CPU (the processor), and thus, the amount of charge calculation device (the battery monitoring device 100) can be realized on the computer.

As described above, according to the battery monitoring device 100 of this embodiment (the amount of charge calculation device), it is not necessary that the secondary battery unit is in an unloaded state, and even in a case where a current flows through the secondary battery unit, it is possible to correct the amount of charge based on the current integration by substituting the amount of charge based on the current integration with the amount of charge based on the battery equivalent circuit model, and it is possible to accurately calculate the amount of charge of the secondary battery unit.

In addition, as a comparative example, there is a method in which the open voltage is calculated from the terminal voltage of the secondary battery and a characteristic line obtained by linear regression calculation from the current, and in a case where a difference between the amount of charge to be calculated on the basis of the open voltage, and the amount of charge based on the current integration, is greater than or equal to a predetermined value, the amount of charge based on the current integration is substituted with the amount of charge to be calculated on the basis of the open voltage. However, in such a method, in order to obtain the characteristic line having a high accuracy by the linear regression calculation, it is necessary to sample the voltage and the current many times, and it is necessary that there is a certain degree of variation in the sampled voltage and current, and for example, in a case where there are many chances that the vehicle is driven at a constant speed, it is not possible to accurately obtain the open voltage, and it is not possible to correct the amount of charge. However, according to the battery monitoring device 100 of this embodiment, it is not necessary to perform the linear regression calculation, and it is possible to correct the amount of charge of the secondary battery unit at the switching timing of charge and discharge of the secondary battery unit (accurately, a time point when a predetermined time has elapsed after the switching between charge and discharge).

In addition, as a comparative example, there is a method in which the open voltage is calculated from the terminal voltage, the current, and the internal resistance of the secondary battery, and in a case where a difference between the amount of charge to be calculated on the basis of the open voltage, and the amount of charge based on the current integration, is greater than or equal to a predetermined value, the amount of charge based on the current integration is substituted with the amount of charge to be calculated on the basis of the open voltage. However, in such a method, in the case of calculating the open voltage, an influence of polarization of the secondary battery is not considered, and thus, it is not possible to accurately obtain the open voltage, and it is not possible to correct the amount of charge. However, according to the battery monitoring device 100 of this embodiment, the influence of the polarization is included in the battery equivalent circuit model, and thus, an error due to the polarization does not occur by using the battery equivalent circuit model.

In the embodiments described above, the secondary battery has been described as a lithium ion battery, but the secondary battery is not limited to the lithium ion battery, and for example, can be provided to a nickel-hydrogen battery, a nickel-cadmium battery, and the like.

It should be considered that the disclosed embodiments are illustrative but not restrictive, in all respects. The scope of the present invention is indicated by the scope of the claims, but not by the above description, and it is intended that the meanings equivalent to the claims and all modifications within the scope are included.

### [Description of Reference Numerals]

- 10: Control portion
- 11: Voltage obtaining portion
- 12: Current obtaining portion
- 13: First amount of charge calculation portion
- 14: Second amount of charge calculation portion
- 15: Open voltage calculation portion
- 16: Condition determination portion
- 17: Switching determination portion
- 18: Difference in amount of charge calculation portion
- 19: Unit time error amount calculation portion
- 20: Unit capacity error amount calculation portion
- 21: Storage portion
- 22: Timer
- 23: Difference calculation portion
- 24: Error amount calculation portion
- 25: Capacity calculation portion
- 26: Unit capacity change amount calculation portion
- 50: Secondary battery unit
- 51: Cell
- 52: Voltage sensor
- 53: Current sensor
- 100: Battery monitoring device

## Claims

1. An amount of charge calculation device calculating an amount of charge of a secondary battery, the device comprising:
a voltage obtaining portion obtaining a voltage of the secondary battery;
a current obtaining portion obtaining a current of the secondary battery;
a first calculation portion calculating a first amount of charge of the secondary battery by integrating the current obtained by the current obtaining portion;
a second calculation portion calculating a second amount of charge of the secondary battery, on the basis of the voltage obtained by the voltage obtaining portion, the current obtained by the current obtaining portion, and an equivalent circuit model of the secondary battery; and
a determination portion determining whether or not a predetermined condition is satisfied,
wherein in a case where the determination portion determines that the predetermined condition is not satisfied, the first amount of charge is set to the amount of charge of the secondary battery, and
in a case where the determination portion determines that the predetermined condition is satisfied, the second amount of charge is set to the amount of charge of the secondary battery.

2. The amount of charge calculation device according to claim 1,
wherein in a case where a time for integrating the current of the secondary battery, is shorter than a predetermined integration time, the determination portion determines that the predetermined condition is not satisfied.

3. The amount of charge calculation device according to claim 2, further comprising:
a switching determination portion determining the presence or absence of switching between charge and discharge of the secondary battery, on the basis of the current obtained by the current obtaining portion,
wherein in a case where the time for integrating the current of the secondary battery, is longer than or equal to the integration time, the determination portion determines whether or not the predetermined condition is satisfied, according to the presence or absence of the switching, determined by the switching determination portion.

4. The amount of charge calculation device according to claim 3,
wherein in a case where the switching determination portion determines that there is switching between charge and discharge, the second calculation portion calculates the second amount of charge of the secondary battery, on the basis of the voltage obtained by the voltage obtaining portion and the current obtained by the current obtaining portion, after a predetermined time has elapsed from a switching time point of charge and discharge.

5. The amount of charge calculation device according to any one of claims 1 to 4, further comprising:
a difference in amount of charge calculation portion calculating a difference in the amount of charge of the first amount of charge calculated by the first calculation portion and the second amount of charge calculated by the second calculation portion, at a time point when the second amount of charge is set to the amount of charge of the secondary battery; and
a unit time error amount calculation portion calculating a unit time error amount per unit time of the amount of charge, on the basis of the difference in the amount of charge, calculated by the difference in amount of charge calculation portion,
wherein the determination portion determines whether or not the predetermined condition is satisfied, on the basis of an elapsed time from the time point when the second amount of charge calculated by the second calculation portion, is set to the amount of charge of the secondary battery, and the unit time error amount.

6. The amount of charge calculation device according to any one of claims 1 to 4, further comprising:
a difference in amount of charge calculation portion calculating a difference in the amount of charge of the first amount of charge calculated by the first calculation portion and the second amount of charge calculated by the second calculation portion, at a time point when the second amount of charge is set to the amount of charge of the secondary battery; and
a unit capacity error amount calculation portion calculating a unit capacity error amount per unit capacity of the amount of charge, on the basis of the difference in the amount of charge, calculated by the difference in amount of charge calculation portion,
wherein the determination portion determines whether or not the predetermined condition is satisfied, on the basis of charge and discharge capacity of the secondary battery after the time point when the second amount of charge calculated by the second calculation portion, is set to the amount of charge of the secondary battery, and the unit capacity error amount.

7. The amount of charge calculation device according to any one of claims 1 to 6, further comprising:
an open voltage calculation portion calculating an open voltage of the secondary battery, on the basis of the voltage obtained by the voltage obtaining portion, the current obtained by the current obtaining portion, and an equivalent circuit model of the secondary battery,
wherein the second calculation portion calculates the second amount of charge of the secondary battery, on the basis of the open voltage calculated by the open voltage calculation portion, and a corresponding relationship between the open voltage and the amount of charge of the secondary battery.

8. An amount of charge calculation device calculating an amount of charge of a secondary battery, the device comprising:
a voltage obtaining portion obtaining a voltage of the secondary battery;
a current obtaining portion obtaining a current of the secondary battery;
a first calculation portion calculating a first amount of charge of the secondary battery by integrating the current obtained by the current obtaining portion;
a second calculation portion calculating a second amount of charge of the secondary battery, on the basis of the voltage obtained by the voltage obtaining portion, the current obtained by the current obtaining portion, and an equivalent circuit model of the secondary battery; and
a switching determination portion determining the presence or absence of switching between charge and discharge of the secondary battery, on the basis of the current obtained by the current obtaining portion,
wherein in a case where the switching determination portion determines that there is no switching between charge and discharge, the first amount of charge is set to the amount of charge of the secondary battery, and
in a case where the switching determination portion determines that there is switching between charge and discharge, the second amount of charge is set to the amount of charge of the secondary battery.

9. The amount of charge calculation device according to claim 8, further comprising:
a difference calculation portion calculating a difference in the first amount of charge calculated by the first calculation portion and the second amount of charge calculated by the second calculation portion,
wherein in a case where the switching determination portion determines that there is switching between charge and discharge, the first amount of charge is set to the amount of charge of the secondary battery when the difference calculated by the difference calculation portion, is not greater than or equal to a predetermined value, and
in a case where the switching determination portion determines that there is switching between charge and discharge, the second amount of charge is set to the amount of charge of the secondary battery when the difference calculated by the difference calculation portion, is greater than or equal to the predetermined value.

10. The amount of charge calculation device according to claim 8 or 9,
wherein in a case where the switching determination portion determines that there is switching between charge and discharge, the second calculation portion calculates the second amount of charge of the secondary battery, on the basis of the voltage obtained by the voltage obtaining portion and the current obtained by the current obtaining portion, after a predetermined time has elapsed from a switching time point of charge and discharge.

11. The amount of charge calculation device according to any one of claims 8 to 10, further comprising:
an open voltage calculation portion calculating an open voltage of the secondary battery, on the basis of the voltage obtained by the voltage obtaining portion, the current obtained by the current obtaining portion, and an equivalent circuit model of the secondary battery,
wherein the second calculation portion calculates the second amount of charge of the secondary battery, on the basis of the open voltage calculated by the open voltage calculation portion, and a corresponding relationship between the open voltage and the amount of charge of the secondary battery.

12. An amount of charge calculation device calculating an amount of charge of a secondary battery, the device comprising:
a voltage obtaining portion obtaining a voltage of the secondary battery;
a current obtaining portion obtaining a current of the secondary battery;
a first calculation portion calculating a first amount of charge of the secondary battery by integrating the current obtained by the current obtaining portion;
a second calculation portion calculating a second amount of charge of the secondary battery, on the basis of the voltage obtained by the voltage obtaining portion, the current obtained by the current obtaining portion, and an equivalent circuit model of the secondary battery;
a difference in amount of charge calculation portion calculating a difference in the amount of charge of the first amount of charge calculated by the first calculation portion and the second amount of charge calculated by the second calculation portion;
a condition determination portion determining whether or not a predetermined condition is satisfied, on the basis of the difference in the amount of charge, calculated by the difference in amount of charge calculation portion; and
a correction portion correcting the first amount of charge, on the basis of the second amount of charge, in a case where the condition determination portion determines that the predetermined condition is satisfied.

13. The amount of charge calculation device according to claim 12, further comprising:
a switching determination portion determining the presence or absence of switching between charge and discharge of the secondary battery, on the basis of the current obtained by the current obtaining portion,
wherein the condition determination portion determines whether or not the predetermined condition is satisfied, according to the presence or absence of the switching, determined by the switching determination portion.

14. The amount of charge calculation device according to claim 12 or 13, further comprising:
a change amount calculation portion calculating a change amount of the difference in the amount of charge, on the basis of the difference in the amount of charge, calculated by the difference in amount of charge calculation portion at each of a first correction time point when the correction portion performs correction and a second correction time point before the first correction time point; and
an error amount calculation portion calculating an error amount, on the basis of the change amount calculated by the change amount calculation portion, and a charge continuation time or a discharge continuation time after the first correction time point,
wherein the condition determination portion determines whether or not the predetermined condition is satisfied, on the basis of whether or not the error amount calculated by the error amount calculation portion, is greater than or equal to a predetermined threshold value.

15. The amount of charge calculation device according to claim 14, further comprising:
a capacity calculation portion calculating charged or discharged capacity between the first correction time point and the second correction time point; and
a unit capacity change amount calculation portion calculating a unit capacity change amount per unit capacity, on the basis of the change amount calculated by the change amount calculation portion and the capacity calculated by the capacity calculation portion,
wherein the error amount calculation portion calculates the error amount, on the basis of the unit capacity change amount calculated by the unit capacity change amount calculation portion, and charge capacity or discharge capacity of the secondary battery after the first correction time point.

16. The amount of charge calculation device according to claim 12 or 13,
wherein the condition determination portion determines whether or not the predetermined condition is satisfied, on the basis of whether or not the difference in the amount of charge, calculated by the difference in amount of charge calculation portion, is greater than or equal to a predetermined value.

17. The amount of charge calculation device according to any one of claims 12 to 16,
wherein in a case where the charge continuation time or the discharge continuation time after the time point when the correction portion performs correction, is longer than or equal to a predetermined time, the condition determination portion determines whether or not the predetermined condition is satisfied.

18. The amount of charge calculation device according to any one of claims 12 to 17, further comprising:
an open voltage calculation portion calculating an open voltage of the secondary battery, on the basis of the voltage obtained by the voltage obtaining portion, the current obtained by the current obtaining portion, and an equivalent circuit model of the secondary battery,
wherein the second calculation portion calculates the second amount of charge of the secondary battery, on the basis of the open voltage calculated by the open voltage calculation portion, and a corresponding relationship between the open voltage and the amount of charge of the secondary battery.

19. A computer program for allowing a computer to calculate an amount of charge of a secondary battery, the program allowing the computer to function as:
a voltage obtaining portion obtaining a voltage of the secondary battery;
a current obtaining portion obtaining a current of the secondary battery;
a first calculation portion calculating a first amount of charge of the secondary battery by integrating the obtained current;
a second calculation portion calculating a second amount of charge of the secondary battery, on the basis of the obtained voltage and current, and an equivalent circuit model of the secondary battery; and
a determination portion determining whether or not a predetermined condition is satisfied,
wherein in a case where it is determined that the predetermined condition is not satisfied, the first amount of charge is processed as the amount of charge of the secondary battery, and in a case where it is determined that the predetermined condition is satisfied, the second amount of charge is processed as the amount of charge of the secondary battery.

20. A computer program for allowing a computer to calculate an amount of charge of a secondary battery, the program allowing the computer to function as:
a voltage obtaining portion obtaining a voltage of the secondary battery;
a current obtaining portion obtaining a current of the secondary battery;
a first calculation portion calculating a first amount of charge of the secondary battery by integrating the obtained current;
a second calculation portion calculating a second amount of charge of the secondary battery, on the basis of the obtained voltage and current, and an equivalent circuit model of the secondary battery; and
a switching determination portion determining the presence or absence of switching between charge and discharge of the secondary battery, on the basis of the obtained current,
wherein in a case where it is determined that there is no switching between charge and discharge, the first amount of charge is processed as the amount of charge of the secondary battery, and
in a case where it is determined that there is switching between charge and discharge, the second amount of charge is processed as the amount of charge of the secondary battery.

21. A computer program for allowing a computer to calculate an amount of charge of a secondary battery, the program allowing the computer to function as:
a voltage obtaining portion obtaining a voltage of the secondary battery;
a current obtaining portion obtaining a current of the secondary battery;
a first calculation portion calculating a first amount of charge of the secondary battery by integrating the obtained current;
a second calculation portion calculating a second amount of charge of the secondary battery, on the basis of the obtained voltage and current, and an equivalent circuit model of the secondary battery;
a difference in amount of charge calculation portion calculating a difference in the amount of charge of the calculated first amount of charge and second amount of charge;
a condition determination portion determining whether or not a predetermined condition is satisfied, on the basis of the calculated difference in the amount of charge; and
a correction portion correcting the first amount of charge, on the basis of the second amount of charge, in a case where it is determined that the predetermined condition is satisfied.

22. An amount of charge calculation method of calculating an amount of charge of a secondary battery, the method comprising:
allowing a voltage obtaining portion to obtain a voltage of the secondary battery;
allowing a current obtaining portion to obtain a current of the secondary battery;
allowing a first calculation portion to calculate a first amount of charge of the secondary battery by integrating the obtained current;
allowing a second calculation portion to calculate a second amount of charge of the secondary battery, on the basis of the obtained voltage and current, and an equivalent circuit model of the secondary battery;
allowing a determination portion to determine whether or not a predetermined condition is satisfied; and
setting the first amount of charge to the amount of charge of the secondary battery in a case where it is determined that the predetermined condition is not satisfied, and
setting the second amount of charge to the amount of charge of the secondary battery in a case where it is determined that the predetermined condition is satisfied.

23. An amount of charge calculation method of calculating an amount of charge of a secondary battery, the method comprising:
allowing a voltage obtaining portion to obtain a voltage of the secondary battery;
allowing a current obtaining portion to obtain a current of the secondary battery;
allowing a first calculation portion to calculate a first amount of charge of the secondary battery by integrating the obtained current;
allowing a second calculation portion to calculate a second amount of charge of the secondary battery, on the basis of the obtained voltage and current, and an equivalent circuit model of the secondary battery;
allowing a switching determination portion to determine the presence or absence of switching between charge and discharge of the secondary battery, on the basis of the obtained current;
setting the first amount of charge to the amount of charge of the secondary battery in a case where it is determined that there is no switching between charge and discharge; and
setting the second amount of charge to the amount of charge of the secondary battery in a case where it is determined that there is switching between charge and discharge.

24. An amount of charge calculation device of calculating an amount of charge of a secondary battery, the method comprising:
allowing a voltage obtaining portion to obtain a voltage of the secondary battery;
allowing a current obtaining portion to obtain a current of the secondary battery;
allowing a first calculation portion to calculate a first amount of charge of the secondary battery by integrating the obtained current;
allowing a second calculation portion to calculate a second amount of charge of the secondary battery, on the basis of the obtained voltage and current, and an equivalent circuit model of the secondary battery;
allowing a difference in amount of charge calculation portion to calculate a difference in the amount of charge of the calculated first amount of charge and second amount of charge;
allowing a condition determination portion to determine whether or not a predetermined condition is satisfied, on the basis of the calculated difference in the amount of charge; and
allowing a correction portion to correct the first amount of charge, on the basis of the second amount of charge, in a case where it is determined that the predetermined condition is satisfied.
